# EUROPEAN PATENT APPLICATION

(11) **EP 4 425 261 A1**
(43) Date of publication of application: **04.09.2024**
(21) Application number: 24159608.9
(22) Date of filing: 26.02.2024
(51) Int. Cl.: G03F 7/09

(54) **RESIST UNDERLAYER FILM MATERIAL, PATTERN FORMING METHOD, AND METHOD OF FORMING RESIST UNDERLAYER FILM**

(30) Priority: 01.03.2023 JP 2023031420
(71) Applicant: SHIN-ETSU CHEMICAL CO., LTD., Tokyo 1000005 (JP)
(72) Inventor: Nakahara, Takayoshi, Niigata (JP); Kori, Daisuke, Niigata (JP); Biyajima, Yusuke, Niigata (JP)
(74) Representative: Sonnenhauser, Thomas Martin

(57) **Abstract**

Provided is a resist underlayer film material that can form a resist underlayer film with excellent planarizing property and film formability and provides a resist underlayer film having appropriate etching properties. The resist underlayer film material includes: (A) a compound containing no phenolic hydroxyl group, or a compound having a phenolic hydroxyl group modified and in which a residual rate of the phenolic hydroxyl group is less than 2%, wherein the compound has a weight average molecular weight of 2,500 or less in terms of polystyrene by gel permeation chromatography; (B) a crosslinking agent containing a phenolic hydroxyl group represented by the following general formula (1); (C) a base generator; and (D) an organic solvent. 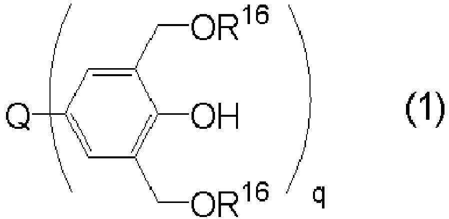 (In the formula, Q is a single bond or a hydrocarbon group with a valency of q having 1 to 20 carbon atoms. R¹⁶ is a hydrogen atom or an alkyl group having 1 to 20 carbon atoms. q is an integer of 1 to 5.)

## Description

### TECHNICAL FIELD

The present invention relates to a resist underlayer film material that can be used in fine patterning by a multilayer resist method in a semiconductor device manufacturing process, a pattern forming method using the resist underlayer film material, and a method of forming a resist underlayer film.

### BACKGROUND ART

With higher integration and higher processing speed of LSIs, the miniaturization of pattern sizes has been rapidly progressing. Along with the miniaturization, lithography technology has achieved finer patterning by employing shorter wavelengths of light sources and selecting resist compositions suitable for the shorter wavelengths. Positive photoresist compositions for monolayers have been mainly used as such resist compositions. The monolayer positive photoresist composition contains a resist resin having a skeleton having etching resistance against dry-etching with chlorine- or fluorine-based gas plasma and provides a switching mechanism that makes an exposed part soluble, whereby the exposed part is dissolved to form a pattern, and the remaining resist pattern is used as a mask to dry-etch a substrate to be processed.

However, when the pattern is miniaturized, that is, the pattern width is reduced without changing the thickness of the photoresist film to be used, the resolution performance of the photoresist film is lowered. In addition, pattern development of the photoresist film with a developer results in an excessively high aspect ratio, causing pattern collapse. Therefore, the photoresist film has been thinned along with miniaturization of the pattern.

On the other hand, a substrate to be processed has been processed typically by dry-etching using a photoresist film with a pattern as an etching mask. Unfortunately, there is no practical dry-etching method capable of providing perfect etching selectivity between the photoresist film and the substrate to be processed. Hence, the resist film is damaged and collapses during processing of the substrate, so that the resist pattern fails to be precisely transferred to the substrate to be processed. Accordingly, with the miniaturization of the pattern, resist compositions with higher dry-etching resistance have been sought for. Meanwhile, to enhance the resolution, resins with low absorbance at an exposure wavelength have been sought for as resins used for photoresist compositions. Accordingly, as the exposure light shifts to shorter wavelengths from i-beam to KrF and to ArF, the resins also shift to novolak resins, polyhydroxystyrene, and resins having aliphatic polycyclic skeletons. In practice, the etching rate in dry etching conditions in processing the substrate has been higher, whereas recent photoresist compositions having high resolution tend to have low etching resistance.

It follows that the substrate to be processed has to be dry-etched using a photoresist film thinner and weaker in etching resistance. It is important to ensure a material and a process in this processing step.

One of solutions to solve these problems is a multilayer resist method. In this method, a middle layer film having a different etching selectivity from a photoresist film (that is, a resist upper layer film) is placed between the resist upper layer film and a substrate to be processed; a pattern is formed in the resist upper layer film; then, the pattern is transferred to the middle layer film by dry-etching using the resist upper layer film pattern as a dry etching mask; and the pattern is further transferred to the substrate to be processed by dry etching using the middle layer film as a dry etching mask.

One of the multilayer resist methods is a three-layer resist method, which can be performed with a typical resist composition used in a monolayer resist method. For example, in the three-layer resist method, an organic film made of a novolak resin or the like is formed as a resist underlayer film on a substrate to be processed; a silicon-containing film is formed as a resist middle layer film on the resist underlayer film; and a usual organic photoresist film is formed as a resist upper layer film on the resist middle layer film. Since the organic resist upper layer film exhibits a good etching selectivity ratio relative to the silicon-containing resist middle layer film in dry-etching with fluorine-based gas plasma, the resist upper layer film pattern can be transferred to the silicon-containing resist middle layer film by dry-etching with fluorine-based gas plasma. According to this method, even when a resist composition to be used has difficulty in forming a pattern with a sufficient film thickness for directly processing the substrate to be processed or has insufficient dry etching resistance for processing the substrate, the pattern can be transferred to the silicon-containing film (resist middle layer film). Subsequently, pattern transfer by dry-etching with oxygen-based or hydrogen-based gas plasma is performed, resulting in a pattern of the organic film (resist underlayer film) made of a novolak resin or the like having a sufficient dry etching resistance for processing the substrate. The resist underlayer film as described above is disclosed, for example, in Patent Document 1, and many others are already known.

In recent years, semiconductor devices having novel structures, such as multi-gate structure, have been actively manufactured and studied. Accordingly, there are growing needs for a resist underlayer film having more excellent planarizing and filling properties than conventional ones. For example, when the underlying substrate to be processed has fine pattern structures, such as holes, trenches, and fins, the gap-filling property is required to fill the gaps in the pattern with a resist underlayer film without voids. In addition, when the underlying substrate to be processed has a step(s) or when a pattern-dense portion and a no-pattern region coexist in the same wafer, the film surface needs to be planarized by a resist underlayer film. Planarizing the surface of the underlayer film can suppress variations in film thickness of the resist middle layer film and the resist upper layer film formed thereon and suppress reduction of a focus margin in lithography or a margin in a subsequent step of processing the substrate to be processed.

The organic film material excellent in filling and planarizing properties is not limited to the underlayer film for multilayer resist and can be widely used as a planarizing material for semiconductor device manufacturing, for example, for planarizing the substrate prior to patterning by nanoimprinting. In addition, this material is also expected as a material for global planarization in a semiconductor device manufacturing process, as an alternative to a CMP process, which is a global planarization method commonly used at present but is a costly process.

To form a planarizing film for planarizing an uneven semiconductor substrate, a resist underlayer film material that contains a compound with low viscosity and high thermal flowability has been proposed (Patent Document 2). However, this material has drawbacks in that the wettability on a hydrophobic substrate treated with hexamethyldisilazane (hereinafter referred to as HMDS) is significantly poor, and that pinholes and shrinkage of film edges tend to occur. Moreover, in state-of-the-art devices, pattern miniaturization involves a thinner resist upper layer film and therefore a thinner resist underlayer film, making it more difficult to ensure wettability. In order to improve the wettability of the underlayer film material, it is effective to improve the adhesiveness with the substrate, and a resist underlayer film material containing an amide structure as a polar functional group has been proposed (Patent Document 3). Unfortunately, this resist underlayer film material has both the wettability on a silicon substrate and the planarizing property, but has insufficient wettability on a hydrophobic substrate. Against this background, there has been a demand for an underlayer film material having excellent planarizing property and wettability on a hydrophobic substrate as well as sufficient etching resistance, and for a pattern forming method using the same.

As described above, the structure of the substrate to be processed has become complicated. In addition, for the surface of the substrate to be processed, various materials have been investigated, such as novel materials with high electron mobility using strained silicon or gallium arsenide or ultra-thin polysilicon controlled in the order of angstrom. It is thus expected that film formation takes place on a wide variety of surface shapes and materials of the substrate to be processed. Therefore, not only excellent planarizing property but also film formability with no dependency on the material and shape of the substrate to be processed is an important property to ensure a process margin.

### CITATION LIST

### PATENT LITERATURE

Patent Document 1: JP 2004-205685 A
Patent Document 2: JP 2017-119670 A
Patent Document 3: JP 2021-196467 A

### SUMMARY OF INVENTION

### TECHNICAL PROBLEM

In view of the circumstances, the present invention aims to provide: a resist underlayer film material that can form a resist underlayer film with excellent planarizing property and film formability even on a substrate to be processed having a portion particularly difficult to be planarized, such as a wide trench structure, and provides a resist underlayer film having appropriate etching properties, in a fine patterning process by a multilayer resist method in a semiconductor device manufacturing process; a pattern forming method using the resist underlayer film material; and a method of forming a resist underlayer film.

### SOLUTION TO PROBLEM

To achieve the object, the present invention provides a resist underlayer film material comprising:
(A) a compound containing no phenolic hydroxyl group, or a compound having a phenolic hydroxyl group modified and in which a residual rate of the phenolic hydroxyl group is less than 2%, wherein the compound has a weight average molecular weight of 2,500 or less in terms of polystyrene by gel permeation chromatography;
(B) a crosslinking agent containing a phenolic hydroxyl group represented by the following general formula (1);
(C) a base generator; and
(D) an organic solvent: 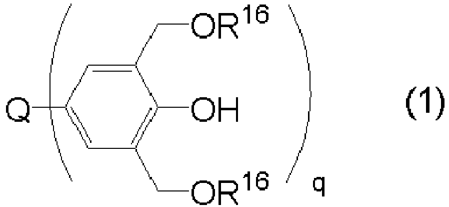 (in the formula, Q is a single bond or a hydrocarbon group with a valency of q having 1 to 20 carbon atoms, R¹⁶ is a hydrogen atom or an alkyl group having 1 to 20 carbon atoms, and q is an integer of 1 to 5) .

With such a resist underlayer film material, a resist underlayer film with excellent planarizing property and film formability can be formed even on a substrate to be processed having a portion difficult to be planarized in a fine patterning process by a multilayer resist method, and in addition, the underlayer film has appropriate etching properties. For example, a resist underlayer film with excellent film formability on a hydrophobic substrate treated with HMDS can be formed.

It is preferable that the base generator (C) is a compound that expresses basicity by thermal decomposition.

Presumably, such a resist underlayer film material has excellent film formability because the phenolic hydroxyl group of the crosslinking agent has ionicity and increases the interaction with the substrate during film baking. The amount added is controlled so that both the thermal flowability and the interaction with the substrate can be achieved.

It is preferable that the base generator (C) is any one represented by the following general formulae (2), (3), and (4):

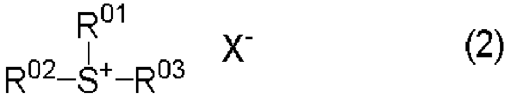

R⁰⁴-I⁺-R⁰⁵ X⁻ (3)

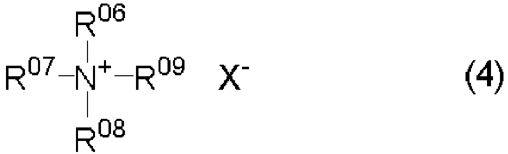

(in the formulae, R⁰¹ to R⁰³ each independently represent a linear, branched, or cyclic alkyl group or alkenyl group having 1 to 10 carbon atoms, which may be substituted with or separated by a hetero atom, or an aryl group or aralkyl group having 6 to 18 carbon atoms, which may be substituted with or separated by a hetero atom, and any two of R⁰¹, R⁰², and R⁰³ may bond together to form a ring with a sulfur atom in the formula; X⁻represents an organic or inorganic anion serving as a pairing ion, provided that X⁻ does not include OH-; R⁰⁴ and R⁰⁵ are each independently an aryl group having 6 to 20 carbon atoms, which may be substituted with or separated by a hetero atom, in which some or all of hydrogen atoms may be substituted with a linear, branched, or cyclic alkyl group or alkoxy group having 1 to 10 carbon atoms, and R⁰⁴ and R⁰⁵ may bond together to form a ring with an iodine atom in the formula; R⁰⁶, R⁰⁷, R⁰⁸, and R⁰⁹ each independently represent a hydrogen atom, or a linear, branched, or cyclic alkyl group, alkenyl group, or aralkyl group having 1 to 20 carbon atoms, which may be substituted with or separated by a hetero atom, or represent an aryl group or aralkyl group having 6 to 18 carbon atoms, which may be substituted with or separated by a hetero atom, and any two or more of R⁰⁶, R⁰⁷, R⁰⁸, and R⁰⁹ may bond together to form a ring with a nitrogen atom in the formula).

Further, it is more preferable that X⁻ in the general formulae (2), (3), and (4) is any one of: a structure represented by any one of the following general formulae (5), (6), and (7); and an anion selected from the group consisting of chloride ion, bromide ion, iodide ion, fluoride ion, cyanide ion, nitrate ion, and nitrite ion:

R¹⁰-COO⁻ (5)

R¹¹-SO₃⁻ (6)

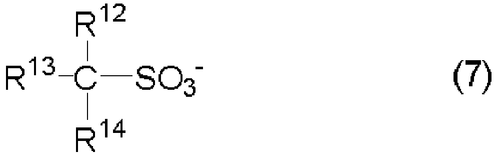

(in the formulae, R¹⁰ represents a linear, branched, or cyclic alkyl group, alkenyl group, aralkyl group, or aryl group having 1 to 20 carbon atoms, which may contain an ether group, an ester group, or a carbonyl group, and one or more of hydrogen atoms in these groups may be substituted with a halogen atom, a hydroxyl group, a carboxyl group, an amino group, or a cyano group; R¹¹ represents an aryl group having 1 to 20 carbon atoms, and one or more of hydrogen atoms in the aryl group may be substituted with a halogen atom, a hydroxyl group, a carboxyl group, an amino group, or a cyano group; R¹², R¹³, and R¹⁴ each independently represent a hydrogen atom, or a halogen atom except fluorine atom, or a linear, branched, or cyclic alkyl group, alkenyl group, aralkyl group, or aryl group having 1 to 20 carbon atoms, which may contain an ether group, an ester group, or a carbonyl group, one or more of hydrogen atoms in these groups may be substituted with a halogen atom, a hydroxyl group, a carboxyl group, an amino group, or a cyano group, and two or more of R¹², R¹³, and R¹⁴ may bond together to form a ring).

Further, it is preferable that a conjugate acid X-H of X⁻ in the general formulae (2), (3), and (4) has a boiling point of 200°C or lower.

The base generator (thermal base generator) that expresses basicity by thermal decomposition is selected as appropriate, so that the basicity can be expressed according to the baking temperature of the resist underlayer film material, thereby achieving both film formability and planarizing property. In addition, the base generator has no adverse effects on the performance other than film formability, because it is totally decomposed or evaporated during baking and is not left in the film after baking.

It is preferable that the compound (A) is represented by the following general formula (8): 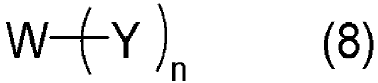 (in the formula, W is an organic group with a valency of n having 2 to 50 carbon atoms, n is an integer of 2 to 10, and Y is independently any one of structures represented by the following general formula (9)) 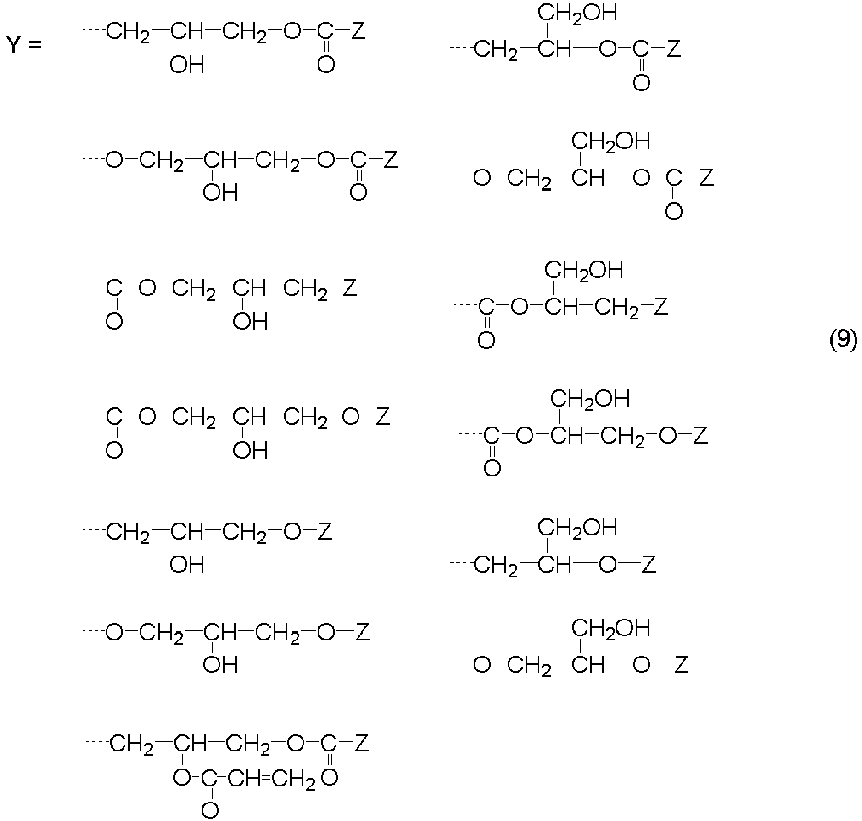 (in the formula, a broken line represents a bonding site with W, Z is one kind or two or more kinds of end groups, and at least one kind of the end groups is any one of groups represented by the following general formula (10)) 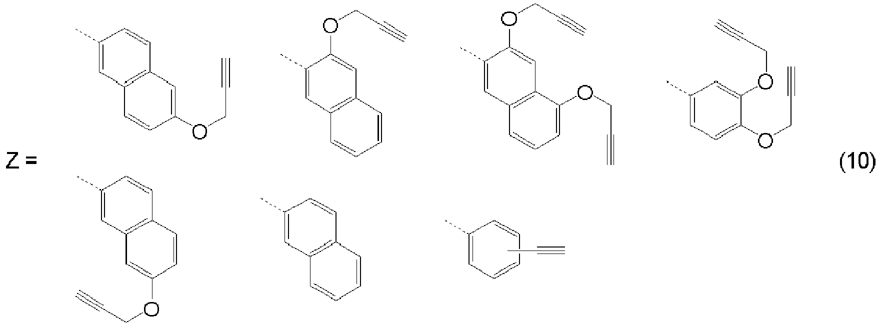 (in the formula, a broken line represents a bonding arm) .

With such a resist underlayer film material, a resist underlayer film with excellent planarizing property and film formability can be formed even on a substrate to be processed having a portion particularly difficult to be planarized, such as a wide trench structure.

In this case, Z in the general formula (9) may comprise one or more kinds of groups represented by the general formula (10) and one or more kinds of groups represented by the following general formulae (11) and (12) :

-----Rₚ (11)

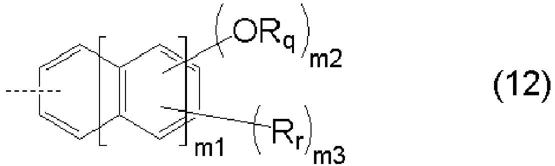

(in the formula (11), Rₚ represents a linear or branched, saturated or unsaturated hydrocarbon group having 1 to 30 carbon atoms, which may be substituted with or separated by a hetero atom; in the formula (12), R_{q} represents a hydrogen atom, or a linear or branched, saturated or unsaturated hydrocarbon group having 1 to 10 carbon atoms; Rᵣ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; m1 represents 0 to 2, m2 and m3 each represent the number of substituents on an aromatic ring, m2 and m3 each represent an integer of 0 to 7, and m2+m3 satisfies a relation of 0 or more and 7 or less; when a proportion of a structure having the general formula (10) that constitutes Z is denoted as "a", and a proportion of a total of structures having the general formulae (11) and (12) is denoted as "b", the following relation is satisfied: a + b = 1.0, 0.50 ≤ a ≤ 0.99, 0.01 ≤ b ≤ 0.50).

Such a resist underlayer film material has sufficient curability and, with a combination of an aromatic structure and a hydrocarbon end group structure, the physical properties such as heat resistance, etching resistance, filling and planarizing properties, adhesiveness with the substrate, and control of optical constants can be adjusted and improved according to the required performance.

Further, it is preferable that W in the general formula (8) is a structure represented by any one of the following formulae: 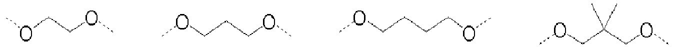 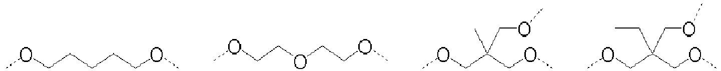 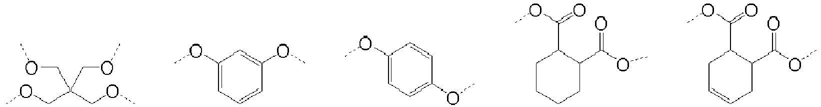 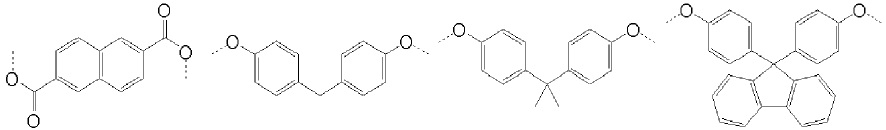 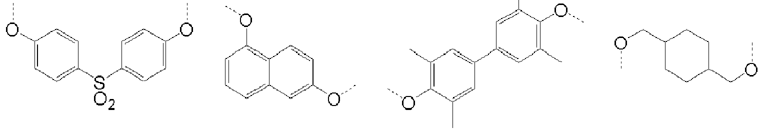 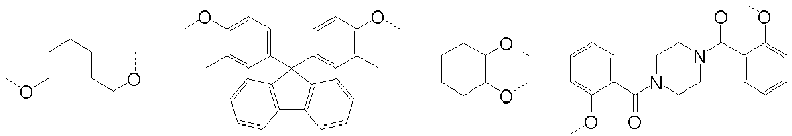 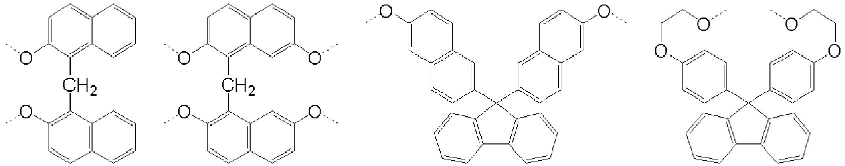 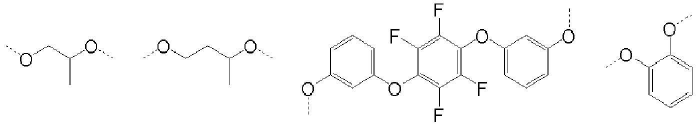 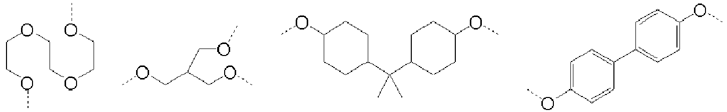 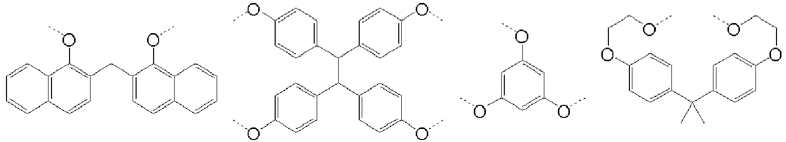 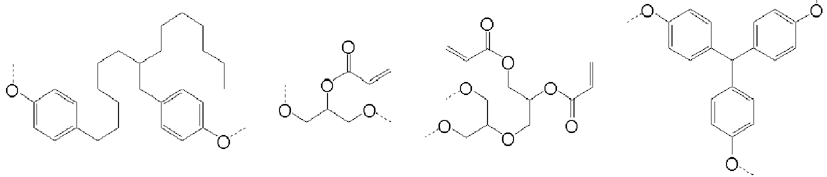 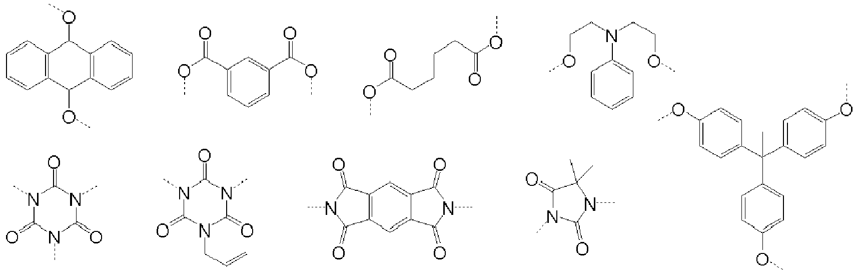 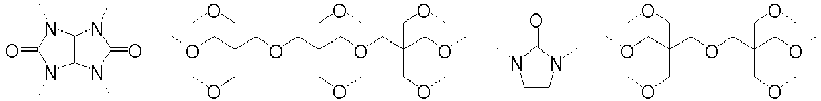 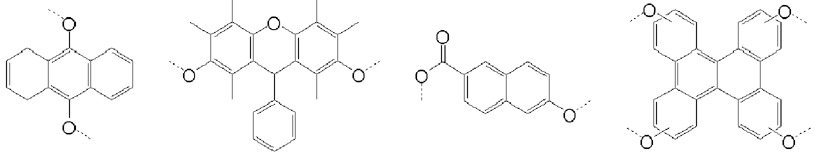 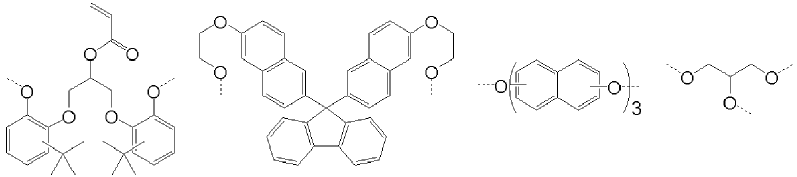 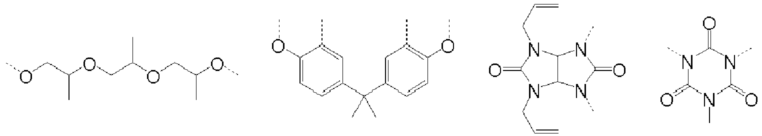 (in the formulae, a broken line represents a bonding arm).

With such a resist underlayer film material, a resist underlayer film with excellent film formability and planarizing property can be formed and in particular can be produced easily.

It is preferable that the organic solvent (D) is a mixture of one or more kinds of organic solvent having a boiling point of lower than 180°C and one or more kinds of organic solvent having a boiling point of 180°C or higher.

With such a resist underlayer film material, the planarizing property of the resist underlayer film formed can be further improved, irrespective of the pattern density and other designs of the substrate to be processed.

Further, the resist underlayer film material in the present invention may further comprise one or more of (E) a surfactant, (F) a plasticizer, and (G) a pigment.

In this way, the resist underlayer film material in the present invention may additionally contain the surfactant (E) for improving the coating property in spin coating, the plasticizer (F) for further improving the filling and planarizing properties, and the pigment (G) for adjusting the light absorption property. It is preferable in practice that the presence/absence and selection of these additives enables minute adjustment of the performance to meet the requirements, such as film formability, curability, filling property, and optical property.

The present invention also provides a method of forming a pattern in a substrate to be processed. The method includes steps of:
(I-1) applying the resist underlayer film material described above on a substrate to be processed and thereafter performing heat treatment to form a resist underlayer film;
(I-2) forming a resist upper layer film using a photoresist material on the resist underlayer film;
(I-3) performing pattern exposure and subsequent development with a developer in the resist upper layer film to form a pattern in the resist upper layer film;
(I-4) transferring a pattern to the resist underlayer film by dry-etching while using the resist upper layer film having the pattern as a mask; and
(I-5) processing the substrate to be processed while using the resist underlayer film having the pattern as a mask to form a pattern in the substrate to be processed.

The present invention also provides a method of forming a pattern in a substrate to be processed. The method includes steps of:
(II-1) applying the resist underlayer film material described above on a substrate to be processed and thereafter performing heat treatment to form a resist underlayer film;
(II-2) forming a resist middle layer film on the resist underlayer film;
(II-3) forming a resist upper layer film using a photoresist material on the resist middle layer film;
(II-4) performing pattern exposure and subsequent development with a developer in the resist upper layer film to form a pattern in the resist upper layer film;
(II-5) transferring a pattern to the resist middle layer film by dry-etching while using the resist upper layer film having the pattern as a mask; and
(II-6) transferring a pattern to the resist underlayer film by dry-etching while using the resist middle layer film having the pattern as a mask; and
(II-7) processing the substrate to be processed while using the resist underlayer film having the pattern as a mask to form a pattern in the substrate to be processed.

The present invention also provides a method of forming a pattern in a substrate to be processed. The method includes steps of:
(III-1) applying the resist underlayer film material described above on a substrate to be processed and thereafter performing heat treatment to form a resist underlayer film;
(III-2) forming an inorganic hard mask middle layer film selected from the group consisting of a silicon oxide film, a silicon nitride film, and a silicon oxynitride film on the resist underlayer film;
(III-3) forming an organic thin film on the inorganic hard mask middle layer film;
(III-4) forming a resist upper layer film using a photoresist material on the organic thin film;
(III-5) performing pattern exposure and subsequent development with a developer in the resist upper layer film to form a pattern in the resist upper layer film;
(III-6) transferring a pattern to the organic thin film and the inorganic hard mask middle layer film by dry-etching while using the resist upper layer film having the pattern as a mask;
(III-7) transferring a pattern to the resist underlayer film by dry-etching while using the inorganic hard mask middle layer film having the pattern as a mask; and (III-8) processing the substrate to be processed while using the resist underlayer film having the pattern as a mask to form a pattern in the substrate to be processed.

In this way, the resist underlayer film material in the present invention can be suitably used in various pattern forming methods including a two-layer resist process, a three-layer resist process using a resist middle layer film, and a four-layer resist process additionally using an organic thin film. These pattern forming methods can effectively alleviate unevenness and steps of the substrate to be processed by forming the resist underlayer film and are suitable for photolithography of the resist upper layer film.

In the pattern forming method in the present invention, an inorganic hard mask middle layer film may be formed by a CVD method or an ALD method.

In the pattern forming method in the present invention, an inorganic hard mask middle layer film formed by a CVD method or an ALD method can be combined with a resist underlayer film formed by spin coating.

In the pattern forming method in the present invention, a substrate having a structure or a step with a height of 30 nm or more may be used as the substrate to be processed.

In the pattern forming method in the present invention, a substrate having a static contact angle with water of 50° or more may be used as the substrate to be processed.

The resist underlayer film material in the present invention is useful particularly for microfabrication of a substrate having such a structure or step, because of its excellent filling and planarizing properties and film formability on a hydrophobic substrate.

The present invention also provides a method of forming a resist underlayer film that functions as an organic planarizing film employed in a semiconductor device manufacturing process, wherein the resist underlayer film material described above is spin-coated on a substrate to be processed, and the substrate coated with the resist underlayer film material is hardened by heat treatment in a range of temperature of 100°C or higher and 600°C or lower for 10 to 600 seconds to form a resist underlayer film.

The present invention also provides a method of forming a resist underlayer film that functions as an organic planarizing film employed in a semiconductor device manufacturing process, wherein the resist underlayer film material described above is spin-coated on a substrate to be processed, and the substrate coated with the resist underlayer film material is hardened by heat treatment in an atmosphere with an oxygen concentration of 1% by volume or more and 21% by volume or less to form a resist underlayer film.

Such a method can accelerate a crosslinking reaction during formation of the resist underlayer film and suppress mixing with the upper layer film to a higher degree. Furthermore, the heat treatment temperature, time, and oxygen concentration can be adjusted as appropriate within the above ranges so that the resist underlayer film can achieve filling and planarizing properties and curability suitable for the intended use.

The present invention also provides a method of forming a resist underlayer film that functions as an organic planarizing film employed in a semiconductor device manufacturing process, wherein the resist underlayer film material described above is spin-coated on a substrate to be processed, and the substrate coated with the resist underlayer film material is hardened by heat treatment in an atmosphere with an oxygen concentration of less than 1% by volume to form a resist underlayer film.

Such a method is useful because it can accelerate a crosslinking reaction during formation of the resist underlayer film and suppress mixing with the upper layer film to a higher degree without deteriorating the substrate to be processed even when the substrate to be processed contains a material unstable toward heating in an oxygen atmosphere.

Furthermore, a substrate having a structure or a step with a height of 30 nm or more may be used as the substrate to be processed.

Further, a substrate having a static contact angle with water of 50° or more may be used as the substrate to be processed.

The method of forming a resist underlayer film in the present invention is suitable for forming a resist underlayer film in particular on a substrate with such a structure or step, because the method uses the resist underlayer film material in the present invention that can form a resist underlayer film with excellent filling and planarizing properties and film formability on a hydrophobic substrate.

### ADVANTAGEOUS EFFECTS OF INVENTION

As described above, the resist underlayer film material, the pattern forming method, and the method of forming a resist underlayer film in the present invention are suitably used particularly in a multilayer resist process involving planarization of a substrate to be processed with a step(s) or unevenness, and are extremely useful in fine patterning for manufacturing semiconductor devices. In particular, it is possible to provide: a resist underlayer film material that contains no acid generator but can form a resist underlayer film with excellent planarizing property and film formability without substrate dependency even on a substrate to be processed having a portion particularly difficult to be planarized, such as a wide trench structure, and has appropriate etching properties and optical properties, in a fine patterning process by a multilayer resist method in a semiconductor device manufacturing process; a pattern forming method using the resist underlayer film material; and a method of forming a resist underlayer film. In particular, the base produced in baking or the like acts on the phenolic hydroxyl group of the crosslinking agent to increase its ionicity and enhance the interaction with the substrate surface. This can suppress occurrence of pin holes or edge shrink (shrinkage) even when a resist underlayer film is formed on a wafer hydrophobized, for example, treated with HMDS.

### BRIEF DESCRIPTION OF DRAWINGS

FIG. 1 is an illustration of an example of a pattern forming method by a three-layer resist process according to the present invention;
FIG. 2 is an illustration of an edge shrinkage evaluation method in an example;
FIG. 3 is an illustration of a filling property evaluation method in an example; and
FIG. 4 is an illustration of a planarizing property evaluation method in an example.

### DESCRIPTION OF EMBODIMENTS

As described above, there has been a demand for a resist underlayer film material that can form a resist underlayer film with excellent film formability and planarizing property even on a substrate to be processed having a portion particularly difficult to be planarized, such as a wide trench structure, and has excellent filling property and appropriate etching properties and optical properties, in a fine patterning process by a multilayer resist method in a semiconductor device manufacturing process; a pattern forming method using the resist underlayer film material; and a method of forming a resist underlayer film.

The inventors of the present invention have been searching various resist underlayer film materials and pattern forming methods in order to realize a high degree of filling and planarization by underlayer film formation and excellent film formability in multilayer lithography using a resist underlayer film. As a result, the inventors have found that a resist underlayer film material containing as main constituents: a compound containing no phenolic hydroxyl group or a compound in which a residual rate of a phenolic hydroxyl group in the end group of the compound is less than 2%, the compound having a weight average molecular weight of 2,500 or less in terms of polystyrene by gel permeation chromatography; a crosslinking agent containing a phenolic hydroxyl group; and a base generator, as well as a pattern forming method using the resist underlayer film material and a method of forming a resist underlayer film are very effective. This finding has led to completion of the present invention.

Specifically, the present invention provides a resist underlayer film material including: (A) a compound containing no phenolic hydroxyl group, or a compound having a phenolic hydroxyl group modified and in which a residual rate of the phenolic hydroxyl group is less than 2%, wherein the compound has a weight average molecular weight of 2,500 or less in terms of polystyrene by gel permeation chromatography; (B) a crosslinking agent containing a phenolic hydroxyl group represented by the following general formula (1); (C) a base generator; and (D) an organic solvent. 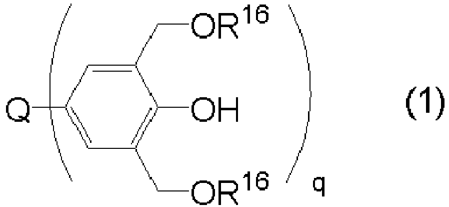 (In the formula, Q is a single bond or a hydrocarbon group with a valency of q having 1 to 20 carbon atoms. R¹⁶ is a hydrogen atom or an alkyl group having 1 to 20 carbon atoms. q is an integer of 1 to 5.)

Although the present invention will be described in detail below, the present invention is not intended to be limited by this description.

### <Resist Underlayer Film Material>

The resist underlayer film material in the present invention includes: (A) a compound containing no phenolic hydroxyl group, or a compound having a phenolic hydroxyl group modified and in which a residual rate of the phenolic hydroxyl group is less than 2%, wherein the compound has a weight average molecular weight of 2,500 or less in terms of polystyrene by gel permeation chromatography; (B) a crosslinking agent containing a phenolic hydroxyl group represented by the following general formula (1); (C) a base generator; and (D) an organic solvent.

### (A) Compound for Forming Resist Underlayer Film

The resist underlayer film material in the present invention contains (A) a compound containing no phenolic hydroxyl group, or a compound having a phenolic hydroxyl group modified and in which a residual rate of the phenolic hydroxyl group is less than 2%, wherein the compound has a weight average molecular weight of 2,500 or less in terms of polystyrene by gel permeation chromatography. Thus, the resist underlayer film material is considered to have good thermal flowability and therefore have high filling and planarizing properties.

The component (A) has a weight average molecular weight of 2,500 or less, preferably 300 to 2,500, particularly preferably 500 to 2,000. The molecular weight of 300 or more can achieve excellent film formability and prevents contamination of devices due to increase in sublimate during curing. The molecular weight of 2,500 or less reduces the complex viscosity of the resin during baking, thereby achieving high thermal flowability and excellent planarizing and filling properties. In the present invention, the molecular weight can be the weight average molecular weight (Mw) in terms of polystyrene by gel permeation chromatography (GPC) using tetrahydrofuran as an eluent. The number average molecular weight (Mn) and the dispersity (Mw/Mn) can also be determined in the same way. The dispersity of the component (A) can be 1.0 to 2.5, but preferably 1.0 to 1.5.

Examples of the component (A) include compounds in which a phenolic hydroxyl group contained in the following is chemically modified: phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, hydroquinone, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluoren-9-ylidene)bisphenol, 2,2'dimethyl-4,4'-(9H-fluoren-9-ylidene)bisphenol, 2,2'diallyl-4,4'-(9H-fluoren-9-ylidene)bisphenol, 2,2'difluoro-4,4'-(9H-fluoren-9-ylidene)bisphenol, 2,2'diphenyl-4,4'-(9H-fluoren-9-ylidene)bisphenol, 2,2'dimethoxy-4,4'-(9H-fluoren-9-ylidene)bisphenol, 1-naphthol, 2-naphthol, 2-methyl-1-naphthol, 4-methoxy-1-naphthol, 7-methoxy-2-naphthol, and dihydroxynaphthalene such as 1,5-dihydroxynaphthalene, 1,7-dihydroxynaphthalene, and 2,6-dihydroxynaphthalene, hydroxyanthracene, bisphenol, and trisphenol. The low complex viscosity compounds disclosed in JP 2017-119670 A can also be suitably used.

When the above compound is synthesized, the reaction to modify a phenolic hydroxyl group sometimes does not proceed completely. If the reaction does not proceed completely, the phenolic hydroxyl group may remain without being capped. The amount of such phenolic hydroxyl residue in the component (A) is less than 2%, more preferably less than 1%, and most preferably less than 0.1%, in which case substantially 100% of the phenolic hydroxyl group is chemically modified and the compound contains no phenolic hydroxyl residue. The compound containing no phenolic hydroxyl residue exhibits higher thermal flowability than a phenolic hydroxyl group-containing compound, because the complex viscosity of the resin tends to be reduced due to the absence of contribution of hydrogen bonds of the phenolic hydroxyl group during baking. Thus, the planarizing and filling properties are improved more. In the present invention, the amount of phenolic hydroxyl residue can be calculated by 1H NMR.

Further, it is preferable that the component (A) is represented by the following general formula (8): 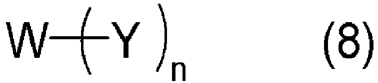 (in the formula, W is an organic group with a valency of n having 2 to 50 carbon atoms, n is an integer of 2 to 10, and Y is independently any one of structures represented by the following general formula (9)) 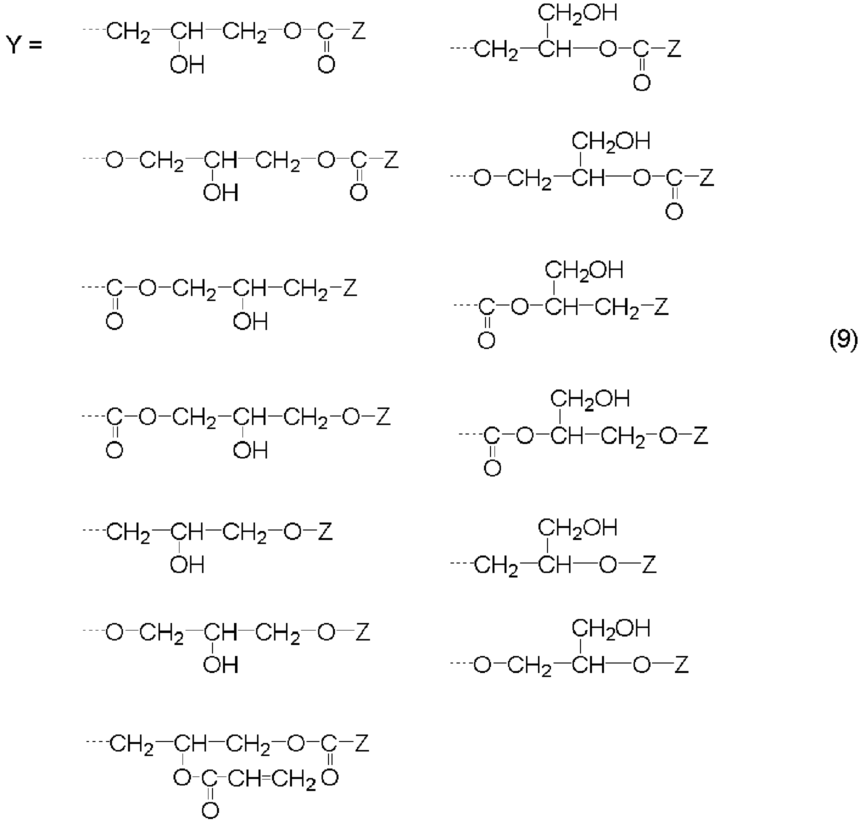 (in the formula, a broken line represents a bonding site with W, Z is one kind or two or more kinds of end groups, and at least one kind of the end groups is any one of groups represented by the following general formula (10)) 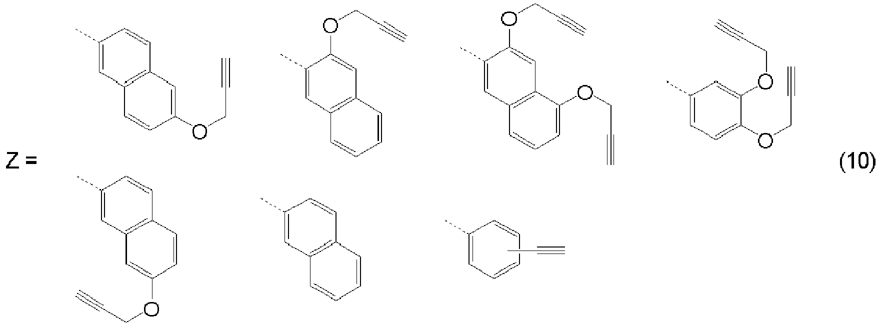 (in the formula, a broken line represents a bonding arm) .

In the resist underlayer film material in the present invention, the end group structure of the general formula (9) functions as a thermosetting group. As a particularly preferable structure, for example, as illustrated by the formula (10), a propargyloxy group is present at the beta position of a naphthalene ring, and the structure is presumably thermally set through a ring structure as represented by the following reaction formula. In this case, the structure contributes as a substituent that imparts thermal flowability before curing but invokes a curing reaction through the rigid ring structure during curing, thereby achieving both thermal flowability and heat resistance, which are conflicting properties. Since the curing reaction proceeds even without an acid generator, the effect of the base generator can be maximized.

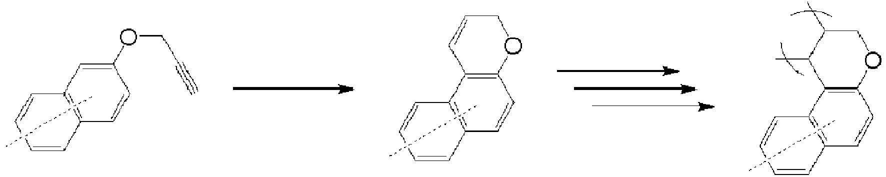

In the general formula (8), W is an organic group with a valency of n having 2 to 50 carbon atoms, and n is an integer of 2 to 10. Then, W is an organic group with a valency of 2 to 10 having a structure in which 2 to 10 hydrogen atoms are eliminated from an organic compound having 2 to 50 carbon atoms. The compound having the organic group W having 2 to 50 carbon atoms and having a structure in which 2 to 10 hydrogen atoms are added to W may contain a linear, branched, or cyclic, saturated or unsaturated hydrocarbon group, aromatic group, heteroaromatic group, ether group, hydroxyl group, ester group, keto group, amino group, halogen group, sulfide group, carboxyl group, sulfo group, imide group, cyano group, aldehyde group, imino group, urea group, carbamate group, carbonate group, nitro group, sulfone group, or the like in the organic group. In order to achieve both good planarizing property and sufficient thermal curability, n is preferably 2 to 4.

In the general formula (9), Z is one kind or two or more kinds of end groups, and at least one kind of the end groups is any one of groups represented by the general formula (10). Here, all of Zs may be any of the groups represented by the general formula (10).

Here, Z in the general formula (9) may be a compound comprising one or more kinds of groups represented by the general formula (10) and one or more kinds of groups represented by the following general formulae (11) and (12).

-----Rₚ (11)

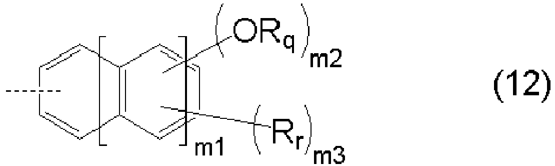

(In the formula (11), Rₚ represents a linear or branched, saturated or unsaturated hydrocarbon group having 1 to 30 carbon atoms, which may be substituted with or separated by a hetero atom. In the formula (12), R_{q} represents a hydrogen atom, or a linear or branched, saturated or unsaturated hydrocarbon group having 1 to 10 carbon atoms, and Rᵣ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms. m1 represents 0 to 2, m2 and m3 each represent the number of substituents on an aromatic ring, m2 and m3 each represent an integer of 0 to 7, and m2+m3 satisfies a relation of 0 or more and 7 or less. When a proportion of a structure having the general formula (10) that constitutes Z is denoted as "a", and a proportion of a total of structures having the general formulae (11) and (12) is denoted as "b", the following relation is satisfied: a + b = 1.0, 0.50 ≤ a ≤ 0.99, 0.01 ≤ b ≤ 0.50).

In Rₚ in the general formula (11), some of hydrogen atoms of the hydrocarbon group may be substituted with a hetero atom such as oxygen, sulfur, nitrogen, or halogen atom or may be separated by a hetero atom such as oxygen, sulfur, or nitrogen atom, and as a result, a hydroxyl group, cyano group, carbonyl group, ether bond, ester bond, sulfonic acid ester bond, carbonate bond, lactone ring, sultone ring, carboxylic anhydride, haloalkyl group or the like may form or intervene.

Examples of the end group structure represented by the general formula (11) include, but not limited to, the following. In the following formulae, n1 represents an integer of 0 to 29, and n2 represents an integer of 0 to 20.

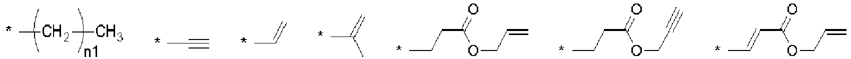

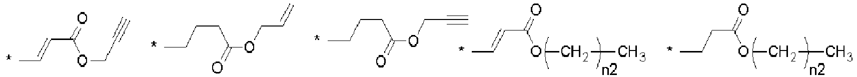

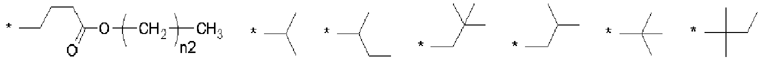

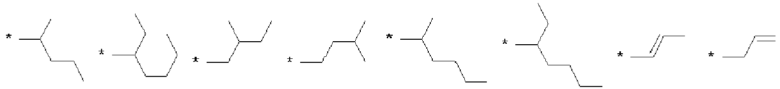

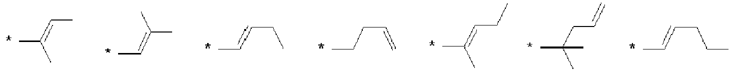

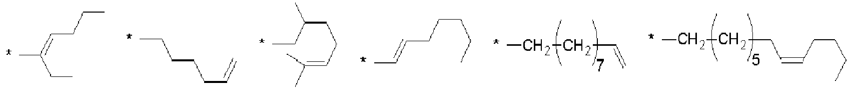

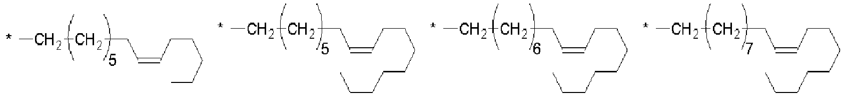

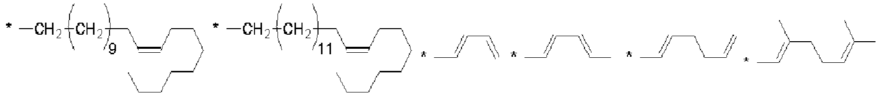

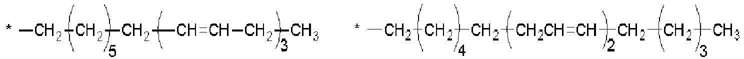

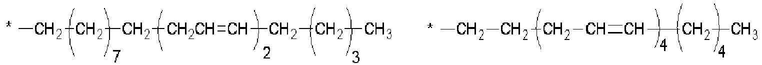

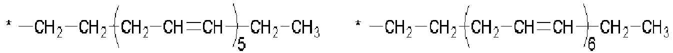

(In the formulae, * represents a bonding arm.)

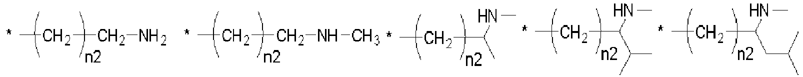

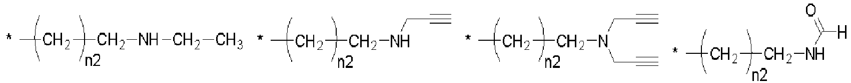

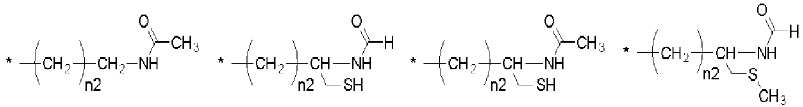

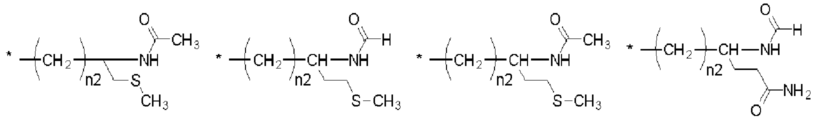

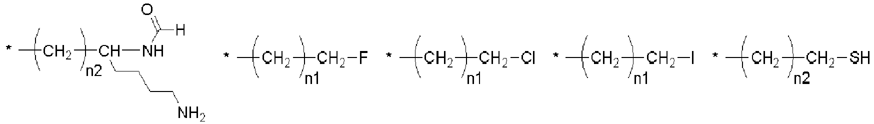

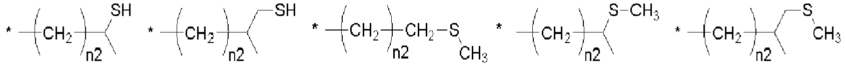

(In the formulae, * represents a bonding arm.)

Examples of the end group structure represented by the general formula (12) include, but not limited to, the following. In the following formulae, n3 represents an integer of 0 to 9.

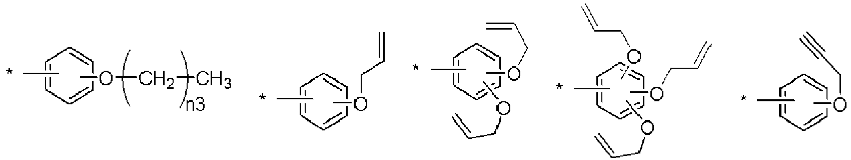

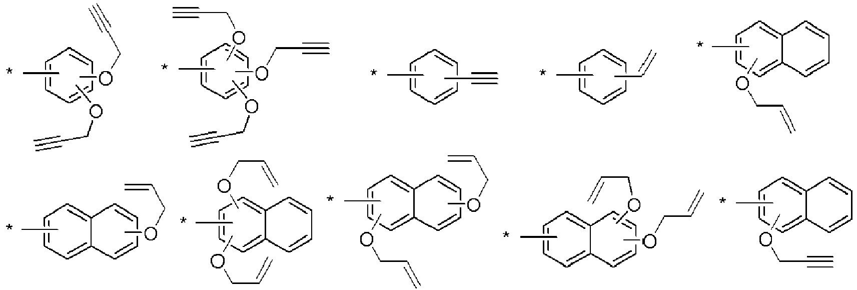

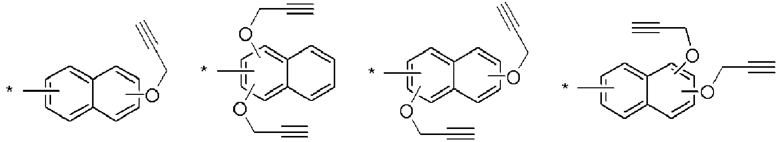

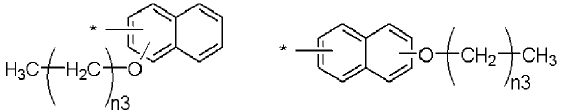

(In the formulae, * represents a bonding arm.)

W, Y, and n in the compound of the general formula (8) are selected as appropriate according to the intended use, so that the properties such as etching resistance, heat resistance, optical properties, polarity, and flexibility of the resist underlayer film material can be adjusted. As for the optical properties among these properties, when the resist underlayer film material has adequate optical properties at a wavelength of 193 nm, reflected light during exposure in multilayer ArF lithography can be suppressed and excellent resolution can be achieved. In order to suppress reflected light, the optical constants of the resist underlayer film material preferably are a refractive index n of approximately 1.4 to 1.9 and an extinction coefficient k of 0.1 to 0.5.

Preferable examples of W in the general formula (8) include the structures of the following formulae.

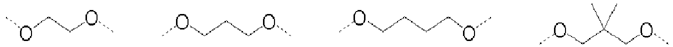

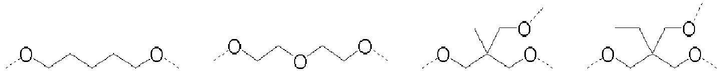

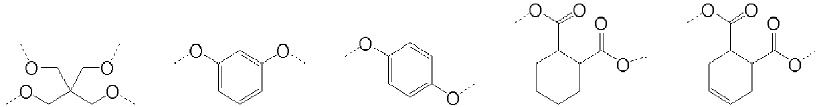

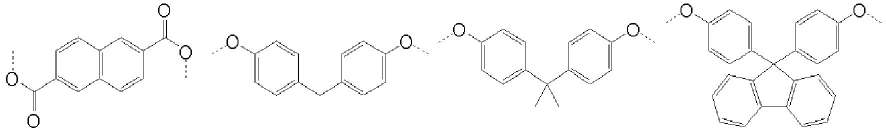

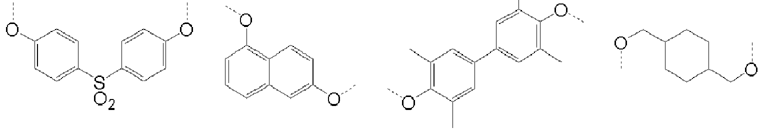

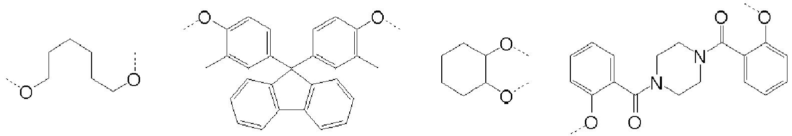

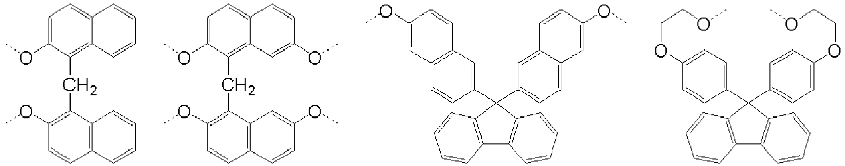

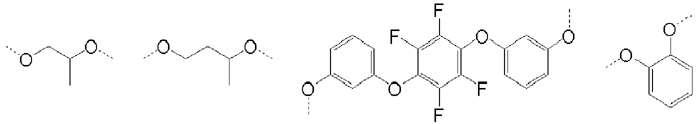

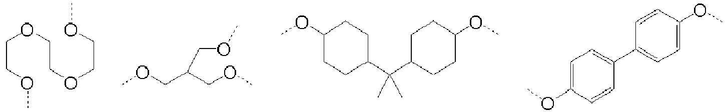

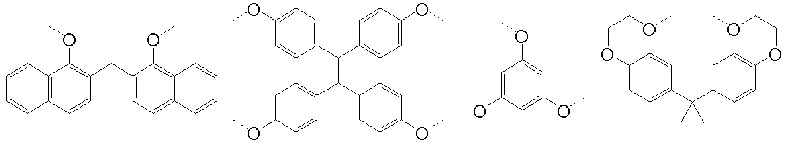

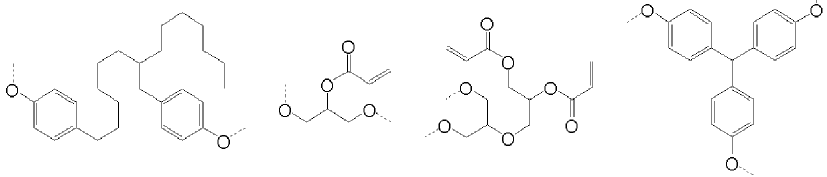

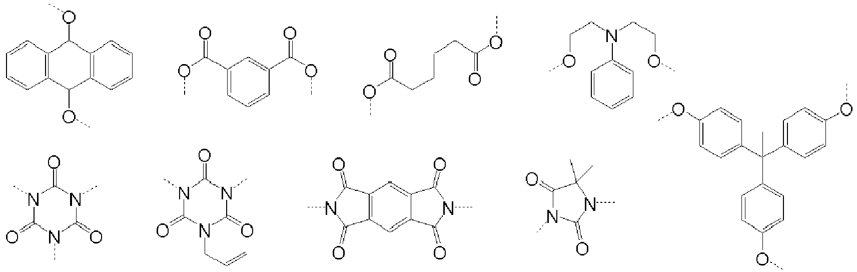

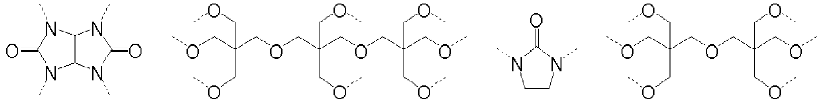

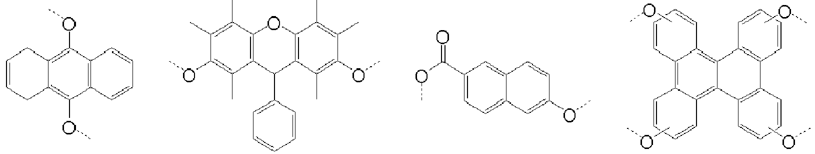

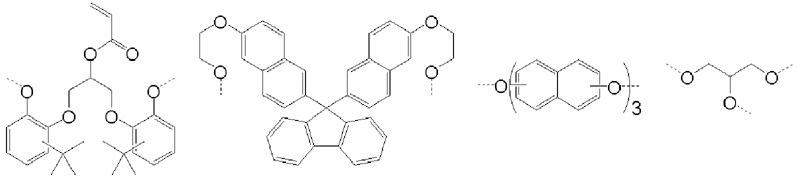

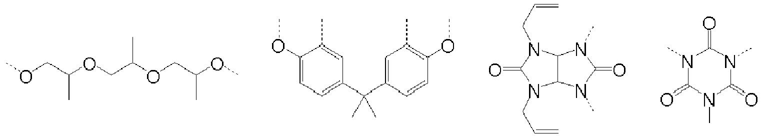

(In the formulae, a broken line represents a bonding arm.)

In the present invention, the compound of the general formula (8) may be used singly or in mixture of two or more kinds. A mixture containing the compound represented by the general formula (8) may be used. When the mixture is used, the compound represented by the general formula (8) makes up 10% by mass or more and more preferably 20% by mass or more in the total solids of the resist underlayer film material excluding the solvent. With 10% by mass or more, a sufficient blending effect can be obtained.

Such a compound for forming a resist underlayer film can provide a sufficient effect of the combination of the crosslinking agent and the base generator, and therefore can form a resist underlayer film with excellent planarizing property and film formability and in particular can be produced easily.

### Method of Producing Compound

The component (A) compound used in the resist underlayer film material in the present invention can be produced by selecting an optimum method according to the structure. Examples of the method of synthesizing the compound represented by the general formula (8) will be described in detail below. The method of producing a compound for forming a resist underlayer film having the component (A) is not limited to these examples.

For example, specifically, the compound can be obtained by an addition reaction of an epoxy compound and a carboxylic acid compound represented by the following reaction formulae (1-1) to (1-8) or an addition reaction of an epoxy compound and an alcohol compound represented by the following reaction formulae (1-9) to (1-12).

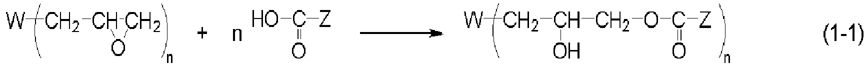

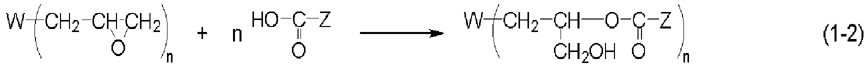

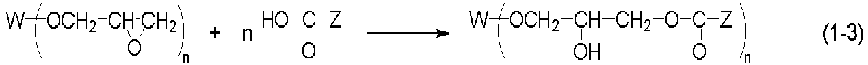

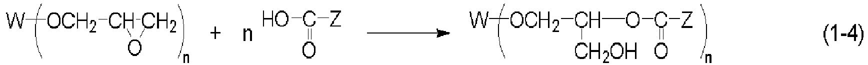

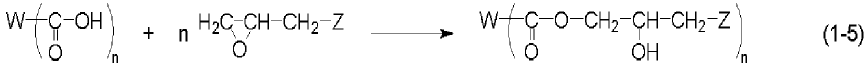

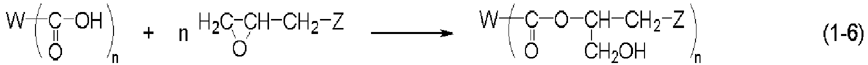

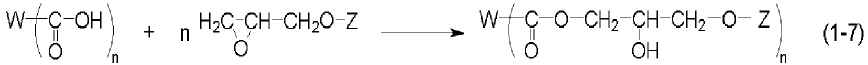

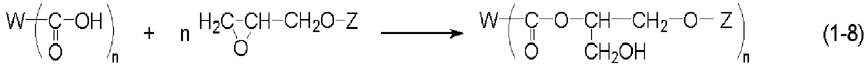

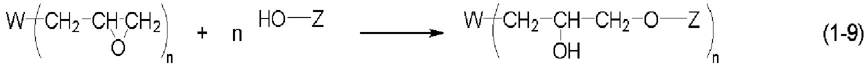

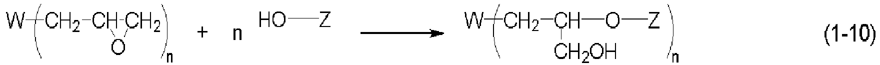

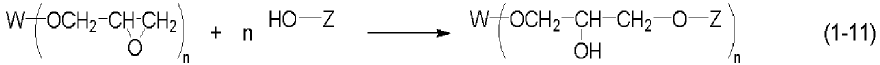

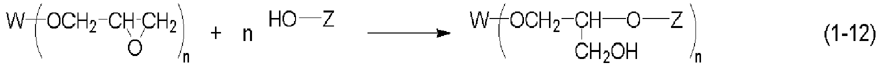

(In the formulae, W, Z, and n are as defined above.)

The amount ratio of the epoxy compound and the carboxylic acid compound or the alcohol compound is preferably such that the carboxyl group in the carboxylic acid compound or the hydroxyl group in the alcohol compound is preferably 0.3 to 2.0 mol, more preferably 0.5 to 1.5 mol, even more preferably 0.75 to 1.25 mol with respect to 1 mol of the epoxy group in the epoxy compound. When the amount of carboxyl group or hydroxyl group to the amount of epoxy group is adequate, there is no possibility that the storage storability of the resist underlayer film material is deteriorated due to the residue of the unreacted epoxy group, and outgassing otherwise caused by the residue of the unreacted carboxylic acid compound or alcohol compound can be prevented.

A plurality of epoxy compounds, carboxylic acid compounds, or alcohol compounds may be used in combination in order to improve the required performance, for example, optical constants (n/k), thermal flowability, etching resistance, heat resistance, and solvent solubility. Also in this case, it is preferable that the amount ratio of the epoxy group and the carboxylic acid group or the alcohol compound is within the above range.

The compound for forming a resist underlayer film having the component (A) in the present invention can be typically obtained by reacting the epoxy compound and the carboxylic acid compound or the alcohol compound in the presence of a reaction catalyst in a solvent or without a solvent at room temperature or, if necessary, under cooling or heating.

Specific examples of the solvent to be used include alcohols such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers such as diethyl ether, dibutyl ether, diethylene glycol diethyl ether, diethylene glycol dimethyl ether, tetrahydrofuran, and 1,4-dioxane; chlorinated solvents such as methylene chloride, chloroform, dichloroethane, and trichloroethylene; hydrocarbons such as hexane, heptane, benzene, toluene, xylene, and cumene; nitriles such as acetonitrile; ketones such as acetone, ethyl methyl ketone, and isobutyl methyl ketone; esters such as ethyl acetate, n-butyl acetate, and propylene glycol methyl ether acetate; lactones such as γ-butyrolactone; and non-protic polar solvents such as dimethylsulfoxide, N,N-dimethylformamide, and hexamethylphosphoric triamide. These solvents may be used singly or in combination of two or more. These solvents are preferably used in a range of 0 to 2,000 parts by mass with respect to 100 parts by mass of the reaction raw materials.

Specific examples of the reaction catalyst include quaternary ammonium salts such as benzyltriethylammonium chloride, benzyltriethylammonium bromide, benzyltrimethylammonium chloride, tetramethylammonium chloride, tetramethylammonium bromide, tetramethylammonium iodide, tetramethylammonium hydroxide, tetraethylammonium bromide, tetrabutylammonium chloride, tetrabutylammonium bromide, tetrabutylammonium iodide, tetrabutylammonium hydrogensulfate, trioctylmethylammonium chloride, tributylbenzylammonium chloride, trimethylbenzylammonium chloride, trimethylbenzylammonium hydroxide, N-laurylpyridinium chloride, N-lauryl-4-picolinium chloride, N-laurylpicolinium chloride, trimethylphenylammonium bromide, and N-benzylpicolinium chloride; quaternary phosphonium salts such as tetrabutylphosphonium chloride, tetrabutylphosphonium bromide, and tetraphenylphosphonium chloride; and tertiary amines such as tris[2-(2-methoxyethoxy)ethyl]amine, tris(3,6-dioxaheptyl)amine, and tris(3,6-dioxaoctyl)amine. The amount of the catalyst to be used is preferably 0.001 to 100% by mass, more preferably 0.005 to 50% by mass, with respect to the raw materials.

The reaction temperature is preferably about from - 50°C to the boiling point of the solvent and even more preferably from room temperature to 150°C. The reaction time is selected as appropriate from the range from 0.1 to 100 hours.

Examples of the reaction method include: a method in which the epoxy compound, the carboxylic acid compound or the alcohol compound, and the catalyst are charged at once; a method in which the epoxy compound and the carboxylic acid compound or the alcohol compound are dispersed or dissolved in the solvent and thereafter the catalyst is added at once or the catalyst diluted with the solvent is added dropwise; and a method in which the catalyst is dispersed or dissolved in the solvent and thereafter the epoxy compound and the carboxylic acid compound or the alcohol compound are added at once or those diluted with the solvent is added dropwise. After completion of the reaction, the resultant product may be used as it is as the resist underlayer film material. Alternatively, the resultant product may be diluted with an organic solvent and then undergo liquid separation and washing before being collected in order to remove the unreacted raw materials, the catalyst and the like in the system.

The organic solvent used in this case is not limited as long as it can dissolve the compound and be separated into two layers when mixed with water. Examples thereof include hydrocarbons such as hexane, heptane, benzene, toluene, and xylene; esters such as ethyl acetate, n-butyl acetate, and propylene glycol methyl ether acetate; ketones such as methyl ethyl ketone, methyl amyl ketone, cyclohexanone, and methyl isobutyl ketone; ethers such as diethyl ether, diisopropyl ether, methyl-tert-butyl ether, and ethylcyclopentyl methyl ether; chlorinated solvents such as methylene chloride, chloroform, dichloroethane, and trichloroethylene; and mixtures thereof. Water used for washing may be typically water called deionized water or ultrapure water. Washing may be performed one or more times. Washing 10 or more times is not worth the resulting effect, so about one to five times is preferred.

In the liquid separation, washing may be performed with a basic aqueous solution in order to remove the unreacted carboxylic acid compound, alcohol compound or acid component in the system. Specific examples of the base include hydroxides of alkaline metals, carbonates of alkaline metals, hydroxides of alkali earth metals, carbonates of alkali earth metals, ammonia, and organic ammonium.

Further, in the liquid separation and washing, washing may be performed with an acidic aqueous solution in order to remove metal impurities or basic components in the system. Specific examples of the acid include inorganic acids such as hydrochloric acid, hydrobromic acid, sulfuric acid, nitric acid, phosphoric acid, and heteropoly acid; and organic acids such as oxalic acid, trifluoroacetic acid, methanesulfonic acid, benzenesulfonic acid, p-toluenesulfonic acid, and trifluoromethanesulfonic acid.

The liquid separation and washing may be performed with one of the basic aqueous solution and the acidic aqueous solution or may be performed in combination. In order to remove metal impurities, the liquid separation and washing is preferably performed with the basic aqueous solution and the acidic aqueous solution in this order.

After the liquid separation and washing with the basic aqueous solution and/or the acidic aqueous solution, washing with neutral water may be successively performed. The neutral water may be deionized water or ultrapure water mentioned above. The washing is performed one or more times and preferably multiple times in order to sufficiently remove basic components or acid components. Washing 10 or more times is not worth the resulting effect, so about one to five times is preferred.

Further, the reaction product after the liquid separation and washing may be collected as powder by concentrating and drying the solvent or crystallizing the reaction product under reduced pressured or normal pressure. Alternatively, the reaction product can be retained in the state of solution with a proper concentration to improve workability for preparing the resist underlayer film material. The concentration of the solution is preferably 0.1 to 50% by mass, more preferably 0.5 to 30% by mass. The solution with such a concentration can prevent deterioration of workability due to high viscosity and is economical because much solvent is not required.

The solvent used in this case is not limited as long as it can dissolve the compound. Specific examples thereof include ketones such as cyclohexanone and methyl-2-amyl ketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. These solvents may be used singly or in combination of two or more.

When the component (A) compound in the present invention is prepared, the epoxy compound, the carboxylic acid compound, and the alcohol compound can be combined as appropriate according to the required performance. More specifically, the compound for forming a resist underlayer film is synthesized by combining a flexible hydrocarbon structure that contributes to improvement of filling and planarizing properties and a rigid aromatic ring structure that contributes to etching resistance and heat resistance in any given proportions, whereby both of the filling and planarizing properties and the heat resistance/etching resistance can be achieved to a high level.

As described above, the compound for forming a resist underlayer film in the present invention provides a resist underlayer film material having high filling and planarizing properties and having good heat resistance and dry-etching resistance.

### (B) Crosslinking Agent

The resist underlayer film material in the present invention can have a crosslinking agent containing a phenolic hydroxyl group to enhance curability and further suppress inter-mixing with the upper layer film. Presumably, because of excellent substrate affinity due to the inclusion of a crosslinking agent containing a phenolic hydroxyl group, a resist underlayer film having excellent film formability can be formed even on a substrate to be processed having a complicated microstructure and various surface materials. In particular, the film formability on a hydrophobic substrate treated with HMDS is excellent.

In the present invention, the crosslinking agent containing a phenolic hydroxyl group is a polynuclear phenol-based crosslinking agent represented by the following general formula (1). The base generator described later acts on the phenolic hydroxyl group contained in the polynuclear phenol-based crosslinking agent to increase the interaction with the substrate, which is expected to have a high film formability-improving effect. Further, since the polynuclear phenol-based crosslinking agent allows a crosslinking reaction to proceed without an acid generator, the effect of the base generator can be maximized. The crosslinking agent can be used singly or in combination of two or more kinds to adequately adjust balance between curability, film formability, and planarizing property. When the crosslinking agent is added, the amount added is preferably 5 to 60 parts by mass, more preferably 10 to 50 parts by mass with respect to 100 parts by mass of the component (A). When the amount of crosslinking agent added is within the above range, a sufficient curability-improving effect and film formability-improving effect can be achieved.

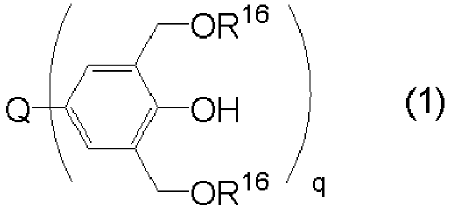

(In the formula, Q is a single bond or a hydrocarbon group with a valency of q having 1 to 20 carbon atoms. R¹⁶ is a hydrogen atom or an alkyl group having 1 to 20 carbon atoms. q is an integer of 1 to 5.)

In the formula (1), Q is a single bond or a hydrocarbon group with a valency of q having 1 to 20 carbon atoms. q is an integer of 1 to 5, more preferably 2 or 3. Specific examples of Q include groups having q hydrogen atoms removed from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R¹⁶ is a hydrogen atom or an alkyl group having 1 to 20 carbon atoms. Specific examples of the alkyl group having 1 to 20 carbon atoms include methyl, ethyl, propyl, isopropyl, butyl, isobutyl, penthyl, isopenthyl, hexyl, octyl, ethylhexyl, decyl, and eicosanyl groups. A hydrogen atom or a methyl group is preferred.

Specific examples of the compound represented by the general formula (1) include the following compounds. Among these, hexamethoxymethylated products of triphenolmethane, triphenolethane, 1,1,1-tris(4-hydroxyphenyl)ethane, tris(4-hydroxyphenyl)-1-ethyl-4-isopropylbenzene are preferred in terms of improvement in curability and film thickness uniformity of the resist underlayer film.

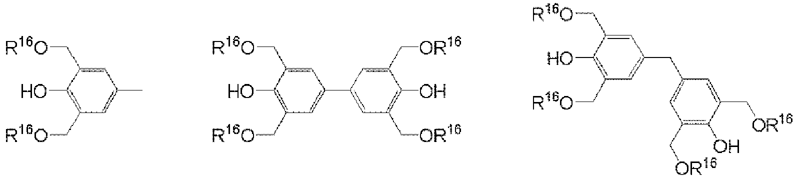

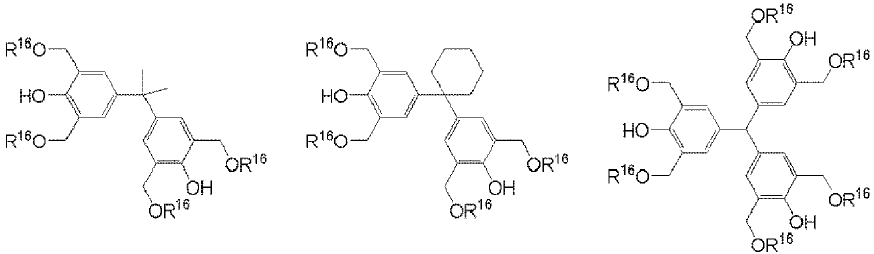

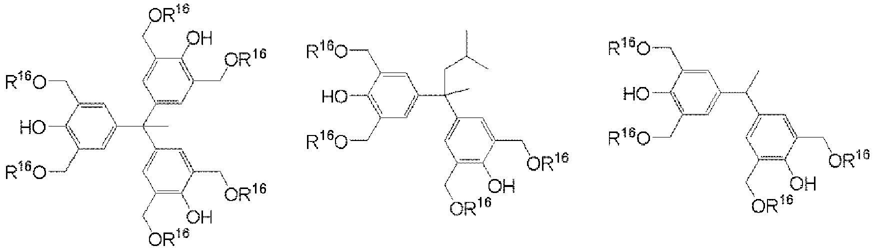

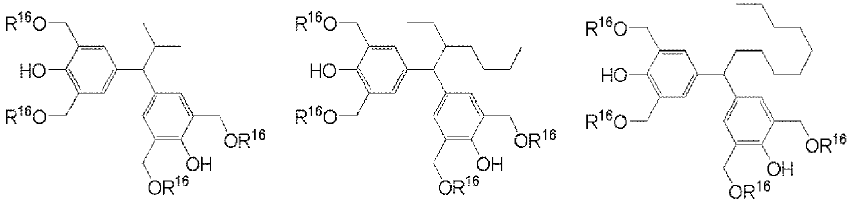

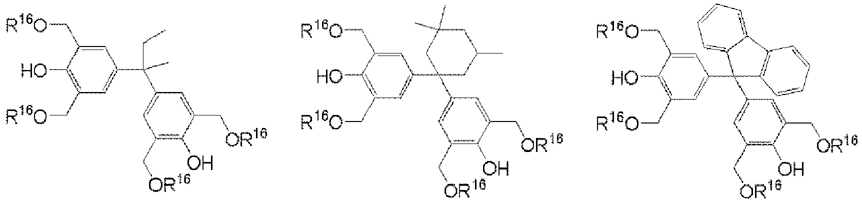

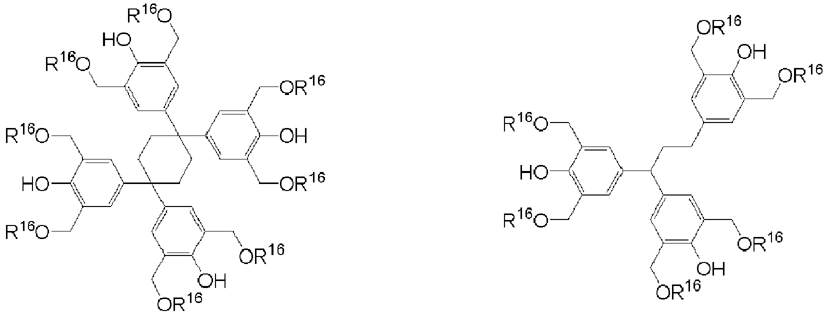

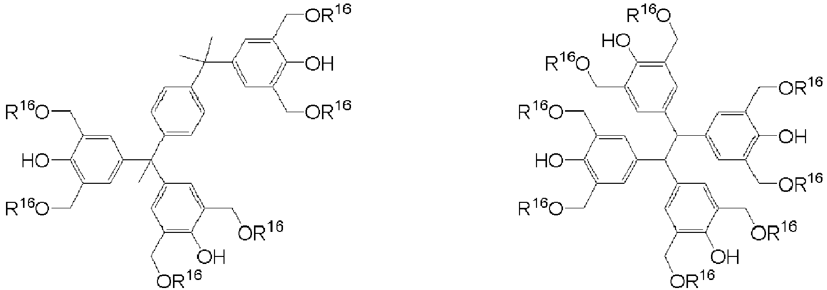

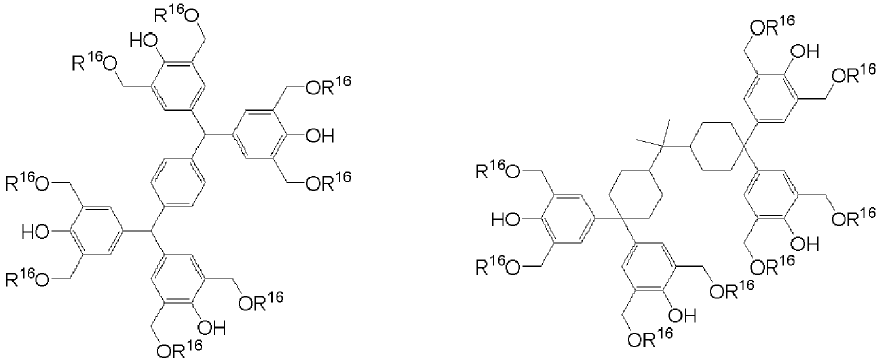

(In the formulae, R¹⁶ is as defined above.)

### (C) Base Generator

The resist underlayer film material in the present invention can contain a base generator to form a resist underlayer film having excellent film formability, for example, even on a hydrophobic substrate treated with HMDS. It is preferable that an acid generator is not involved in order to maximize the effect of the base generator.

In the present invention, the base generator refers to the one having its chemical structure changed by external stimulus such as light and heat to generate a base, and is also called "latent base" or "base precursor". The base generated may be not only a common base such as ammonia or amine but also a chemical species having the function of enhancing the ionicity of the phenolic hydroxyl group in the component (B).

The component (C) base generator is not limited, and a known base generator can be used as necessary. The base generator (C) is preferably a compound that expresses basicity by thermal decomposition, because film formation using the resist underlayer film material in the present invention involves heating, and the interaction of the phenolic hydroxyl group in the component (B) having ionicity with the substrate is expected to increase during heating and thereby improve the film formability. The resist underlayer film material containing such a component (C) can achieve both of the thermal flowability of the film and the interaction with the substrate by adjusting the amount of the component (C) added.

When such a base generator that expresses basicity by thermal decomposition (also referred to as thermal base generator) is used as the component (C), the generated base is the cation excess in the system due to evaporation or decomposition of the anion. Specific examples include triphenylsulfonium cation and tetrabutylammonium cation. Thus, the ionicity (polarity) of the phenolic hydroxyl group in the component (B) is increased, and even on a substrate hydrophobized, for example, treated with HMDS, the interaction with the polar group such as silanol group present in the surface of the substrate improves the wettability of the resist underlayer film material on the substrate, thereby suppressing film edge shrinkage (shrink) or the like. On the other hand, since the action described above does not take place before heating, that is, before base generation, the flowability of the resist underlayer film material itself is maintained. In this way, a resist underlayer film having excellent film formability can be formed.

It is preferable that the base generator (C) is any one represented by the following general formulae (2), (3), and (4).

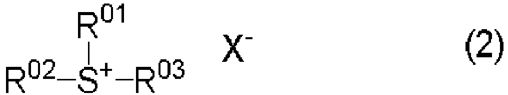

R⁰⁴-I⁺-R⁰⁵ X⁻ (3)

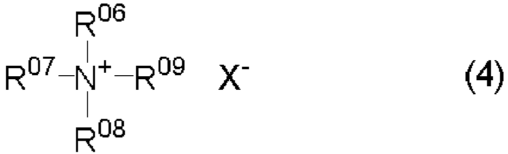

(In the formulae, R⁰¹ to R⁰³ each independently represent a linear, branched, or cyclic alkyl group or alkenyl group having 1 to 10 carbon atoms, which may be substituted with or separated by a hetero atom, or an aryl group or aralkyl group having 6 to 18 carbon atoms, which may be substituted with or separated by a hetero atom. Any two of R⁰¹, R⁰², and R⁰³ may bond together to form a ring with a sulfur atom in the formula. X⁻represents an organic or inorganic anion serving as a pairing ion, provided that X⁻ does not include OH-. R⁰⁴ and R⁰⁵ are each independently an aryl group having 6 to 20 carbon atoms, which may be substituted with or separated by a hetero atom, in which some or all of hydrogen atoms may be substituted with a linear, branched, or cyclic alkyl group or alkoxy group having 1 to 10 carbon atoms. R⁰⁴ and R⁰⁵ may bond together to form a ring with an iodine atom in the formula. R⁰⁶, R⁰⁷, R⁰⁸, and R⁰⁹ each independently represent a hydrogen atom, or a linear, branched, or cyclic alkyl group, alkenyl group, or aralkyl group having 1 to 20 carbon atoms, which may be substituted with or separated by a hetero atom, or an aryl group or aralkyl group having 6 to 18 carbon atoms, which may be substituted with or separated by a hetero atom. Any two or more of R⁰⁶, R⁰⁷, R⁰⁸, and R⁰⁹ bond together to form a ring with a nitrogen atom in the formula.)

Specific examples of R⁰¹, R⁰², and R⁰³ in the general formula (2) include alkyl groups such as methyl, ethyl, n-propyl, isopropyl, n-butyl, tert-butyl, cyclopropyl, cyclopenthyl, cyclohexyl, cyclopropylmethyl, 4-methylcyclohexyl, cyclohexylmethyl, norbornyl, and adamantyl groups; alkenyl groups such as vinyl, allyl, propenyl, butenyl, hexenyl, and cyclohexenyl groups; aryl groups such as phenyl, naphthyl, and thienyl groups; and aralkyl groups such as benzyl, 1-phenylethyl, and 2-phenylethyl groups. Aryl groups are preferred. Some of hydrogen atoms in these groups may be substituted with a hetero atom such as oxygen, sulfur, nitrogen, or halogen atom or may be separated by a hetero atom such as oxygen, sulfur, or nitrogen atom, and as a result, a hydroxyl group, cyano group, carbonyl group, ether bond, ester bond, sulfonic acid ester bond, carbonate bond, lactone ring, sultone ring, carboxylic anhydride, haloalkyl group or the like may form or intervene.

When any two of R⁰¹, R⁰², and R⁰³ bond together directly or through an oxygen atom, methylene group, sulfone group, or carbonyl group, examples include, but not limited to, dibenzothiophene skeleton, phenoxathiin skeleton, and partial structures illustrated below. In the following formulae, the structure may have a substituent at any position on an aromatic ring.

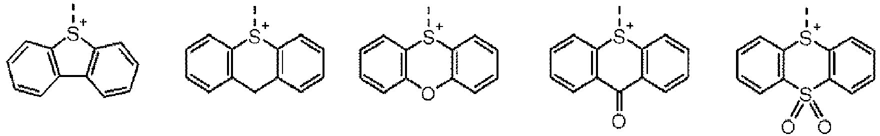

More specifically, examples of sulfonium cation include triphenylsulfonium, 4-hydroxyphenyldiphenylsulfonium, bis(4-hydroxyphenyl)phenylsulfonium, tris(4-hydroxyphenyl)sulfonium, 4-tert-butoxyphenyldiphenylsulfonium, bis(4-tert-butoxyphenyl)phenylsulfonium, tris(4-tert-butoxyphenyl)sulfonium, 3-tert-butoxyphenyldiphenylsulfonium, bis(3-tert-butoxyphenyl)phenylsulfonium, tris(3-tert-butoxyphenyl)sulfonium, 4-tert-butylphenyldiphenylsulfonium, tris(4-tert-butylphenyl)sulfonium, 3,4-di-tert-butoxyphenyldiphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, 10-phenylphenoxathiinium, S-phenyldibenzothiophenium, 4-tert-butoxycarbonylmethyloxyphenyldiphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, (4-hydroxy-3,5-dimethylphenyl)diphenylsulfonium, and (4-n-hexyloxy-3,5-dimethylphenyl)diphenylsulfonium. Other examples include 4-methacryloyloxyphenyldiphenylsulfonium, 4-acryloyloxyphenyldiphenylsulfonium, 4-methacryloyloxyphenyldimethylsulfonium, 4-acryloyloxyphenyldimethylsulfonium, (4-methacryloyloxy-3,5-dimethylphenyl)diphenylsulfonium, and (4-acryloyloxy-3,5-dimethylphenyl)diphenylsulfonium. More preferable examples include triphenylsulfonium, 4-tert-butylphenyldiphenylsulfonium, 4-tert-butoxyphenyldiphenylsulfonium, 10-phenylphenoxathiinium, and S-phenyldibenzothiophenium. Among those, triphenylsulfonium, 4-tert-butylphenyldiphenylsulfonium, and 4-tert-butoxyphenyldiphenylsulfonium are more preferable.

Specific examples of R⁰⁴ and R⁰⁵ in the general formula (3) include phenyl, naphthyl, with any substitution position of the substituent, tolyl, xylyl, trimethylphenyl, ethylphenyl, isopropylphenyl, tert-butylphenyl, 1-adamantylphenyl, triisopropylphenyl, tricyclohexylphenyl, methoxyphenyl, ethoxyphenyl, butoxyphenyl, hydroxyphenyl, dihydroxyphenyl, trimethoxyphenyl, methylthiophenyl, biphenyl, fluorophenyl, difluorophenyl, bromophenyl, iodophenyl, N,N-diphenylaminophenyl, acetoxyphenyl, acetylaminophenyl, 2,2,2-trifluoroethoxyphenyl, (2-methoxyethoxy)phenyl, hydroxynaphthyl, dihydroxynaphthyl, 2,2,2-trifluoroethoxynaphthyl, and (2-methoxyethoxy)naphthyl groups.

R⁰⁴ and R⁰⁵ are preferably a non-substituted phenyl group, or a phenyl group having a substituent selected from the group consisting of halogen atom, alkyl group, and alkoxy group at the para position to the iodine atom. In particular, a phenyl group, a 4-tert-butylphenyl group, a 4-fluorophenyl group and the like are preferable.

When R⁰⁴ and R⁰⁵ bond together directly or through an oxygen atom, methylene group, sulfone group, or carbonyl group, examples include, but not limited to, partial structures illustrated below. In the following formulae, the structure may have a substituent at any position on an aromatic ring.

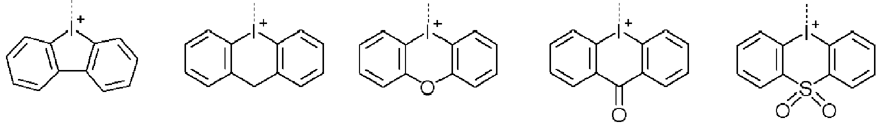

More specifically, examples of iodonium cation include, but not limited to, the following. In the following formulae, tBu is a tert-butyl group, and Ph is a phenyl group.

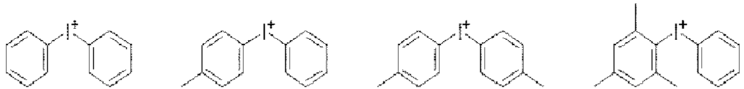

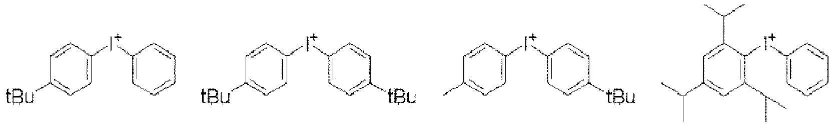

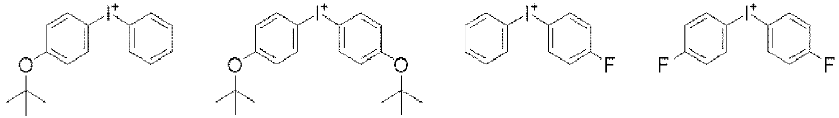

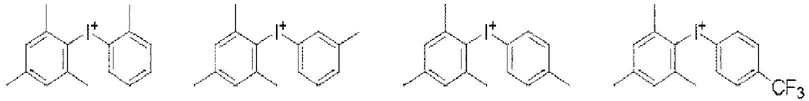

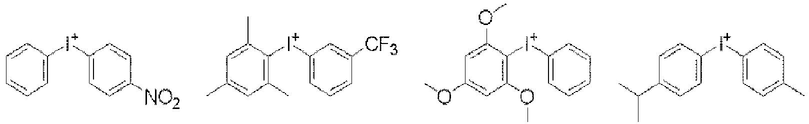

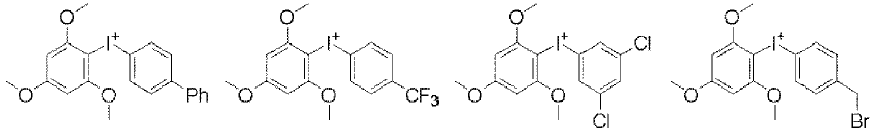

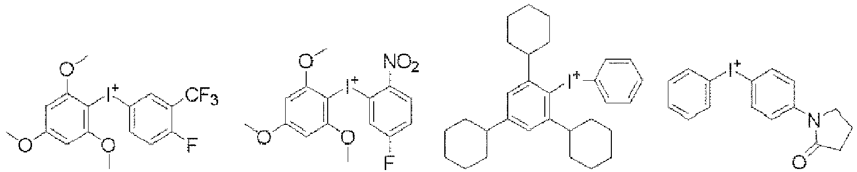

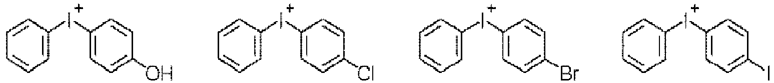

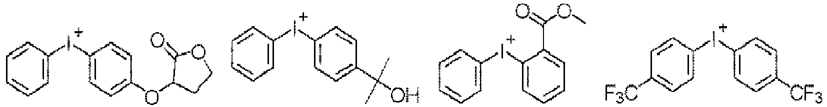

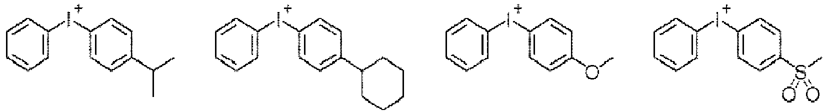

Examples of ammonium cation represented by the general formula (4) include ammonium cations resulting from protonation of the nitrogen atom of the following compounds: ammonia, primary, secondary and tertiary aliphatic amines, mixed amines, aromatic amines, heterocyclic amines, nitrogen-containing compounds having carboxyl group, nitrogen-containing compounds having sulfonyl group, nitrogen-containing compounds having hydroxyl group, nitrogen-containing compounds having hydroxyphenyl group, and alcoholic nitrogen-containing compounds, as well as quaternary ammonium cations.

Specifically, examples of primary aliphatic ammoniums include methylammonium, ethylammonium, n-propylammonium, isopropylammonium, n-butylammonium, isobutylammonium, sec-butylammonium, tert-butylammonium, pentylammonium, tert-amylammonium, cyclopentylammonium, hexylammonium, cyclohexylammonium, heptylammonium, octylammonium, nonylammonium, decylammonium, dodecylammonium, cetylammonium, aminomethylammonium, and 2-aminoethylammonium. Examples of secondary aliphatic ammoniums include dimethylammonium, diethylammonium, din-propylammonium, diisopropylammonium, di-n-butylammonium, diisobutylammonium, di-sec-butylammonium, dipentylammonium, dicyclopentylammonium, dihexylammonium, dicyclohexylammonium, diheptylammonium, dioctylammonium, dinonylammonium, didecylammonium, didodecylammonium, dicetylammonium, methyl(methylamino)methylammonium, and methyl-2-(methylamino)ethylammonium. Examples of tertiary aliphatic ammoniums include trimethylammonium, triethylammonium, tri-n-propylammonium, triisopropylammonium, tri-n-butylammonium, triisobutylammonium, tri-sec-butylammonium, tripentylammonium, tricyclopentylammonium, trihexylammonium, tricyclohexylammonium, triheptylammonium, trioctylammonium, trinonylammonium, tridecylammonium, tridodecylammonium, tricetylammonium, dimethyl(dimethylamino)methylammonium, and dimethyl(2-dimethylaminoethyl) ammonium.

Examples of mixed ammoniums include dimethyl ethyl ammonium, methyl propyl ammonium, benzyl ammonium, phenethyl ammonium, and benzyl dimethyl ammonium. Specific examples of aromatic ammoniums and heterocyclic ammoniums include anilinium derivatives (e.g., anilinium, N-methylanilinium, N-ethylanilinium, N-propylanilinium, N,N-dimethylanilinium, 2-methylanilinium, 3-methylanilinium, 4-methylanilinium, ethylanilinium with an arbitrary substitution position, propylanilinium with an arbitrary substitution position, trimethylanilinium with an arbitrary substitution position, 2-nitroanilinium, 3-nitroanilinium, 4-nitroanilinium, 2,4-dinitroanilinium, 2,6-dinitroanilinium, 3,5-dinitroanilinium, and N,N-dimethyltoluidinium with an arbitrary substitution position), diphenyl(p-tolyl)ammonium, methyldiphenylammonium, triphenylammonium, aminophenylammonium with an arbitrary substitution position, naphthylammonium, aminonaphthylammonium with an arbitrary substitution position, pyrrolinium derivatives (e.g., pyrrolinium, 2H-pyrrolinium, 1-methylpyrrolinium, 2,4-dimethylpyrrolinium, 2,5-dimethylpyrrolinium, and N-methylpyrrolinium), oxazolium derivatives (e.g., oxazolium and isooxazolium), thiazolium derivatives (e.g., thiazolium and isothiazolium), imidazolium derivatives (e.g., imidazolium, 4-methylimidazolium, and 4-methyl-2-phenylimidazolium), pyrazolium derivatives, furazanium derivatives, pyrrolinium derivatives (e.g., pyrrolinium, 2-methyl-1-pyrrolinium), pyrrolidinium derivatives (e.g., pyrrolidinium, N-methylpyrrolidinium, pyrrolidinonium, and N-methylpyrolidonium), imidazolinium derivatives, imidazolidinium derivatives, pyridinium derivatives (e.g., pyridinium, methylpyridinium, ethylpyridinium, propylpyridinium, butylpyridinium, 4-(1-butylpentyl)pyridinium, dimethylpyridinium, trimethylpyridinium, triethylpyridinium, phenylpyridinium, 3-methyl-2-phenylpyridinium, 4-tert-butylpyridinium, diphenylpyridinium, benzylpyridinium, methoxypyridinium, butoxypyridinium, dimethoxypyridinium, 4-pyrrolidinopyridinium, 2-(1-ethylpropyl)pyridinium, aminopyridinium, and dimethylaminopyridinium), pyridazinium derivatives, pyrimidinium derivatives, pyrazinium derivatives, pyrazolinium derivatives, pyrazolidinium derivatives, piperidinium derivatives, piperazinium derivatives, molpholinium derivatives, indolinium derivatives, isoindolinium derivatives, 1H-indazolinium derivatives, indolinium derivatives, qunolinium derivatives (e.g., quinolinium), isoquinolinium derivatives, cinnolinium derivatives, quinazolinium derivatives, quinoxalinium derivatives, phthalazinium derivatives, purinium derivatives, pteridinium derivatives, carbazolium derivatives, phenanthridinium derivatives, acridinium derivatives, phenazinium derivatives, and 1,10-phenanthrolinium derivatives.

Examples of nitrogen-containing compounds having carboxyl group include carboxyphenylammonium, carboxyindolinium, and amino acid derivatives (e.g. protonated forms of nicotinic acid, alanine, alginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine). Examples of nitrogen-containing compounds having sulfonyl group include 3-pyridiniumsulfonic acid. Examples of nitrogen-containing compounds having hydroxyl group, nitrogen-containing compounds having hydroxyphenyl group, and alcoholic nitrogen-containing compounds include 2-hydroxypyridinium, hydroxyanilinium with an arbitrary substitution position, hydroxy-methylanilinium with an arbitrary substitution position, hydroxyquinolinium, dihydroxyquinolinium, 2-hydroxyethylammonium, bis(2-hydroxyethyl)ammonium, tris(2-hydroxyethyl)ammonium, ethylbis(2-hydroxyethyl)ammonium, diethyl(2-hydroxyethyl)ammonium, hydroxypropylammonium, bis(hydroxypropyl)ammonium, tris(hydroxypropyl)ammonium, 4-(2-hydroxyethyl)morpholinium, 2-(2-hydroxyethyl)pyridinium, 1-(2-hydroxyethyl)piperazinium, 1-[2-(2-hydroxyethoxy)ethyl]piperazinium, (2-hydroxyethyl)piperazinium, 1-(2-hydroxyethyl)pyrrolidinium, 1-(2-hydroxyethyl)-2-pyrrolidinonium, 2,3-dihydroxypropylpiperidinium, 2,3-dihydroxypropylpiperolidinium, 8-hydroxyjulolidinium, and 3-hydroxyquinuclidinium.

Specific examples of quaternary ammonium salts include tetramethylammonium, triethylmethylammonium, tetraethylammonium, tetrabutylammonium, tetraoctylammonium, didecyldimethylammonium, tridecylmethylammonium, hexadecyltrimethylammonium, stearyltrimethylammonium, benzyltrimethylammonium, benzyltriethylammonium, benzyltributylammonium, and 2-hydroxyethyltrimethylammonium.

The ammonium cation is preferably quaternary ammonium cation, particularly preferably tetramethylammonium cation, tetraethylammonium cation, and tetrabutylammonium cation.

In this case, it is more preferable that X⁻ in the general formulae (2), (3), and (4) is a structure represented by any one of the following general formulae (5), (6), and (7), or any one of chloride ion, bromide ion, iodide ion, fluoride ion, cyanide ion, nitrate ion, and nitrite ion.

R¹⁰-COO⁻ (5)

R¹¹-SO₃⁻ (6)

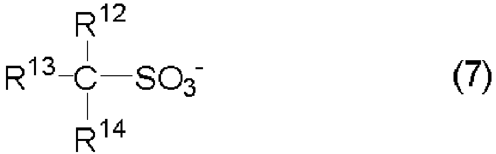

(In the formulae, R¹⁰ represents a linear, branched, or cyclic alkyl group, alkenyl group, aralkyl group, or aryl group having 1 to 20 carbon atoms, which may contain an ether group, an ester group, or a carbonyl group, and one or more of hydrogen atoms in these groups may be substituted with a halogen atom, a hydroxyl group, a carboxyl group, an amino group, or a cyano group. R¹¹ represents an aryl group having 1 to 20 carbon atoms. One or more of hydrogen atoms in the aryl group may be substituted with a halogen atom, a hydroxyl group, a carboxyl group, an amino group, or a cyano group. R¹², R¹³, and R¹⁴ each independently represent a hydrogen atom, or a halogen atom except fluorine atom, or a linear, branched, or cyclic alkyl group, alkenyl group, aralkyl group, or aryl group having 1 to 20 carbon atoms, which may contain an ether group, an ester group, or a carbonyl group, and one or more of hydrogen atoms in these groups may be substituted with a halogen atom, a hydroxyl group, a carboxyl group, an amino group, or a cyano group. Two or more of R¹², R¹³, and R¹⁴ may bond together to form a ring.)

Examples of carboxylate anion represented by the general formula (5) include formate, acetate, propionate, butyrate, isobutyrate, valerate, isovalerate, pivalate, hexanoate, octanoate, cyclohexanecarboxylate, cyclohexylacetate, laurate, myristate, palmitate, stearate, phenylacetate, diphenylacetate, phenoxyacetate, mandelate, benzoylformate, cinnamate, dihydrocinnamate, benzoate, methylbenzoate, salicylate, naphthalenecarboxylate, anthracenecarboxylate, anthraquinonecarboxylate, hydroxyacetate, pivalate, lactate, methoxyacetate, 2-(2-methoxyethoxy)acetate, 2-(2-(2-methoxyethoxy)ethoxy)acetate, diphenolate, monochloroacetate, dichloroacetate, trichloroacetate, trifluoroacetate, pentafluoropropionate, heptafluorobutyrate, and 2-hydroxy-2,2-bis(trifluoromethyl)acetate anions. Other examples include mono-anions of dicarboxylic acids such as succinic acid, tartaric acid, glutaric acid, pimelic acid, sebacic acid, phthalic acid, isophthalic acid, terephthalic acid, naphthalenedicarboxylic acid, cyclohexanedicarboxylic acid, and cyclohexenedicarboxylic acid.

Specific examples of arenesulfonate anion represented by the general formula (6) include benzenesulfonate, 4-toluenesulfonate, 2-toluenesulfonate, xylenesulfonate with an arbitrary substitution position, trimethylbenzenesulfonate, mesitylenesulfonate, 4-methoxybenzenesulfonate, 4-ethylbenzenesulfonate, 2,4,6-triisopropylbenzenesulfonate, 1-naphthalenesulfonate, 2-naphthalenesulfonate, anthraquinone-1-sulfonate, anthraquinone-2-sulfonate, 4-(4-methylbenzenesulfonyloxy)benzenesulfonate, 3,4-bis(4-methylbenzenesulfonyloxy)benzenesulfonate, 6-(4-methylbenzenesulfonyloxy)naphthalene-2-sulfonate, 4-phenyloxybenzenesulfonate, 4-diphenylmethylbenzenesulfonate, 2,4-dinitrobenzenesulfonate, and dodecylbenzenesulfonate.

Specific examples of alkanesulfonate anion represented by the general formula (7) include methanesulfonate, ethanesulfonate, propanesulfonate, butanesulfonate, pentanesulfonate, hexanesulfonate, cyclohexanesulfonate, octanesulfonate, and 10-camhporsulfonate.

Further, it is more preferable that a conjugate acid X-H of X⁻ in the general formulae (2), (3), and (4) has a boiling point of 200°C or lower. As used herein the boiling point is a value at one atmosphere (1013 hPa) .

X⁻ in the general formulae (2), (3), and (4) is particularly preferably trifluoroacetate anion, pentafluoropropionate anion, 2-hydroxy-2,2-bis(trifluoromethyl)acetate anion, chloride ion, or nitrate ion.

Examples of the base generator (C) include, but not limited to, any combinations of the above specific examples of cation and the above specific examples of anion. Examples of a preferable structure are as follows. In the following formulae, tBu is a tert-butyl group.

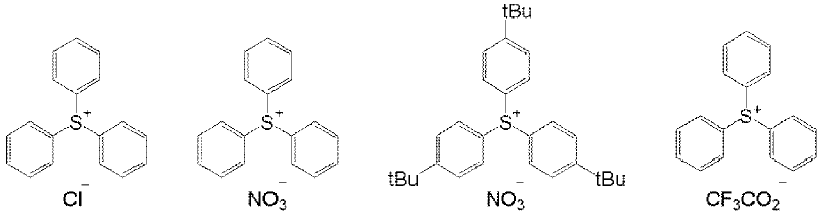

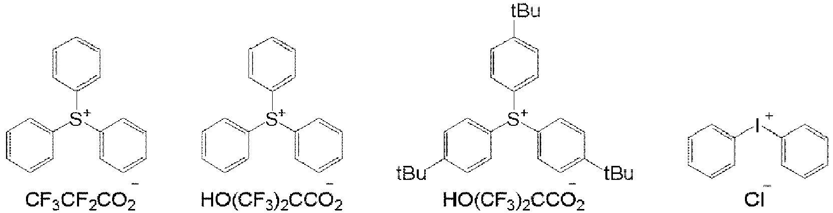

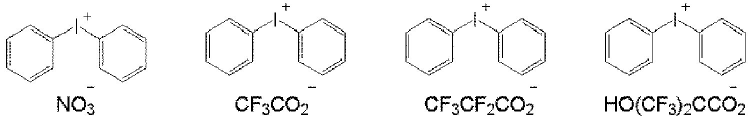

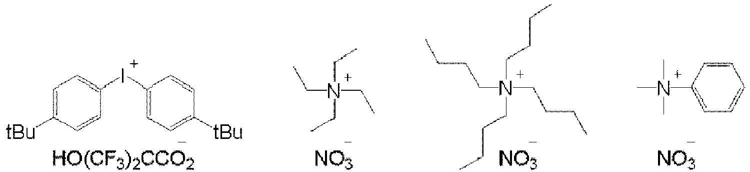

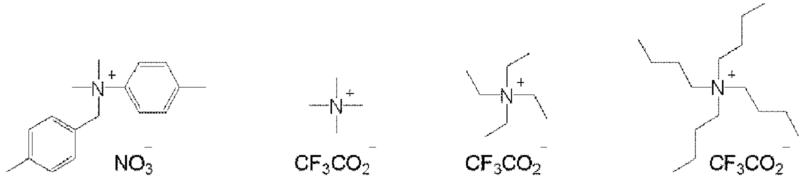

The base generator (C) is used singly or in combination of two or more kinds so that basicity can be expressed in accordance with the baking temperature of the resist underlayer film material, and the balance between the film formability on a hydrophobic substrate and the planarizing property can be adjusted adequately. When the base generator is added, the amount added is preferably 0.5 to 20 parts by mass, more preferably 1 to 5 parts by mass with respect to 100 parts by mass of the crosslinking agent (B). When the amount of base generator added is within the range above, a sufficient film formability-improving effect can be achieved to prevent deterioration of in-plane uniformity of the film due to decomposition and sublimation, or reduction in curability of the compound or resin due to basicity.

### (D) Organic Solvent

The organic solvent (D) that can be used in the resist underlayer film material in the present invention is not limited as long as it can dissolve one or two or more kinds of the compound (A), one or two or more kinds of the crosslinking agent (B), and the base generator (C), and those that can dissolve the surfactant (E), plasticizer (F), and pigment (G) described later are preferred.

Specifically, the solvent disclosed in paragraphs [0091] to [0092] in JP 2007-199653 A can be added. More specifically, propylene glycol monomethyl ether acetate, propylene glycol monomethyl ether, propylene glycol monoethyl ether, propylene glycol monopropyl ether, 2-heptanone, cyclopentanone, cyclohexanone, diacetone alcohol, ethyl lactate, and γ-butyrolactone, or a mixture containing one or more kinds of these is preferably used.

It is preferable that the amount of the organic solvent is adjusted according to the setting film thickness of the resist underlayer film. Typically, the amount of the organic solvent is in a range of 100 to 50,000 parts by mass with respect to 100 parts by mass of the compound (A) (the component (A)).

In the resist underlayer film material in the present invention, it is preferable that the organic solvent (D) is a mixture of one or more kinds of organic solvent having a boiling point of lower than 180°C and one or more kinds of organic solvent having a boiling point of 180°C or higher (hereinafter also referred to as "high boiling point solvent").

Specific examples of the organic solvent having a boiling point of lower than 180°C include propylene glycol monomethyl ether acetate, propylene glycol monomethyl ether, propylene glycol monoethyl ether, propylene glycol monopropyl ether, 2-heptanone, cyclopentanone, and cyclohexanone.

The organic solvent having a boiling point of 180°C or higher is not limited to hydrocarbons, alcohols, ketones, esters, ethers, chlorinated solvents, and the like as long as it can dissolve each component of the resist underlayer film material of the present invention. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, diethylene glycol diacetate, diethylene glycol dibenzoate, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, triethylene glycol diacetate, triethylene glycol dibenzoate, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexane diol diacetate, triethylene glycol diacetate, γ-butyrolactone, methyl benzoate, ethyl benzoate, propyl benzoate, butyl benzoate, benzyl benzoate, dihexyl malonate, diethyl succinate, dipropyl succinate, dibutyl succinate, dihexyl succinate, dimethyl adipate, diethyl adipate, and dibutyl adipate. These may be used singly or in mixture.

The organic solvent having a boiling point of 180°C or higher may be selected as appropriate, for example, from those listed above, in accordance with the temperature at which the resist underlayer film material in the present invention is thermally treated. The boiling point of the organic solvent having a boiling point of 180°C or higher is preferably 180°C to 300°C, even more preferably 200°C to 300°C. Presumably, such boiling points can prevent too fast evaporation in baking (heat treatment) which would occur if the boiling point is too low. Thus, sufficient thermal flowability can be obtained during film formation, resulting in a resist underlayer film with excellent filling and planarizing properties. In addition, such boiling points can prevent solvent residues which would be left in the film without being evaporated after baking if the boiling point was too high. Thus, there is no possibility of adverse effects on the film properties such as etching resistance.

When the organic solvent having a boiling point of 180°C or higher is used, the amount blended is preferably 1 to 30 parts by mass with respect to 100 parts by mass of the organic solvent having a boiling point of lower than 180°C. Preferably, such a blending amount can prevent a failure in imparting sufficient thermal flowability in baking, which would occur if the blending amount was too small, or prevent deterioration of film properties such as etching resistance, which would occur if the blending amount was too much and the solvent was left in the film.

### (E) Surfactant

The surfactant (E) can be added to the resist underlayer film material in the present invention in order to improve the coating property in spin coating. For example, those disclosed in [0142] to [0147] in JP 2009-269953 A can be used as the surfactant. When the surfactant is added, the amount added is preferably 0.001 to 20 parts by mass, more preferably 0.01 to 10 parts by mass with respect to 100 parts by mass of the component (A).

### (F) Plasticizer

The plasticizer (F) can also be added to the resist underlayer film material in the present invention in order to further improve planarizing/filling properties. The plasticizer is not limited and various known plasticizers can be used. Examples include low molecular weight compounds such as phthalate esters, adipate esters, phosphate esters, trimellitate esters, and citrate esters, and polymers such as polyethers, polyesters, and polyacetal-based polymers disclosed in JP 2013-253227 A. When the plasticizer is added, the amount added is preferably 5 to 500 parts by mass, more preferably 10 to 200 parts by mass with respect to 100 parts by mass of the component (A).

### (G) Pigment

The pigment (G) can also be added to the resist underlayer film material in the present invention in order to further improve the resolution in patterning in multilayer lithography. The pigment may be any compound that has appropriate absorption at exposure wavelengths, and various known compounds can be widely used. Examples can include benzenes, naphthalenes, anthracenes, phenanthrenes, pyrenes, isocyanuric acids, and triazines. When the pigment is added, the amount added is preferably 0.01 to 10 parts by mass, more preferably 0.1 to 5 parts by mass with respect to 100 parts by mass of the component (A).

### <Pattern Forming Method>

The present invention also provides a method of forming a pattern in a substrate to be processed. The method includes steps of:
(I-1) applying the resist underlayer film material described above on a substrate to be processed and thereafter performing heat treatment to form a resist underlayer film;
(I-2) forming a resist upper layer film using a photoresist material on the resist underlayer film;
(I-3) performing pattern exposure and subsequent development with a developer in the resist upper layer film to form a pattern in the resist upper layer film;
(I-4) transferring a pattern to the resist underlayer film by dry-etching while using the resist upper layer film having the pattern as a mask; and
(I-5) processing the substrate to be processed while using the resist underlayer film having the pattern as a mask to form a pattern in the substrate to be processed (two-layer resist process).

Further, the present invention provides a method of forming a pattern in a substrate to be processed. The method includes steps of:
(II-1) applying the resist underlayer film material described above on a substrate to be processed and thereafter performing heat treatment to form a resist underlayer film;
(II-2) forming a resist middle layer film on the resist underlayer film;
(II-3) forming a resist upper layer film using a photoresist material on the resist middle layer film;
(II-4) performing pattern exposure and subsequent development with a developer in the resist upper layer film to form a pattern in the resist upper layer film;
(II-5) transferring a pattern to the resist middle layer film by dry-etching while using the resist upper layer film having the pattern as a mask;
(II-6) transferring a pattern to the resist underlayer film by dry-etching while using the resist middle layer film having the transferred pattern as a mask; and
(II-7) processing the substrate to be processed while using the resist underlayer film having the pattern as a mask to form a pattern in the substrate to be processed (three-layer resist process).

In addition, the present invention provides a method of forming a pattern in a substrate to be processed. The method includes steps of:
(III-1) applying the resist underlayer film material described above on a substrate to be processed and thereafter performing heat treatment to form a resist underlayer film;
(III-2) forming an inorganic hard mask middle layer film selected from the group consisting of a silicon oxide film, a silicon nitride film, and a silicon oxynitride film on the resist underlayer film;
(III-3) forming an organic thin film on the inorganic hard mask middle layer film;
(III-4) forming a resist upper layer film using a photoresist material on the organic thin film;
(III-5) performing pattern exposure and subsequent development with a developer in the resist upper layer film to form a pattern in the resist upper layer film; (III-6) transferring a pattern to the organic thin film and the inorganic hard mask middle layer film by dry-etching while using the resist upper layer film having the pattern as a mask;
(III-7) transferring a pattern to the resist underlayer film by dry-etching while using the inorganic hard mask middle layer film having the transferred pattern as a mask; and
(III-8) processing the substrate to be processed while using the resist underlayer film having the pattern as a mask to form a pattern in the substrate to be processed (four-layer resist process).

The thickness of the resist underlayer film used in the present invention is selected as appropriate and preferably 2 to 20,000 nm, particularly preferably 50 to 15,000 nm. In the case of the resist underlayer film for a three-layer process, a resist middle layer film (middle layer film) containing silicon and a resist upper layer film containing no silicon can be formed on the resist underlayer film. In the case of the resist underlayer film for a two-layer process, a resist upper layer film containing silicon or a resist upper layer film containing no silicon can be formed on the resist underlayer film.

The pattern forming method in the present invention can be suitably used in a multilayer resist process such as a two-layer resist process involving silicon, a three-layer resist process using a silicon-containing middle layer film, a four-layer resist process using a silicon-containing middle layer film and an organic thin film, or a two-layer resist process involving no silicon.

### Three-Layer Resist Process

The pattern forming method in the present invention will be described below, taking a three-layer resist process as an example, but the pattern forming method is not limited to this process. In this case, a resist underlayer film is formed using the above resist underlayer film material on a substrate; a resist middle layer film is formed using a resist middle layer film material containing silicon atoms on the resist underlayer film; a resist upper layer film is formed using a resist upper layer film material having a photoresist composition on the resist middle layer film to form a multilayer resist film; a pattern circuit region in the resist upper layer film is exposed and thereafter developed with a developer to form a resist pattern in the resist upper layer film; the resist middle layer film is etched using the resist upper layer film having the pattern as a mask; the resist underlayer film is etched using the resist middle layer film having the pattern as a mask; and the substrate is processed using the resist underlayer film having the pattern as a mask to form a pattern in the substrate.

Since the resist middle layer film containing silicon atoms exhibits etching resistance against etching with oxygen gas or hydrogen gas, it is preferable that etching of the resist underlayer film using the resist middle layer film as a mask is performed using an etching gas based on oxygen gas or hydrogen gas.

Alternatively, in the pattern forming method in the present invention, at least, a resist underlayer film is formed on a substrate using the above resist underlayer film material; an inorganic hard mask middle layer film selected from the group consisting of a silicon oxide film, a silicon nitride film, and a silicon oxynitride film is formed on the resist underlayer film; a resist upper layer film is formed on the inorganic hard mask middle layer film using a resist upper layer film material containing a photoresist composition; a pattern circuit region in the resist upper layer film is exposed and thereafter developed with a developer to form a resist pattern in the resist upper layer film; the inorganic hard mask middle layer film is etched using the resulting resist pattern as an etching mask; the resist underlayer film is etched using the resulting inorganic hard mask middle layer film pattern as an etching mask; and the substrate is processed using the resulting resist underlayer film pattern as a mask to form a pattern in the substrate.

As described above, when an inorganic hard mask middle layer film is formed on the resist underlayer film, a silicon oxide film, a silicon nitride film, or a silicon oxynitride film (SiON film) is formed by a CVD method, an ALD method, or the like. A method of forming a nitride film is disclosed in JP 2002-334869 A and WO 2004/066377 A1. The film thickness of the inorganic hard mask is 5 to 200 nm, preferably 10 to 100 nm. A SiON film which is effective as an anti-reflective film is most preferably used for ArF exposure.

A polysilsesquioxane-based middle layer film can be suitably used as the silicon-containing resist middle layer film in the three-layer resist process. The polysilsesquioxane-based middle layer film is advantageous in that it can easily impart the anti-reflection effect in excimer exposure and thereby suppress reflected light in pattern exposure of the resist upper layer film to achieve high resolution. In particular, when a material containing a large amount of aromatic groups is used for a resist underlayer film for 193-nm exposure, the k value increases and the substrate reflection increases. However, the resist middle layer film can suppress reflection so that the substrate reflection can be 0.5% or less. As the resist middle layer film having the anti-reflection effect, polysilsesquioxane having anthracene for 248-nm and 157-nm exposure, or having a phenyl group or a light-absorbing group having a silicon-silicon bond for 193-nm light exposure in a pendant manner which is crosslinked by an acid or heat is preferably used.

In this case, forming a silicon-containing resist middle layer film by a spin coating method is easier and more advantageous in terms of cost than by a CVD method

The resist upper layer film in the three-layer resist film may be either a positive type or a negative type, and the same photoresist composition as those commonly used can be used. When the resist upper layer film is formed using the above photoresist composition, a spin coating method is preferably used in the same manner as when the resist underlayer film is formed. After the photoresist composition is spin-coated, prebake is performed preferably in the range of 60 to 180°C for 10 to 300 seconds. Thereafter, exposure, post-exposure bake (PEB), and development are performed according to the ordinary method to obtain a resist pattern. The thickness of the resist upper layer film is preferably, but not limited to, 30 to 500 nm, particularly preferably 50 to 400 nm.

Examples of exposure light include high energy beams with a wavelength of 300 nm or less, specifically, 248 nm, 193 nm, or 157 nm excimer laser beams, 3 to 20 nm soft X-ray, electron beams, and X-ray with a wavelength of less than 3 nm.

Subsequently, etching is performed using the resulting resist pattern as a mask. The etching of the resist middle layer film in the three-layer process is performed using the resist pattern as a mask using a fluorocarbon-based gas. Subsequently, using the resist middle layer film pattern as a mask, the resist underlayer film is etched using oxygen gas or hydrogen gas.

The subsequent processing of the substrate to be processed can also be performed according to the ordinary method. For example, when the substrate is a SiO₂, SiN, or silica-based low dielectric constant insulating film, etching based on a fluorocarbon-based gas is performed, or when the substrate is made of p-Si, Al, or W, etching based on a chlorine or bromine-based gas is performed. When the substrate is etched with a fluorocarbon-based gas, the silicon-containing middle layer film in the three-layer process is stripped simultaneously with the substrate processing. When the substrate is etched with a chlorine or bromine-based gas, the silicon-containing middle layer film needs to be stripped by dry-etching with a fluorocarbon-based gas, separately after the substrate processing.

As the substrate to be processed, a layer to be processed is formed on a substrate. The substrate is not particularly limited, and a substrate made of a material different from the layer to be processed, such as Si, α-Si, p-Si, SiO₂, SiN, SiON, W, TiN, or Al, is used. As the layer to be processed, for example, a variety of low-k films made of Si, SiO₂, SiON, SiN, p-Si, α-Si, W, TiN, W-Si, Al, Cu, Al-Si, and the like and a stopper film thereof are used. The layer is formed to a thickness of typically 50 to 10,000 nm, particularly 100 to 5,000 nm. Further, a substrate having a static contact angle with water of 50° or more can be suitably used as the substrate to be processed.

The pattern forming method in the present invention is suitable even for processing a stepped substrate having a structure or a step with a height of 30 nm or more. The resist underlayer film material in the present invention is formed on the stepped substrate to fill and planarize the substrate, thereby ensuring that the resist middle layer film and the resist upper layer film subsequently formed have a uniform thickness. This is very preferable because the exposure depth margin (depth of focus: DOF) in photolithography is easily ensured. Further, the present pattern forming method is also useful when a substrate having a static contact angle with water of 50° or more is used as the substrate to be processed.

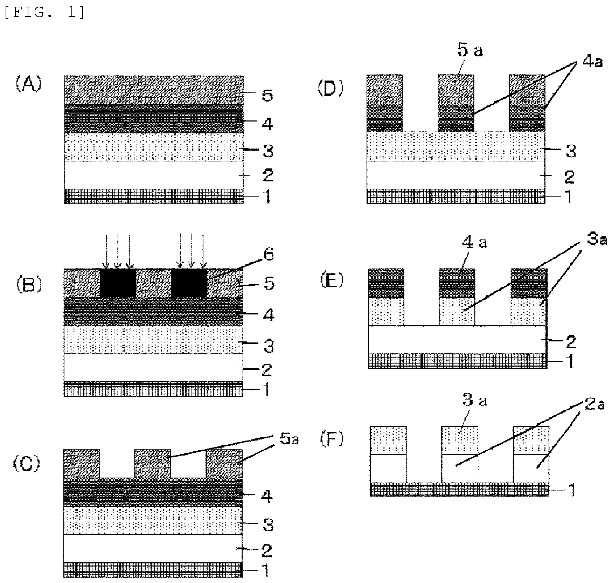

An example of the three-layer resist process will be specifically described below with reference to FIG. 1. In the case of a three-layer resist process, as illustrated in FIG. 1(A), a resist underlayer film 3 is formed on a layer 2 to be processed deposited on a substrate 1, and then a resist middle layer film 4 is formed and a resist upper layer film 5 is formed thereon.

Subsequently, as illustrated in FIG. 1(B), a predetermined portion 6 of the resist upper layer film is subjected to exposure, post-exposure bake (PEB), and development to form a resist upper layer film pattern 5a (FIG. 1(C)). Using the resulting resist upper layer film pattern 5a as a mask, the resist middle layer film 4 is etched using a CF-based gas to form a resist middle layer film pattern 4a (FIG. 1(D)). After the resist upper layer film pattern 5a is removed, the resist underlayer film 3 is etched with oxygen or hydrogen-based plasma using the resulting resist middle layer film pattern 4a as a mask to form a resist underlayer film pattern 3a (FIG. 1(E)). Further, after the resist middle layer film pattern 4a is removed, the layer 2 to be processed is etched using the resist underlayer film pattern 3a as a mask to form a pattern 2a (FIG. 1(F)).

When an inorganic hard mask middle layer film is used, the resist middle layer film 4 is the inorganic hard mask middle layer film, and when an organic thin film is formed, the organic thin film layer is provided between the resist middle layer film 4 and the resist upper layer film 5. The organic thin film may be etched successively prior to the etching of the resist middle layer film 4. Alternatively, only the organic thin film may be etched and thereafter the resist middle layer film 4 may be etched, for example, with a different etching apparatus.

### Four-Layer Resist Process

The present invention can also be suitably used in a four-layer resist process using an organic thin film. In this case, at least, a resist underlayer film is formed on a substrate using the above resist underlayer film material; an inorganic hard mask middle layer film selected from the group consisting of a silicon oxide film, a silicon nitride film, and a silicon oxynitride film is formed on the resist underlayer film; an organic thin film is formed on the inorganic hard mask middle layer film; a resist upper layer film is formed on the organic thin film using a resist upper layer film material containing a photoresist composition; a pattern circuit region in the resist upper layer film is exposed and thereafter developed with a developer to form a resist pattern in the resist upper layer film; the organic thin film and the inorganic hard mask middle layer film are etched using the resulting resist pattern as an etching mask; the resist underlayer film is etched using the resulting inorganic hard mask middle layer film pattern as an etching mask; and the substrate is processed using the resulting resist underlayer film pattern as a mask to form a pattern in the substrate.

A photoresist film may be formed as the resist upper layer film on the resist middle layer film. Alternatively, an organic thin film may be formed by spin coating on the resist middle layer film and a photoresist film may be formed on the organic thin film, as described above. When a SiON film is used as the resist middle layer film and an organic anti-reflective film (BARC) having a light-absorbing group at an exposure wavelength is used as the organic thin film, the two-layer anti-reflective film including the SiON film and the organic thin film can suppress reflection in excimer exposure, even in liquid immersion exposure with a high NA exceeding 1.0. Other advantages of forming an organic thin film include reducing resist footing of the photoresist pattern immediately above SiON. It is also advantageous that pattern collapse of the photoresist can be prevented when an adhesive film (ADL) with excellent affinity to the upper layer photoresist is used as the organic thin film.

### <Method of Forming Resist Underlayer Film>

The present invention provides a method of forming a resist underlayer film that functions as an organic planarizing film employed in a semiconductor device manufacturing process, wherein the above resist underlayer film material is spin-coated on a substrate to be processed, and the substrate coated with the resist underlayer film material is hardened by heat treatment in a range of temperature of 100°C or higher and 600°C or lower for 10 to 600 seconds to form a resist underlayer film (cured film).

The present invention also provides a method of forming a resist underlayer film that functions as an organic planarizing film employed in a semiconductor device manufacturing process, wherein the above resist underlayer film material is spin-coated on a substrate to be processed, and the substrate coated with the resist underlayer film material is hardened by heat treatment in an atmosphere with an oxygen concentration of 1% by volume or more and 21% by volume or less to form a resist underlayer film (cured film).

Alternatively, the present invention provides a method of forming a resist underlayer film that functions as an organic planarizing film employed in a semiconductor device manufacturing process, wherein the above resist underlayer film material is spin-coated on a substrate to be processed, and the substrate coated with the resist underlayer film material is hardened by heat treatment in an atmosphere with an oxygen concentration of less than 1% by volume to form a resist underlayer film (cured film).

In the method of forming a resist underlayer film in the present invention, a substrate to be processed is coated with the above resist underlayer film material using a spin coating method or the like. A spin coating method or the like can be used to achieve good filling property. After spin coating, the solvent is evaporated and baking for accelerating a crosslinking reaction is performed to prevent mixing with the resist upper layer film or the resist middle layer film. The baking is performed in a temperature range of 100°C or higher and 600°C or lower, preferably 100°C or higher and 300°C or lower, more preferably 150°C or higher and 280°C or lower, for 10 to 600 seconds, preferably for 10 to 300 seconds. The baking temperature and time can be adjusted as appropriate within the above ranges to achieve filling and planarizing properties and curability suitable for the intended use. The baking temperature of 100°C or higher allows curing to proceed well and prevents mixing with the upper layer film or the middle layer film. The baking temperature of 600°C or lower can suppress thermal decomposition of the base resin, prevent reduction of the film thickness, and achieve a uniform film surface.

The atmosphere in baking can be selected as necessary from an oxygen-containing atmosphere such as the air (oxygen concentration of 1% by volume to 21% by volume) and a non-oxygen atmosphere such as nitrogen. For example, when the substrate to be processed is susceptible to air oxidation, damage to the substrate can be suppressed by forming the cured film by heat treatment in an atmosphere with an oxygen concentration of less than 1% by volume (non-oxygen atmosphere).

In the method of forming a resist underlayer film in the present invention, it is also preferable that a substrate having a structure or a step with a height of 30 nm or more is used as the substrate to be processed. The method of forming a resist underlayer film in the present invention is particularly useful when a planarizing organic film free from voids is formed on a substrate having a structure or a step with a height of 30 nm or more. Further, the method is also useful when a substrate having a static contact angle with water of 50° or more is used as the substrate to be processed.

### EXAMPLE

Hereinafter, the present invention will be specifically described with reference to Examples and Comparative Examples. However, the present invention is not limited thereto. The molecular weight and the dispersity were measured by the following method. The weight average molecular weight (Mw) in terms of polystyrene and the dispersity (Mw/Mn) were determined by gel permeation chromatography (GPC) using tetrahydrofuran as an eluent. The introduction ratio of the end group and the residual rate of the phenolic hydroxyl group of the end group were calculated by 1H NMR.

### Synthesis Example Synthesis of Compound for Forming Resist Underlayer Film Material

Compounds (D1) to (D19) for resist underlayer film materials and compounds (R1) to (R3) for comparative examples were synthesized using the following carboxylic acid group-containing compounds: compound group A (A1) to (A14), a hydroxyl group-containing compound (B1), and an epoxy group-containing compound: compound group C (C1) to (C12).

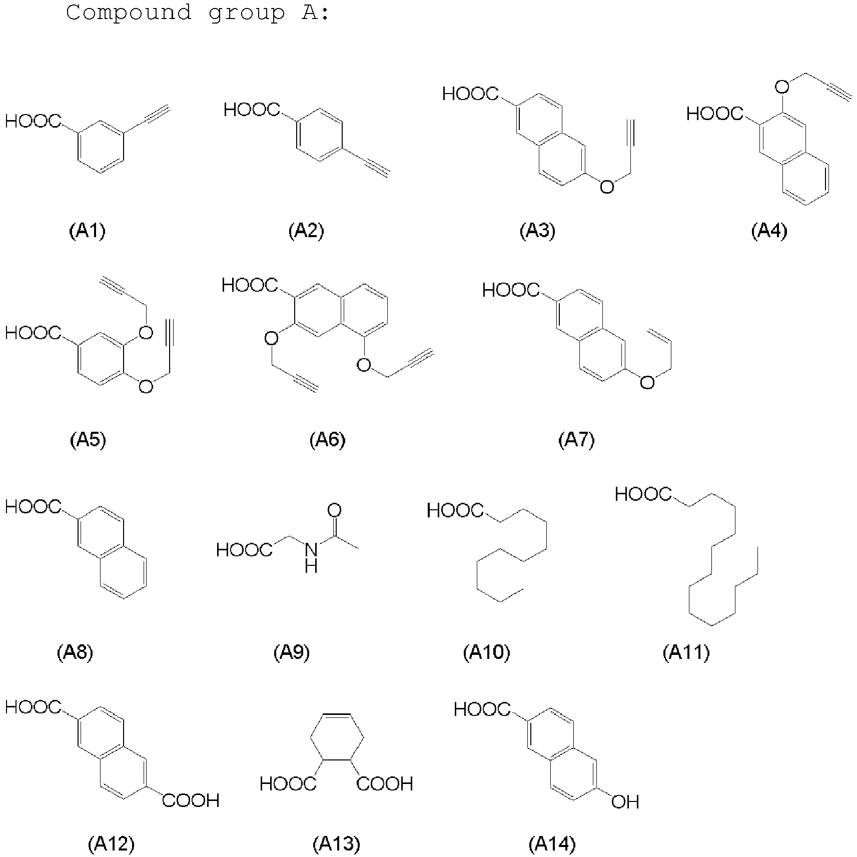

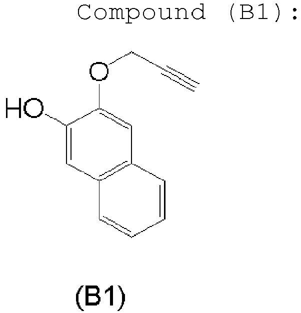

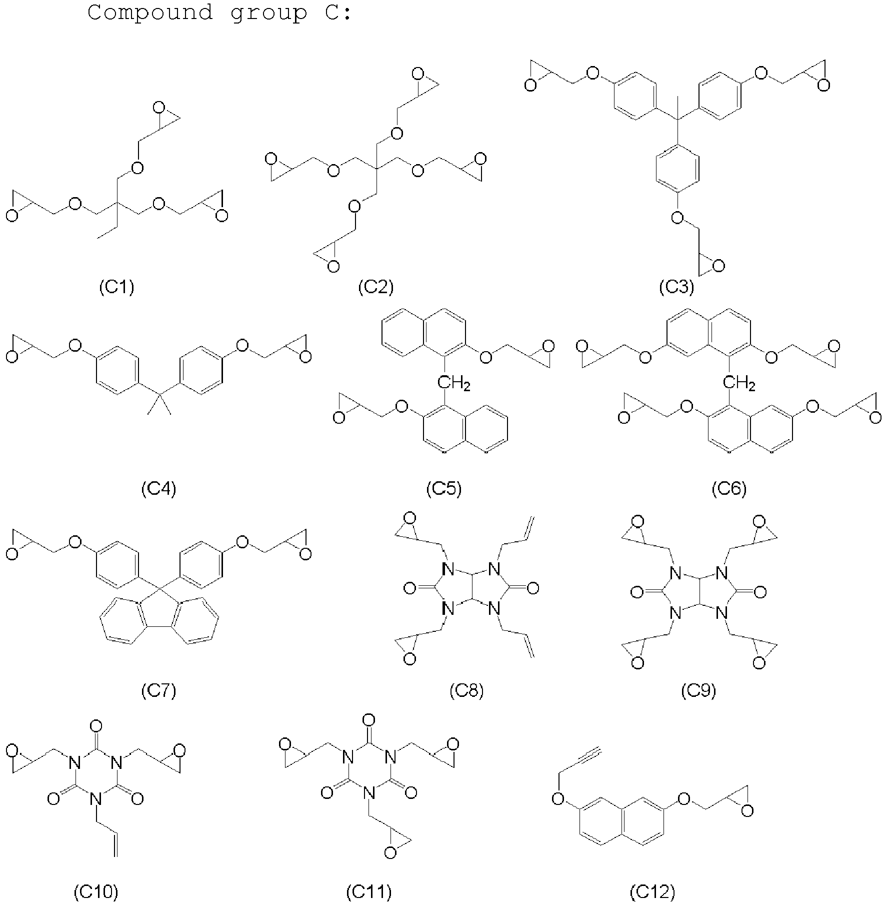

Purchased reagents were used except for the followings.
(C1) Epolight MF (manufactured by KYOEISHA CHEMICAL Co., Ltd.) epoxy equivalent: 140
(C2) PETG (manufactured by Resonac Corporation) epoxy equivalent: 90
(C3) 1032H60 (manufactured by Mitsubishi Chemical Corporation) epoxy equivalent: 167
(C4) EXA-850CRP (manufactured by DIC Corporation) epoxy equivalent: 172
(C5) HP-4770 (manufactured by DIC Corporation) epoxy equivalent: 205
(C6) HP-4700 (manufactured by DIC Corporation) epoxy equivalent: 165
(C8) DAG-G (manufactured by SHIKOKU CHEMICALS CORPORATION) epoxy equivalent: 168
(C9) TG-G (manufactured by SHIKOKU CHEMICALS CORPORATION) epoxy equivalent: 92
(C10) MA-DGIC (manufactured by SHIKOKU CHEMICALS CORPORATION) epoxy equivalent: 141

### Synthesis Example 1 Synthesis of Compound (D1)

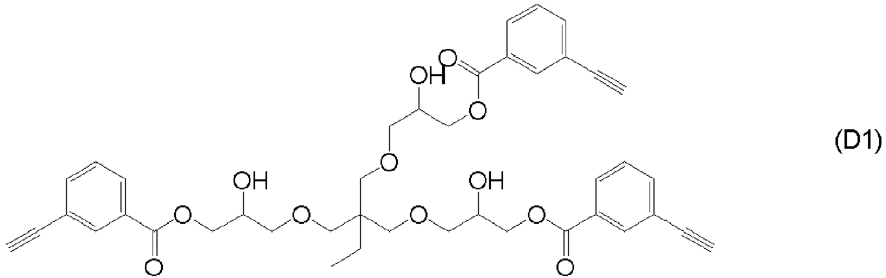

In a nitrogen atmosphere, 14.6 g of carboxylic acid compound (A1), 14.0 g of epoxy compound (C1), and 60 g of 2-methoxy-1-propanol were stirred at an internal temperature of 100°C to form a homogeneous solution. Then, 1.00 g of benzyltriethylammonium chloride was added and the mixture was stirred at an internal temperature of 110°C for 12 hours. After cooling to room temperature, 200 ml of methyl isobutyl ketone was added, and washing was performed with 100 g of 1 wt% aqueous ammonia solution twice, with 100 g of 3% nitric acid aqueous solution twice, and with 100 g of ultrapure water five times, in this order. The organic layer was evaporated to dryness under reduced pressure to obtain compound (D1).

The weight average molecular weight (Mw) and the dispersity (Mw/Mn) were determined by GPC. Mw = 880 and Mw/Mn = 1.03.

### Synthesis Examples 2 to 17 Synthesis of Compounds (D2) to (D17)

Compounds (D2) to (D17) listed in Tables 2 to 4 were obtained as products under the same conditions as in Synthesis Example 1 except that compound group A, compound (B1), and compound group C listed in Table 1 were used. The weight average molecular weight (Mw), the dispersity (Mw/Mn) of these compounds and, when two or more kinds of carboxylic acid compounds were used, the end group ratio were determined, and the results were listed in Tables 2 to 4.

**[Table 1]**

| Synthesis Example | Compound group A | Compound B1 | Compound group C | Pro-duct |
|---|---|---|---|---|
| 1 | A1: 14.6g | - | C1: 14.0g | D1 |
| 2 | A2: 14.6g | - | C9: 9.2g | D2 |
| 3 | A3: 22.6g | - | C10: 14.1g | D3 |
| 4 | A3: 22.6g | - | C11: 9.9g | D4 |
| 5 | A3: 22.6g | - | C4: 17.2g | D5 |
| 6 | A3: 22.6g | - | C5: 20.5g | D6 |
| 7 | A3: 18.9g | - | C11: 9.9g | D7 |
| | A9: 2.0g | | | |
| 8 | A4: 19.4g | - | C11: 9.9g | D8 |
| | A10: 2.7g | | | |
| 9 | A5: 23.0g | - | C7: 23.1g | D9 |
| 10 | A6: 28.0g | - | C5: 20.5g | D10 |
| 11 | A4: 22.6g | - | C3: 16.7g | D11 |
| 12 | A3: 15.8g | - | C9: 9.2g | D12 |
| | A7: 6.8g | | | |
| 13 | A8: 8.6g | - | C6: 16.5g | D13 |
| | A11: 11.4g | | | |
| 14 | - | B1: 19.8g | C2: 9.0g | D14 |
| 15 | - | B1: 19.8g | C8: 16.8g | D15 |
| 16 | A12: 21.6g | - | C12: 25.4g | D16 |
| 17 | A13: 17.0g | - | C12: 25.4g | D17 |
| 18 | A3: 22.6g | - | C4: 17.2g | D18 |
| 19 | A6: 28.0g | - | C5: 20.5g | D19 |

**[Table 2]**

| Synthesis Example | Compound | Mw | Mw/Mn |
|---|---|---|---|
| 1 | 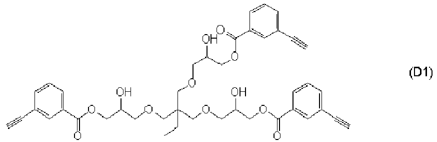 | 880 | 1.03 |
| 2 | 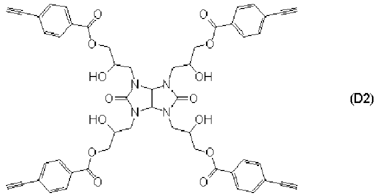 | 1280 | 1.07 |
| 3 | 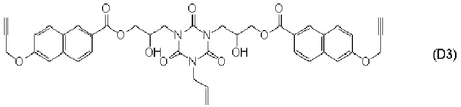 | 920 | 1.05 |
| 4 | 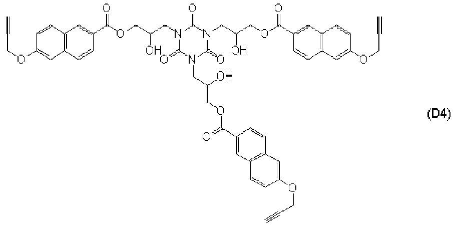 | 1150 | 1.06 |
| 5 | 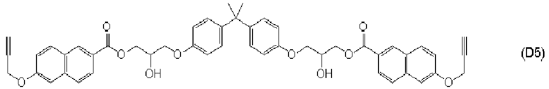 | 1110 | 1.04 |
| 6 | 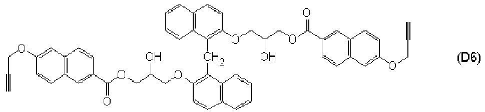 | 1320 | 1.15 |
| 7 | 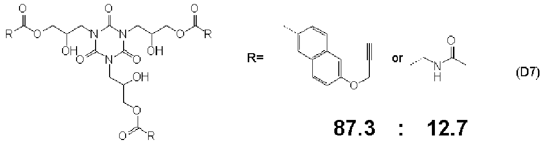 | 1080 | 1.04 |

**[Table 3]**

| Synthesis Example | Compound | Mw | Mw/Mn |
|---|---|---|---|
| 8 | 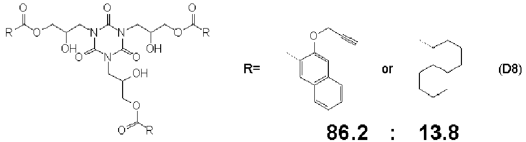 | 1220 | 1.05 |
| 9 | 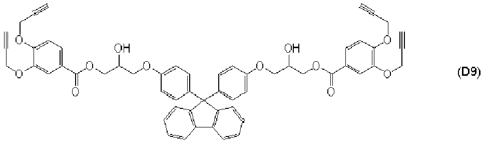 | 1350 | 1.08 |
| 10 | 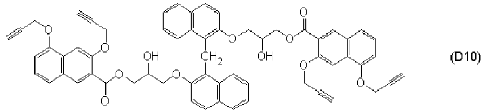 | 1510 | 1.19 |
| 11 | 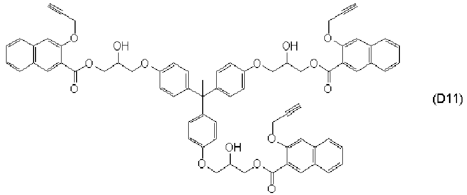 | 960 | 1.11 |
| 12 | 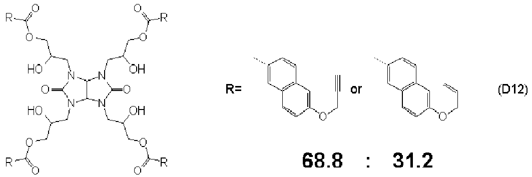 | 1330 | 1.09 |
| 13 | 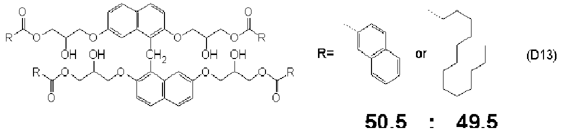 | 2140 | 1.34 |
| 14 | 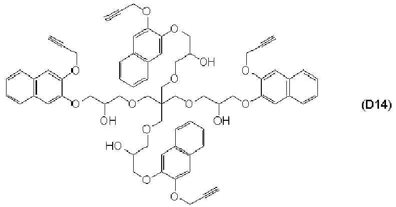 | 1470 | 1.08 |

**[Table 4]**

| Synthesis Example | Compound | Mw | Mw/Mn |
|---|---|---|---|
| 15 | 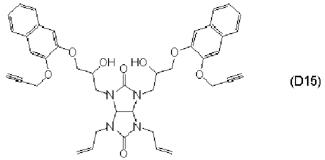 | 910 | 1.04 |
| 16 | 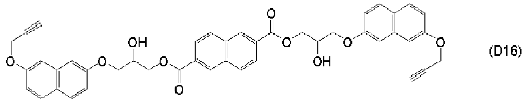 | 860 | 1.04 |
| 17 | 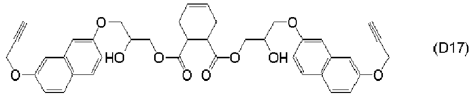 | 720 | 1.03 |

### Synthesis Example 18 Synthesis of Compound (D18)

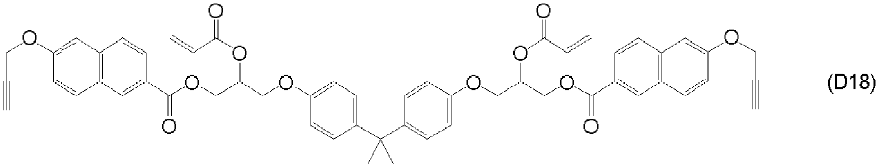

15.9 g of compound (D5), 4.0 g of acryloyl chloride, and 50 g of N-methylpyrrolidone were added and the mixture was stirred. To this mixture, 4.5 g of triethylamine was added dropwise and the mixture was stirred for 24 hours. Ethyl acetate was added to dilute the mixture, and the diluted solution was washed with water three times and purified by silica gel chromatography to obtain compound (D18).

The weight average molecular weight (Mw) and the dispersity (Mw/Mn) were determined by GPC. Mw = 1200 and Mw/Mn = 1.05.

### Synthesis Example 19 Synthesis of Compound (D19)

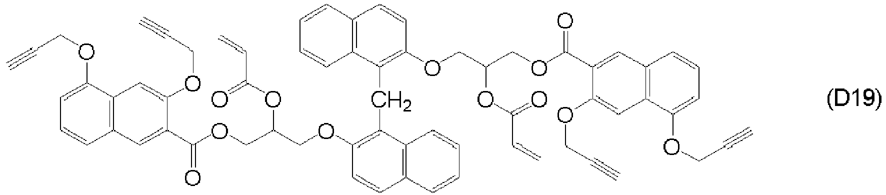

Compound (D19) was obtained as a product under the same conditions as in Synthesis Example 18 except that compound (D10) was used. The weight average molecular weight (Mw) and the dispersity (Mw/Mn) were determined by GPC. Mw = 1640 and Mw/Mn = 1.27.

### Synthesis Examples 20 to 22 Synthesis of Comparative Compounds (R1) to (R3)

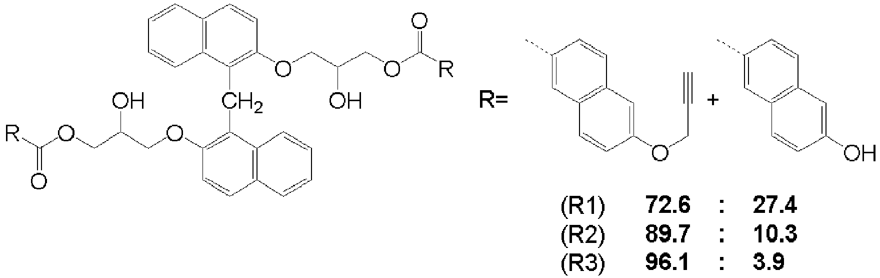

In a nitrogen atmosphere, 18.8 g of carboxylic acid compound (A14), 20.5 g of epoxy compound (C5), and 60 g of 2-methoxy-1-propanol were stirred at an internal temperature of 100°C to form a homogeneous solution. Then, 1.00 g of benzyltriethylammonium chloride was added and the mixture was stirred at an internal temperature of 110°C for 12 hours. After cooling to room temperature, 200 ml of methyl isobutyl ketone was added, and washing was performed with 100 g of 1 wt% aqueous ammonia solution twice and with 100 g of ultrapure water three times. Then, the solution was concentrated under reduced pressure to synthesize an intermediate. To the resulting intermediate, 60 g of dimethylformamide and 15.9 g of potassium carbonate were added and stirred. To this mixture, propargyl bromide (80% toluene solution) was added dropwise in the amount listed in Table 5, and the mixture was stirred in a nitrogen atmosphere at an internal temperature of 50°C for 20 hours. After cooling to room temperature, 200 ml of methyl isobutyl ketone was added, and washing was performed with 100 g of 3% nitric acid aqueous solution twice and with 100 g of ultrapure water five times, in this order. The organic layer was evaporated to dryness under reduced pressure to obtain compounds (R1) to (R3).

The weight average molecular weight (Mw) and dispersity (Mw/Mn) determined by GPC and the residual rate of the phenolic hydroxyl group in the end group determined by 1H NMR were as listed in Table 5.

**[Table 5]**

| Synthesis Example | Product | Amount of propargyl bromide added dropwise | Mw | Mw/Mn | Residual rate of phenolic hydroxyl group |
|---|---|---|---|---|---|
| 20 | R1 | 10.4g | 1270 | 1.24 | 27.4% |
| 21 | R2 | 13.4g | 1310 | 1.26 | 10.3% |
| 22 | R3 | 14.1g | 1360 | 1.24 | 3.9% |

### Synthesis Example 23 Synthesis of Comparative Polymer (R4)

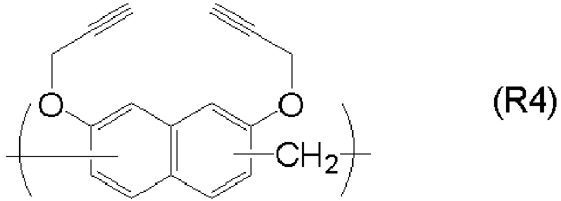

In a nitrogen atmosphere, 78.8 g of 2,7-dipropargyloxynaphthalene, 21.6 g of 37% formalin solution, and 250 g of 1,2-dichloroethane were mixed at a liquid temperature of 70°C to form a homogeneous solution. Then, 5 g of methanesulfonic acid was added slowly and the mixture was stirred at a liquid temperature of 80°C for 12 hours. After cooling to room temperature, 500 g of methyl isobutyl ketone was added, and the organic layer was washed with 200 g of pure water five times. Then, the organic layer was evaporated to dryness under reduced pressure. To the residue, 300 mL of THF was added, and the polymer was reprecipitated by 2000 mL of hexane. The precipitated polymer was collected by filtration and dried under reduced pressure to obtain comparative polymer (R4).

The weight average molecular weight (Mw) and the dispersity (Mw/Mn) were determined by GPC. Mw = 2700 and Mw/Mn = 1.54.

### Synthesis Example 24 Synthesis of Comparative Polymer (R5)

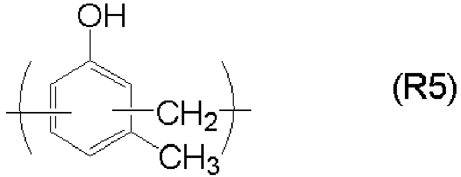

In a nitrogen atmosphere, 54.1 g of m-cresol, 32.5 g of 37% formalin solution, and 250 g of 2-methoxy-1-propanol were mixed at a liquid temperature of 80°C to form a homogeneous solution. Then, 18 g of 20% p-toluenesulfonic acid 2-methoxy-1-propanol solution was added slowly, and the mixture was stirred at a liquid temperature of 110°C for 12 hours. After cooling to room temperature, 500 g of methyl isobutyl ketone was added, and the organic layer was washed with 200 g of pure water five times. Then, the organic layer was evaporated to dryness under reduced pressure. To the residue, 300 mL of THF was added, and the polymer was reprecipitated by 2,000 mL of hexane. The precipitated polymer was collected by filtration and dried under reduced pressure to obtain comparative polymer (R5).

The weight average molecular weight (Mw) and the dispersity (Mw/Mn) were determined by GPC. Mw = 6,900 and Mw/Mn = 5.53.

### Preparation of Resist Underlayer Film Material (UDL-1 to UDL-23, Comparative UDL-1 to UDL- 9)

The above compounds and polymers (D1) to (D19) and (R1) to (R5), (X1) to (X5) as a crosslinking agent, (BG1) to (BG3) as a base generator, (AG1) as an acid generator, tripropylene glycol monomethyl ether (TPM): boiling point 242°C or 1,6-diacetoxyhexane (1,6-DAH): boiling point 260°C as a high boiling point solvent, and propylene glycol monomethyl ether acetate (PGMEA) containing 0.1% by mass of PF6320 (manufactured by OMNOVA Solutions Inc.) were used in the proportions listed in Table 6. The solution was then filtered through a 0.1-pm fluorocarbon resin filter to prepare resist underlayer film materials (UDL-1 to UDL-23, Comparative UDL-1 to UDL-9).

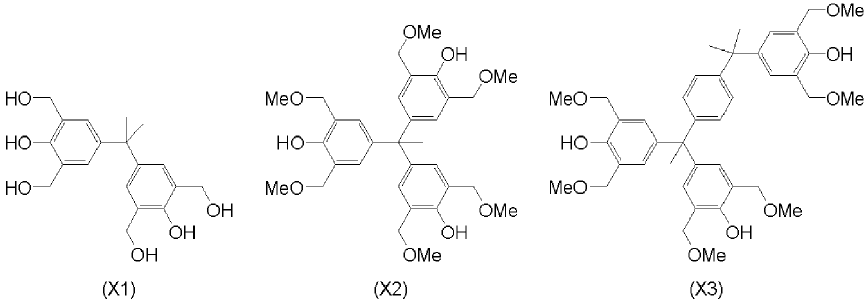

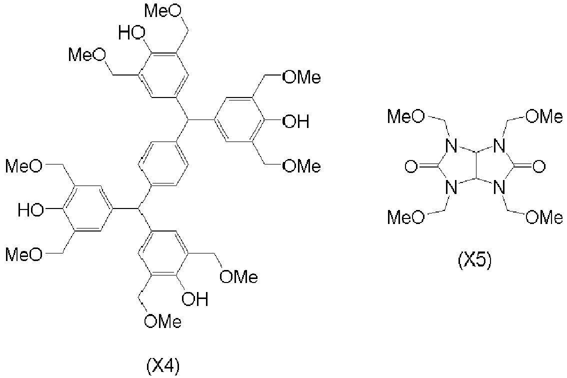

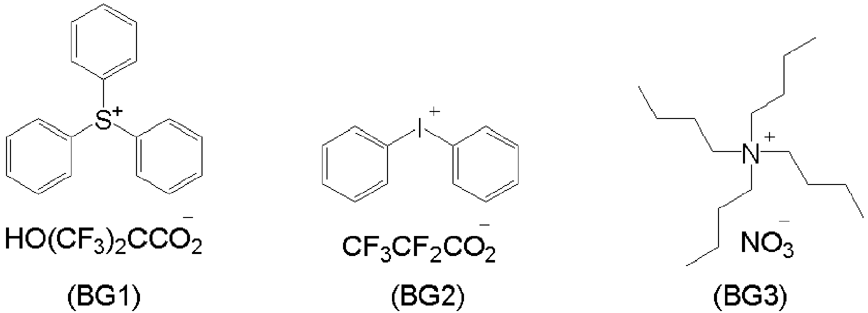

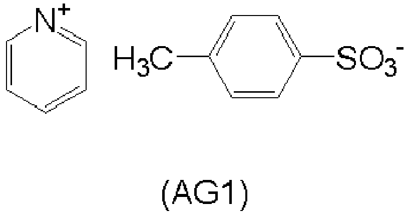

**[Table 6]**

| Resist underlayer film material | Compound or polymer (parts by mass) | Crosslinking agent (parts by mass) | Base generator (parts by mass) | Acid generator (parts by mass) | High boiling point solvent (parts by mass) | PGMEA (parts by mass) |
|---|---|---|---|---|---|---|
| UDL-1 | D1 (10) | X1 (3) | BG1 (0.1) | - | - | 180 |
| UDL-2 | D2 (10) | X2 (3) | BG2 (0.1) | - | - | 180 |
| UDL-3 | D3 (10) | X3 (3) | BG1 (0.1) | - | - | 180 |
| UDL-4 | D4 (10) | X4 (3) | BG1 (0.1) | - | - | 180 |
| UDL-3 | D5 (10) | X3 (3) | BG3 (0.1) | - | - | 180 |
| UDL-6 | D6 (10) | X2 (3) | BG2 (0.1) | - | - | 180 |
| UDL-7 | D7 (10) | X3 (3) | BG1 (0.1) | - | - | 180 |
| UDL-8 | D8 (10) | X3 (3) | BG1 (0.1) | - | - | 180 |
| UDL-9 | D9 (10) | X1 (3) | BG1 (0.1) | - | - | 180 |
| UDL-10 | D10 (10) | X3 (1.5) | BG1 (0.1) | - | - | 180 |
| UDL-11 | D11 (10) | X2 (3) | BG3 (0.1) | - | - | 180 |
| UDL-12 | D12 (10) | X4 (3) | BG2 (0.1) | - | - | 180 |
| UDL-13 | D13 (10) | X1 (3) | BG3 (0.1) | - | - | 180 |
| UDL-14 | D14 (10) | X3 (3) | BG1 (0.1) | - | - | 180 |
| UDL-13 | D15 (10) | X4 (3) | BG3 (0.1) | - | - | 180 |
| UDL-16 | D16 (10) | X3 (3) | BG1 (0.1) | - | - | 180 |
| UDL-17 | D17 (10) | X2 (2.5) | BG2 (0.1) | - | - | 180 |
| UDL-18 | D18 (10) | X3 (3) | BG3 (0.1) | - | - | 180 |
| UDL-19 | D19 (10) | X1 (3) | BG1 (0.1) | - | - | 180 |
| UDL-20 | D3 (9) D14 (1) | X4 (3) | BG1 (0.1) | - | - | 180 |
| UDL-21 | D6 (10) | X3 (3) | BG1 (0.1) | - | 1,6-DAH (10) | 180 |
| UDL-22 | D3 (10) | X3 (3) | BG1 (0.1) | - | TPM (10) | 180 |
| UDL-23 | D7 (10) | X3 (3) | BG1 (0.1) | - | TPM (15) | 180 |
| Comparative UDL-1 | D1 (10) | - | - | - | - | 180 |
| Comparative UDL-2 | D3 (10) | X3 (3) | - | - | - | 180 |
| Comparative UDL-3 | D10 (10) | - | BG1 (0.1) | - | - | 180 |
| Comparative UDL-4 | R1 (10) | X2 (3) | BG2 (0.1) | - | - | 180 |
| Comparative UDL-3 | R2 (10) | X2 (3) | BG2 (0.1) | - | - | 180 |
| Comparative UDL-6 | R3 (10) | X2 (3) | BG2 (0.1) | - | - | 180 |
| Comparative UDL-7 | R4 (10) | X2 (3) | BG1 (0.1) | - | - | 180 |
| Comparative UDL-8 | R5 (10) | X3 (3) | BG2 (0.1) | - | - | 180 |
| Comparative UDL-9 | D11 (10) | X5 (2.5) | BG3 (0.2) | AG1 (0.1) | - | 180 |

### Example 1 Film Formability Evaluation (Examples 1-1 to 1-23, Comparative Examples 1-1 to 1-9)

The prepared resist underlayer film materials (UDL-1 to UDL-23, Comparative UDL-1 to UDL-9) were each applied on a Bare-Si substrate, a substrate treated with SiON, or a substrate treated with hexamethyldisilazane (HMDS) as listed in Table 7, and baked at 250°C for 60 seconds to form a resist underlayer film having a film thickness of 100 nm. The formed organic film was observed with an optical microscope (ECLIPSE L200 manufactured by Nikon Corporation) to check whether there was coating abnormality. The water contact angle of each substrate was measured by a contact angle meter (DM-701R manufactured by Kyowa Interface Science Co., LTd.). The contact angle of the Bare-Si substrate was less than 15°, the contact angle of the SiON-treated substrate was 46°, and the contact angle of the HMDS-treated (90°C × 60 seconds) substrate was 58°. The higher the contact angle, the more hydrophobic the substrate surface, and it is difficult to ensure film formability. In this evaluation, the film thickness is reduced in order to evaluate the superiority in coating property. This is a strict evaluation condition that is likely to cause film formation abnormality.

**[Table 7]**

| | Resist underlayer film material | Bare-Si substrate | SiON-treated substrate | HMDS-treated substrate 90°Cx60s |
|---|---|---|---|---|
| Example 1-1 | UDL-1 | No abnormality | No abnormality | No abnormality |
| Example 1-2 | UDL-2 | No abnormality | No abnormality | No abnormality |
| Example 1-3 | UDL-3 | No abnormality | No abnormality | No abnormality |
| Example 1-4 | UDL-4 | No abnormality | No abnormality | No abnormality |
| Example 1-5 | UDL-3 | No abnormality | No abnormality | No abnormality |
| Example 1-6 | UDL-6 | No abnormality | No abnormality | No abnormality |
| Example 1-7 | UDL-7 | No abnormality | No abnormality | No abnormality |
| Example 1-8 | UDL-8 | No abnormality | No abnormality | No abnormality |
| Example 1-9 | UDL-9 | No abnormality | No abnormality | No abnormality |
| Example 1-10 | UDL-10 | No abnormality | No abnormality | No abnormality |
| Example 1-11 | UDL-11 | No abnormality | No abnormality | No abnormality |
| Example 1-12 | UDL-12 | No abnormality | No abnormality | No abnormality |
| Example 1-13 | UDL-13 | No abnormality | No abnormality | No abnormality |
| Example 1-14 | UDL-14 | No abnormality | No abnormality | No abnormality |
| Example 1-15 | UDL-13 | No abnormality | No abnormality | No abnormality |
| Example 1-16 | UDL-16 | No abnormality | No abnormality | No abnormality |
| Example 1-17 | UDL-17 | No abnormality | No abnormality | No abnormality |
| Example 1-18 | UDL-18 | No abnormality | No abnormality | No abnormality |
| Example 1-19 | UDL-19 | No abnormality | No abnormality | No abnormality |
| Example 1-20 | UDL-20 | No abnormality | No abnormality | No abnormality |
| Example 1-21 | UDL-21 | No abnormality | No abnormality | No abnormality |
| Example 1-22 | UDL-22 | No abnormality | No abnormality | No abnormality |
| Example 1-23 | UDL-23 | No abnormality | No abnormality | No abnormality |
| Comparative Example 1-1 | Comparative UDL-1 | No abnormality | Several pinhole defects | Numerous pinhole defects |
| Comparative Example 1-2 | Comparative UDL-2 | No abnormality | Several pinhole defects | Numerous pinhole defects |
| Comparative Example 1-3 | Comparative UDL-3 | No abnormality | Several pinhole defects | Numerous pinhole defects |
| Comparative Example 1-4 | Comparative UDL-4 | No abnormality | No abnormality | No abnormality |
| Comparative Example 1-5 | Comparative UDL-5 | No abnormality | No abnormality | No abnormality |
| Comparative Example 1-6 | Comparative UDL-6 | No abnormality | No abnormality | No abnormality |
| Comparative Example 1-7 | Comparative UDL-7 | No abnormality | No abnormality | No abnormality |
| Comparative Example 1-8 | Comparative UDL-8 | No abnormality | No abnormality | No abnormality |
| Comparative Example 1-9 | Comparative UDL-9 | No abnormality | Several pinhole defects | Numerous pinhole defects |

As listed in Table 7, the resist underlayer film material in the present invention successfully formed a uniform resist underlayer film with no coating abnormality on the SiON-treated substrate and the HMDS-treated (90°C × 60 seconds) substrate. The comparison between the results of Examples 1-1 to 1-23 and the results of Comparative Examples 1-1 to 1-3 indicates that the combination of the crosslinking agent containing a phenolic hydroxyl group and the base generator improves the film formability, suggesting that the present invention is useful. In Comparative Example 1-9, it is found that the film formability-improving effect by the base generator is not achieved, because the resist underlayer film material contains no phenolic hydroxyl group and requires a thermal acid generator for curing. On the other hand, in Comparative Examples 1-4 to 1-6 containing a phenolic hydroxyl group-containing compound and Comparative Examples 1-7 and 1-8 containing a polymer, a film formation was successful irrespective of the kinds of substrates.

### Example 2 Edge Shrinkage Evaluation (Examples 2-1 to 2-23, Comparative Examples 2-1 to 2-9)

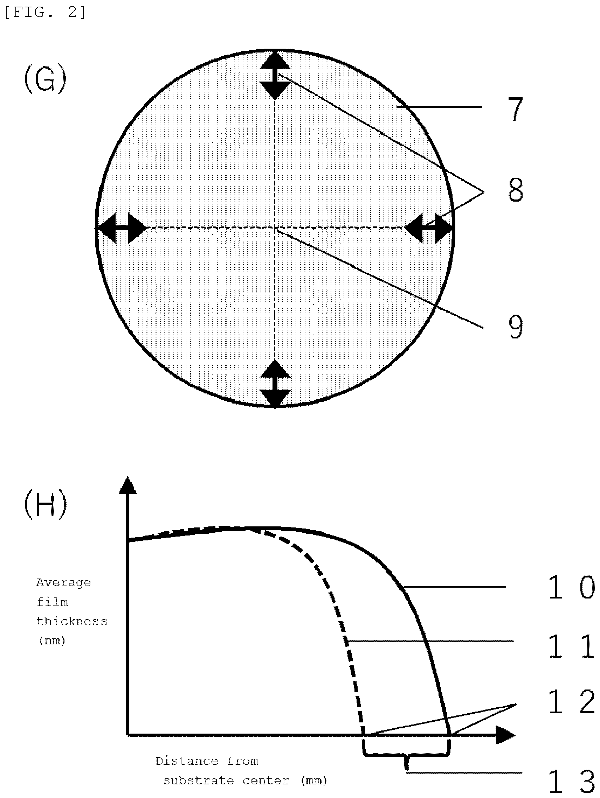

The prepared resist underlayer film materials (UDL-1 to UDL-23, Comparative UDL-1 to UDL-9) were each applied on a 12-inch Bare-Si substrate or HMDS-treated (90°C × 60 seconds) substrate with an edge cut width of 2 mm and baked at 250°C for 60 seconds to form a resist underlayer film with a film thickness of 100 nm (7 in FIG. 2(G)). The formed resist underlayer film was measured in a range from a substrate center 9 to a radius of 145 mm to 149 mm at 0.1 mm intervals at four sections of each substrate, using a film metrology system (Atlas-XP⁺ manufactured by Onto Innovation, Inc.) (8 in FIG. 2(G)). FIG. 2(H) illustrates an average film thickness plot 10 on the Bare-Si substrate and an average film thickness plot 11 on the HMDS substrate. As illustrated in this figure, the point at which the average film thickness was zero was determined as a film edge 12, and the difference in film edge position between the Bare-Si substrate and the HMDS-treated substrate was determined as an edge shrinkage distance 13. The results are listed in Table 8. The smaller the edge shrinkage distance 13, the more excellent the coating property on the HMDS substrate is considered to be.

**[Table 8]**

| | Resist underlayer film material | Distance from substrate center to film edge | | Edge shrinkage distance: a - b (mm) |
|---|---|---|---|---|
| | | Bare-Si substrate: a (mm) | HMDS-treated substrate: b (mm) | |
| Example 2-1 | UDL-1 | 148.1 | 147.9 | 0.2 |
| Example 2-2 | UDL-2 | 148.1 | 148.0 | 0. 1 |
| Example 2-3 | UDL-3 | 148.1 | 148.0 | 0. 1 |
| Example 2-4 | UDL-4 | 147.9 | 147.9 | 0 . 0 |
| Example 2-5 | UDL-3 | 148.0 | 147.8 | 0.2 |
| Example 2-6 | UDL-6 | 148.1 | 148.0 | 0. 1 |
| Example 2-7 | UDL-7 | 147.9 | 147.7 | 0.2 |
| Example 2-8 | UDL-8 | 148.1 | 148.0 | 0. 1 |
| Example 2-9 | UDL-9 | 148.0 | 148.0 | 0 . 0 |
| Example 2-10 | UDL-10 | 148.1 | 148.1 | 0 . 0 |
| Example 2-11 | UDL-11 | 148.1 | 148.0 | 0. 1 |
| Example 2-12 | UDL-12 | 147.9 | 147.8 | 0. 1 |
| Example 2-13 | UDL-13 | 147.9 | 147.9 | 0 . 0 |
| Example 2-14 | UDL-14 | 148.1 | 148.0 | 0. 1 |
| Example 2-15 | UDL-13 | 148.0 | 147.7 | 0.3 |
| Example 2-16 | UDL-16 | 148.0 | 147.8 | 0.2 |
| Example 2-17 | UDL-17 | 148.0 | 147.8 | 0.2 |
| Example 2-18 | UDL-18 | 148.1 | 148.0 | 0. 1 |
| Example 2-19 | UDL-19 | 148.0 | 148.0 | 0 . 0 |
| Example 2-20 | UDL-20 | 148.0 | 147. 9 | 0. 1 |
| Example 2-21 | UDL-21 | 148.0 | 147. 9 | 0. 1 |
| Example 2-22 | UDL-22 | 147.9 | 147.8 | 0. 1 |
| Example 2-23 | UDL-23 | 147.9 | 147.7 | 0.2 |
| Comparative Example 2-1 | Comparative UDL-1 | 148.0 | <145.0 | >3.0 mm |
| Comparative Example 2-2 | Comparative UDL-2 | 148.0 | <145.0 | >3.0 mm |
| Comparative Example 2-3 | Comparative UDL-3 | 148.0 | <145.0 | >3.0 mm |
| Comparative Example 2-4 | Comparative UDL-4 | 148.1 | 148.0 | 0.1 |
| Comparative Example 2-5 | Comparative UDL-3 | 148.0 | 147. 9 | 0.1 |
| Comparative Example 2-6 | Comparative UDL-6 | 148.0 | 147. 9 | 0.1 |
| Comparative Example 2-7 | Comparative UDL-7 | 148.1 | 148.0 | 0.1 |
| Comparative Example 2-8 | Comparative UDL-8 | 148.0 | 148.0 | 0 . 0 |
| Comparative Example 2-9 | Comparative UDL-9 | 148.0 | <145.0 | >3.0 mm |

As listed in Table 8, the resist underlayer film material in the present invention has an edge shrinkage distance of approximately 0.2 mm or less, indicating that the combination of the crosslinking agent containing a phenolic hydroxyl group and the base generator can suppress film edge shrinkage. In Comparative Examples 2-1 to 2-3 and 2-9 which did not contain the combination of the crosslinking agent containing a phenolic hydroxyl group and the base generator, the film edge shrinkage was extremely large on the HMDS-treated substrate and no film edge was found in the measured range. On the other hand, in Comparative Examples 2-4 to 2-6 containing a phenolic hydroxyl group-containing compound and Comparative Examples 2-7 and 2-8 containing a polymer, film edge shrinkage did not occur.

### Example 3 Filling Property Evaluation (Examples 3-1 to 3-23, Comparative Examples 3-1 to 3-9)

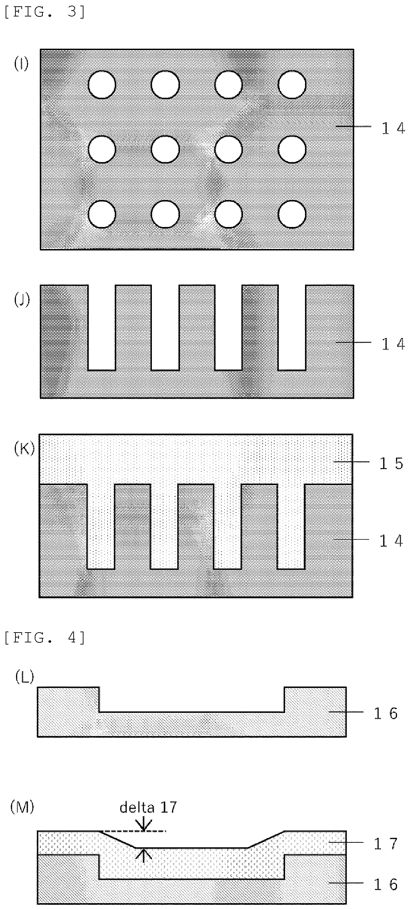

The prepared resist underlayer film materials (UDL-1 to UDL-23, Comparative UDL-1 to UDL-9) were each applied on a SiO₂ wafer substrate having a dense hole pattern (hole diameter 0.16 um, hole depth 0.50 um, the distance between the centers of two holes adjacent to each other 0.32 um) and baked at 250°C for 60 seconds to form a resist underlayer film. The substrate used was a base substrate 14 (SiO₂ wafer substrate) having a dense hole pattern as illustrated in FIG. 3(I) (plane view) and (J) (cross-sectional view). The cross-sectional shape of each obtained wafer substrate was observed using a scanning electron microscope (SEM) to check whether there were no voids inside the holes and the holes were filled with the resist underlayer film 15. The results are listed in Table 9. When a resist underlayer film material inferior in filling property is used, voids are produced inside the holes in the present evaluation. When a resist underlayer film material with good filling property is used, there are no voids inside the holes and the holes are filled with the resist underlayer film, as illustrated in FIG. 3(K), in the present evaluation.

**[Table 9]**

| | Resist underlayer film material | Presence/absence of voids |
|---|---|---|
| Example 3-1 | UDL-1 | None |
| Example 3-2 | UDL-2 | None |
| Example 3-3 | UDL-3 | None |
| Example 3-4 | UDL-4 | None |
| Example 3-5 | UDL-5 | None |
| Example 3-6 | UDL-6 | None |
| Example 3-7 | UDL-7 | None |
| Example 3-8 | UDL-8 | None |
| Example 3-9 | UDL-9 | None |
| Example 3-10 | UDL-10 | None |
| Example 3-11 | UDL-11 | None |
| Example 3-12 | UDL-12 | None |
| Example 3-13 | UDL-13 | None |
| Example 3-14 | UDL-14 | None |
| Example 3-15 | UDL-15 | None |
| Example 3-16 | UDL-16 | None |
| Example 3-17 | UDL-17 | None |
| Example 3-18 | UDL-18 | None |
| Example 3-19 | UDL-19 | None |
| Example 3-20 | UDL-20 | None |
| Example 3-21 | UDL-21 | None |
| Example 3-22 | UDL-22 | None |
| Example 3-23 | UDL-23 | None |
| Comparative Example 3-1 | Comparative UDL-1 | None |
| Comparative Example 3-2 | Comparative UDL-2 | None |
| Comparative Example 3-3 | Comparative UDL-3 | None |
| Comparative Example 3-4 | Comparative UDL-4 | None |
| Comparative Example 3-5 | Comparative UDL-5 | None |
| Comparative Example 3-6 | Comparative UDL-6 | None |
| Comparative Example 3-7 | Comparative UDL-7 | Present |
| Comparative Example 3-8 | Comparative UDL-8 | Present |
| Comparative Example 3-9 | Comparative UDL-9 | None |

As listed in Table 9, all of the resist underlayer film materials in the present invention can fill the hole pattern without voids, indicating that the filling property is excellent. On the other hand, in Comparative Examples 3-7 and 3-8, which contained a polymer with a high molecular weight, filling defects occurred, which were presumably attributable to insufficient thermal flowability.

### Example 4 Planarizing Property Evaluation (Examples 4-1 to 4-23, Comparative Examples 4-1 to 4-9)

The prepared resist underlayer film materials (UDL-1 to UDL-23, Comparative UDL-1 to UDL-9) were each applied on a base substrate 16 (SiO₂ wafer substrate) having a huge isolated trench pattern (FIG. 4(L), trench width 10 µm, trench depth 0.1 µm) and baked at 250°C for 60 seconds. A step (delta 17 in FIG. 4(M)) between a trench portion and a no-trench portion in a resist underlayer film 17 was observed using an NX10 atomic force microscope (AFM) manufactured by Park Systems Corporation. The results are listed in Table 10. In this evaluation, it can be said that the smaller the step, the better the planarizing property. In this evaluation, the trench pattern with a depth of 0.10 um was planarized with a resist underlayer film material with a film thickness of about 0.2 um. This is a strict evaluation condition to evaluate the superiority in planarizing property.

**[Table 10]**

| | Resist underlayer film material | Step (nm) |
|---|---|---|
| Example 4-1 | UDL-1 | 10 |
| Example 4-2 | UDL-2 | 15 |
| Example 4-3 | UDL-3 | 10 |
| Example 4-4 | UDL-4 | 10 |
| Example 4-5 | UDL-5 | 15 |
| Example 4-6 | UDL-6 | 15 |
| Example 4-7 | UDL-7 | 10 |
| Example 4-8 | UDL-8 | 15 |
| Example 4-9 | UDL-9 | 10 |
| Example 4-10 | UDL-10 | 20 |
| Example 4-11 | UDL-11 | 10 |
| Example 4-12 | UDL-12 | 15 |
| Example 4-13 | UDL-13 | 20 |
| Example 4-14 | UDL-14 | 15 |
| Example 4-15 | UDL-15 | 10 |
| Example 4-16 | UDL-16 | 10 |
| Example 4-17 | UDL-17 | 10 |
| Example 4-18 | UDL-18 | 15 |
| Example 4-19 | UDL-19 | 15 |
| Example 4-20 | UDL-20 | 10 |
| Example 4-21 | UDL-21 | 5 |
| Example 4-22 | UDL-22 | 5 |
| Example 4-23 | UDL-23 | 5 |
| Comparative Example 4-1 | Comparative UDL-1 | 10 |
| Comparative Example 4-2 | Comparative UDL-2 | 10 |
| Comparative Example 4-3 | Comparative UDL-3 | 20 |
| Comparative Example 4-4 | Comparative UDL-4 | 35 |
| Comparative Example 4-5 | Comparative UDL-5 | 30 |
| Comparative Example 4-6 | Comparative UDL-6 | 25 |
| Comparative Example 4-7 | Comparative UDL-7 | 80 |
| Comparative Example 4-8 | Comparative UDL-8 | 95 |
| Comparative Example 4-9 | Comparative UDL-9 | 15 |

As listed in Table 10, compared with Comparative Examples 4-7 and 4-8 containing a polymer with a high molecular weight, the resist underlayer film material in the present invention is superior in planarizing property in that the step of the resist underlayer film between a trench portion and a non-trench portion is small. When the residual rates of the phenolic hydroxyl group are compared, Example 4-6 with a residual rate of less than 2% (0%) exhibits excellent planarizing property, compared with Comparative Examples 4-4 to 4-6 with a residual rate of (3.9 to 27.4%). Further, it is found that among Comparative Examples 4-4 to 4-6, the lower the residual rate of the phenolic hydroxyl group, the higher the planarizing performance. Based on this, it was confirmed that the structure containing no phenolic hydroxyl group is highly flowable and has high planarizing property-improving performance.

### Example 5 Pattern Formation Test (Examples 5-1 to 5-23, Comparative Examples 5-1 to 5-9)

The prepared UDL-1 to UDL-23 and Comparative Examples UDL-1 to UDL-9 were each applied on a SiO₂ substrate treated with HMDS having a 200 nm-thick SiO₂ film with a trench pattern (trench width 10 µm, trench depth 0.10 µm) and baked in the air at 250°C for 60 seconds to a film thickness of 200 nm on a Bare Si substrate to form a resist underlayer film. A silicon-containing resist middle layer film material (SOG-1) was applied thereon and baked at 220°C for 60 seconds to form a resist middle layer film with a film thickness of 35 nm. A resist upper layer film material (SL resist for ArF) was applied and baked at 105°C for 60 seconds to form a resist upper layer film with a film thickness of 100 nm. A liquid immersion protective film (TC-1) was applied on the resist upper layer film and baked at 90°C for 60 seconds to form a protective film with a film thickness of 50 nm.

The resist upper layer film material (SL resist for ArF) was prepared by dissolving a polymer (RP1), an acid generator (PAG1), and a basic compound (Amine1) in a solvent containing 0.1% by mass of FC-430 (manufactured by Sumitomo 3M Limited) in the proportions listed in Table 11, and filtering the solution through a 0.1-pm fluorocarbon resin filter.

**[Table 11]**

| | Polymer (parts by mass) | Acid generator (parts by mass) | Basic compound (parts by mass) | Solvent (parts by mass) |
|---|---|---|---|---|
| SL resist for ArF | RP1 (100) | PAG1 (6.6) | Aminel (0.8) | PGMEA (2500) |

The structural formulae of the polymer (RP1), the acid generator (PAG1), and the basic compound (Amine1) that were used are as follows.

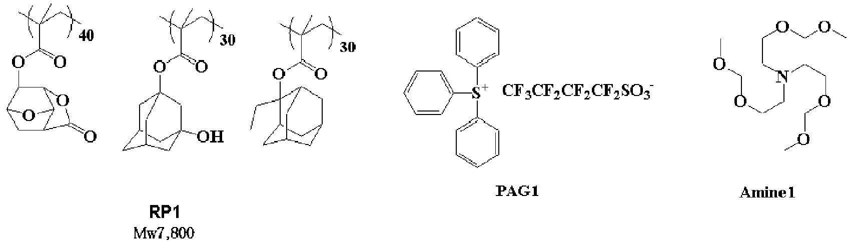

The liquid immersion protective film material (TC-1) was prepared by dissolving a protective film polymer (PP1) in an organic solvent in the proportions listed in Table 12 and filtering the solution through a 0.1-pm fluorocarbon resin filter.

**[Table 12]**

| | Polymer (parts by mass) | Organic solvent (parts by mass) |
|---|---|---|
| TC-1 | PP1 (100) | Diisoamyl ether (2700) |
| | | 2-Methyl-1-butanol (270) |

The structural formula of the polymer (PP1) that was used is as follows.

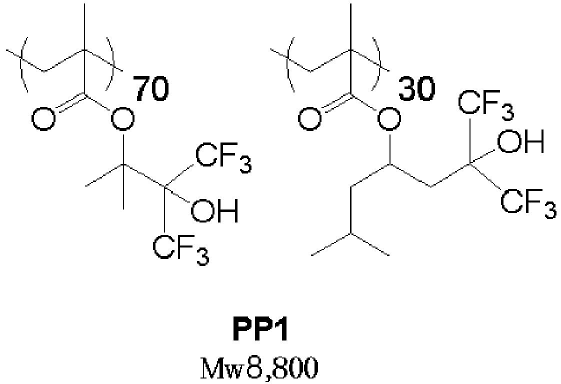

As the silicon-containing resist middle layer film material (SOG-1), a polymer denoted as an ArF silicon-containing middle layer film polymer (SiP1) and a crosslinking catalyst (CAT1) were dissolved in an organic solvent containing 0.1% by mass of FC-4430 (manufactured by Sumitomo 3M Limited) in the proportions listed in Table 13, and the solution was filtered through a fluorocarbon resin filter with a pore diameter of 0.1 µm to prepare a silicon-containing resist middle layer film material (SOG-1).

**[Table 13]**

| | Polymer (parts by mass) | Thermal crosslinking catalyst (parts by mass) | Organic solvent (parts by mass) |
|---|---|---|---|
| SOG-1 | SiP1 (100) | CAT1 (1) | Propylene glycol monoethyl ether (4000) |

The structural formulae of the ArF silicon-containing middle layer film polymer (SiP1) and the crosslinking catalyst (CAT1) that were used are as follows.

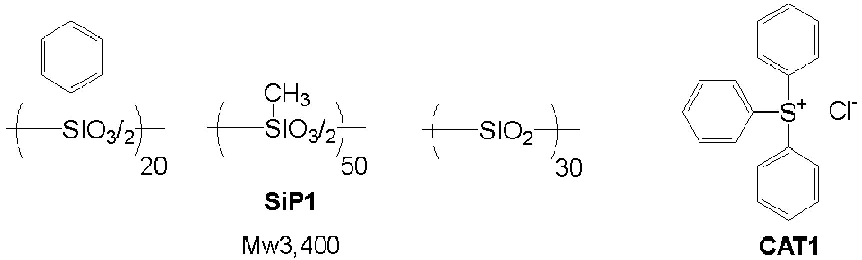

Subsequently, the substrate was exposed using an ArF liquid immersion exposure apparatus (manufactured by Nikon Corporation; NSR-S610C, NA 1.30, σ 0.98/0.65, 35-degree polarized dipole illumination, 6% halftone phase shift mask) while changing the exposure dose, baked at 100°C for 60 seconds (PEB), and developed by 2.38% by mass tetramethylammonium hydroxide (TMAH) aqueous solution for 30 seconds to obtain a 1:1 positive-type line-and-space pattern with a pitch of 100 nm and a resist line width of 50 nm.

Subsequently, using an etching apparatus Telius manufactured by Tokyo Electron Limited, the silicon-containing middle layer film was processed using the resist pattern as a mask by dry-etching, the underlayer film was processed using the silicon-containing middle layer film as a mask, and the SiO₂ film was processed using the underlayer film as a mask.

The etching conditions are as follows.
Conditions for Transferring Resist Pattern to SOG Film
   Chamber pressure: 10.0 Pa
   RF power: 1,500 W
   CF₄ gas flow rate: 15 sccm
   O₂ gas flow rate: 75 sccm
   Time: 15 sec
Conditions for Transferring SOG Film Pattern to Underlayer Film
   Chamber pressure: 2.0 Pa
   RF power: 500 W
   Ar gas flow rate: 75 sccm
   O₂ gas flow rate: 45 sccm
   Time: 120 sec
Conditions for Transferring Underlayer Film Pattern to SiO₂ Film
   Chamber pressure: 2.0 Pa
   RF power: 2,200 W
   C₅F₁₂ gas flow rate: 20 sccm
   C₂F₆ gas flow rate: 10 sccm
   Ar gas flow rate: 300 sccm
   O₂ gas flow rate: 60 sccm
   Time: 90 sec

The pattern cross sections were observed with an electron microscope (S-4700) manufactured by Hitachi, Ltd. The shapes were compared and the results were shown in Table 14.

**[Table 14]**

| | Resist underlayer film material | Pattern shape after transfer and etching of substrate |
|---|---|---|
| Example 5-1 | UDL-1 | Vertical shape |
| Example 5-2 | UDL-2 | Vertical shape |
| Example 5-3 | UDL-3 | Vertical shape |
| Example 5-4 | UDL-4 | Vertical shape |
| Example 5-5 | UDL-5 | Vertical shape |
| Example 5-6 | UDL-6 | Vertical shape |
| Example 5-7 | UDL-7 | Vertical shape |
| Example 5-8 | UDL-8 | Vertical shape |
| Example 5-9 | UDL-9 | Vertical shape |
| Example 5-10 | UDL-10 | Vertical shape |
| Example 5-11 | UDL-11 | Vertical shape |
| Example 5-12 | UDL-12 | Vertical shape |
| Example 5-13 | UDL-13 | Vertical shape |
| Example 5-14 | UDL-14 | Vertical shape |
| Example 5-15 | UDL-15 | Vertical shape |
| Example 5-16 | UDL-16 | Vertical shape |
| Example 5-17 | UDL-17 | Vertical shape |
| Example 5-18 | UDL-18 | Vertical shape |
| Example 5-19 | UDL-19 | Vertical shape |
| Example 5-20 | UDL-20 | Vertical shape |
| Example 5-21 | UDL-21 | Vertical shape |
| Example 5-22 | UDL-22 | Vertical shape |
| Example 5-23 | UDL-23 | Vertical shape |
| Comparative Example 5-1 | Comparative UDL-1 | Pattern shape collapse |
| Comparative Example 5-2 | Comparative UDL-2 | Pattern shape collapse |
| Comparative Example 5-3 | Comparative UDL-3 | Pattern shape collapse |
| Comparative Example 5-4 | Comparative UDL-4 | Vertical shape |
| Comparative Example 5-5 | Comparative UDL-5 | Vertical shape |
| Comparative Example 5-6 | Comparative UDL-6 | Vertical shape |
| Comparative Example 5-7 | Comparative UDL-7 | Pattern shape collapse |
| Comparative Example 5-8 | Comparative UDL-8 | Pattern shape collapse |
| Comparative Example 5-9 | Comparative UDL-9 | Pattern shape collapse |

As listed in Table 14, the results of all of the resist underlayer film materials in the present invention (Examples 5-1 to 5-23) indicated that the resist upper layer film pattern was transferred finally to the substrate in a satisfactory manner, and that the resist underlayer film material in the present invention can be suitably used for microfabrication by a multilayer resist method. On the other hand, in Comparative Examples 5-1, 5-2, 5-3, and 5-9, as indicated by the results of the film formability evaluation in Example 1, pin holes produced during film formation caused pattern collapse during patterning, resulting in a failure in pattern formation. In Comparative Examples 5-7 and 5-8, as indicated by Example 3 and Example 4, poor filling property and planarizing property caused pattern collapse during patterning, resulting in a failure in pattern formation.

Based on the above, it was found that the resist underlayer film material in the present invention is extremely useful as an organic film material for use in a multilayer resist method because of good film formability and excellent filling and planarizing properties. In addition, the pattern forming method in the present invention using this material can form a fine pattern with high accuracy even on a substrate with a body to be processed having a step(s). Further, the resist underlayer film material in the present invention need not contain an acid generator, can avoid problems such as pattern defects caused by a decomposition product of the acid generator, and can maximize the effect of the base generator.

The present description encompasses the following invention.
[1]: A resist underlayer film material comprising: (A) a compound containing no phenolic hydroxyl group, or a compound having a phenolic hydroxyl group modified and in which a residual rate of the phenolic hydroxyl group is less than 2%, wherein the compound has a weight average molecular weight of 2,500 or less in terms of polystyrene by gel permeation chromatography; (B) a crosslinking agent containing a phenolic hydroxyl group represented by the following general formula (1); (C) a base generator; and (D) an organic solvent: 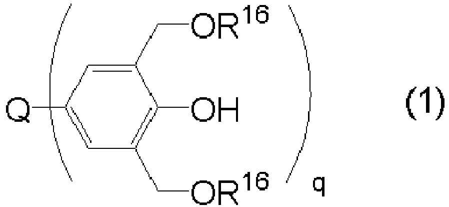 (in the formula, Q is a single bond or a hydrocarbon group with a valency of q having 1 to 20 carbon atoms, R¹⁶ is a hydrogen atom or an alkyl group having 1 to 20 carbon atoms, and q is an integer of 1 to 5) .
[2]: The resist underlayer film material according to [1], wherein the base generator (C) is a compound that expresses basicity by thermal decomposition.
[3]: The resist underlayer film material according to [1] or [2], wherein the base generator (C) is any one represented by the following general formulae (2), (3), and (4) :

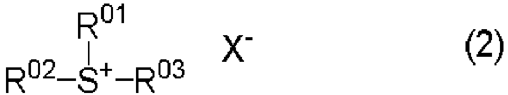

   R⁰⁴-I⁺-R⁰⁵ X⁻ (3)

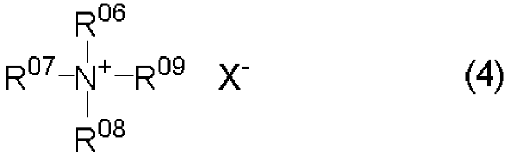

   (in the formulae, R⁰¹ to R⁰³ each independently represent a linear, branched, or cyclic alkyl group or alkenyl group having 1 to 10 carbon atoms, which may be substituted with or separated by a hetero atom, or an aryl group or aralkyl group having 6 to 18 carbon atoms, which may be substituted with or separated by a hetero atom, and any two of R⁰¹, R⁰², and R⁰³ may bond together to form a ring with a sulfur atom in the formula; X-represents an organic or inorganic anion serving as a pairing ion, provided that X⁻ does not include OH⁻; R⁰⁴ and R⁰⁵ are each independently an aryl group having 6 to 20 carbon atoms, which may be substituted with or separated by a hetero atom, in which some or all of hydrogen atoms may be substituted with a linear, branched, or cyclic alkyl group or alkoxy group having 1 to 10 carbon atoms, and R⁰⁴ and R⁰⁵ may bond together to form a ring with an iodine atom in the formula; R⁰⁶, R⁰⁷, R⁰⁸, and R⁰⁹ each independently represent a hydrogen atom, or a linear, branched, or cyclic alkyl group, alkenyl group, or aralkyl group having 1 to 20 carbon atoms, which may be substituted with or separated by a hetero atom, or represent an aryl group or aralkyl group having 6 to 18 carbon atoms, which may be substituted with or separated by a hetero atom, and any two or more of R⁰⁶, R⁰⁷, R⁰⁸, and R⁰⁹ may bond together to form a ring with a nitrogen atom in the formula).
[4]: The resist underlayer film material according to [3], wherein X⁻ in the general formulae (2), (3), and (4) is any one of: a structure represented by any one of the following general formulae (5), (6), and (7); and an anion selected from the group consisting of chloride ion, bromide ion, iodide ion, fluoride ion, cyanide ion, nitrate ion, and nitrite ion:

   R¹⁰-COO⁻ (5)

   R¹¹-SO₃⁻ (6)

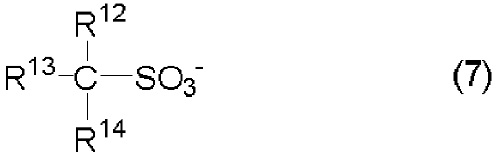

   (in the formulae, R¹⁰ represents a linear, branched, or cyclic alkyl group, alkenyl group, aralkyl group, or aryl group having 1 to 20 carbon atoms, which may contain an ether group, an ester group, or a carbonyl group, and one or more of hydrogen atoms in these groups may be substituted with a halogen atom, a hydroxyl group, a carboxyl group, an amino group, or a cyano group; R¹¹ represents an aryl group having 1 to 20 carbon atoms, and one or more of hydrogen atoms in the aryl group may be substituted with a halogen atom, a hydroxyl group, a carboxyl group, an amino group, or a cyano group; R¹², R¹³, and R¹⁴ each independently represent a hydrogen atom, or a halogen atom except fluorine atom, or a linear, branched, or cyclic alkyl group, alkenyl group, aralkyl group, or aryl group having 1 to 20 carbon atoms, which may contain an ether group, an ester group, or a carbonyl group, one or more of hydrogen atoms in these groups may be substituted with a halogen atom, a hydroxyl group, a carboxyl group, an amino group, or a cyano group, and two or more of R¹², R¹³, and R¹⁴ may bond together to form a ring).
[5]: The resist underlayer film material according to [3] or [4], wherein a conjugate acid X-H of X⁻ in the general formulae (2), (3), and (4) has a boiling point of 200°C or lower.
[6]: The resist underlayer film material according to any one of [1] to [5], wherein the compound (A) is represented by the following general formula (8): 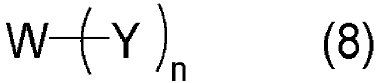 (in the formula, W is an organic group with a valency of n having 2 to 50 carbon atoms, n is an integer of 2 to 10, and Y is independently any one of structures represented by the following general formula (9)) 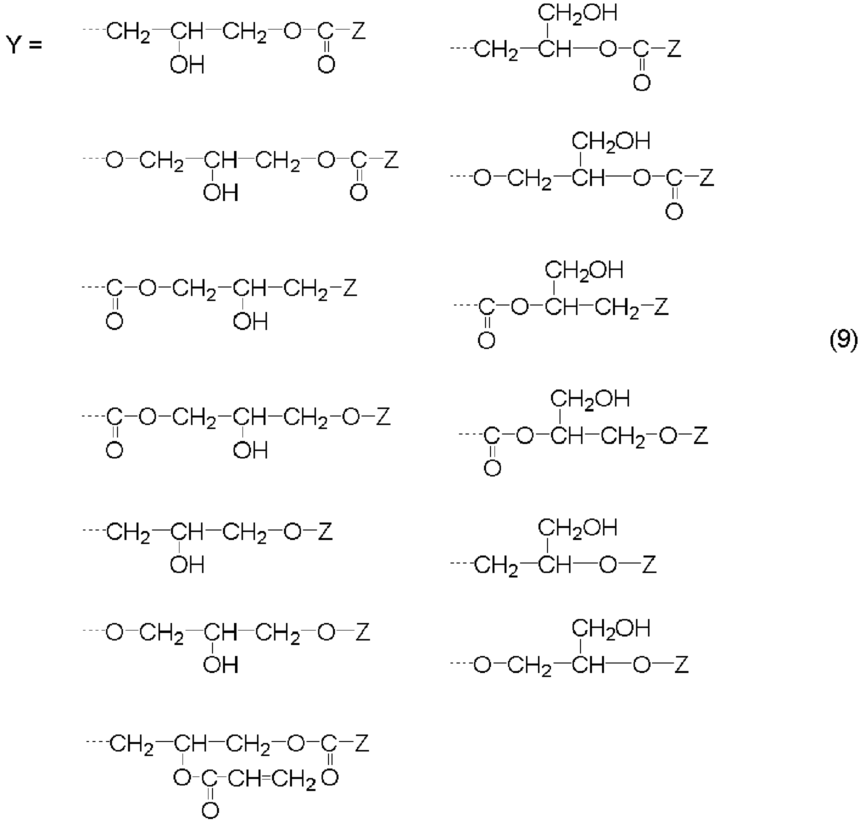 (in the formula, a broken line represents a bonding site with W, Z is one kind or two or more kinds of end groups, and at least one kind of the end groups is any one of groups represented by the following general formula (10)) 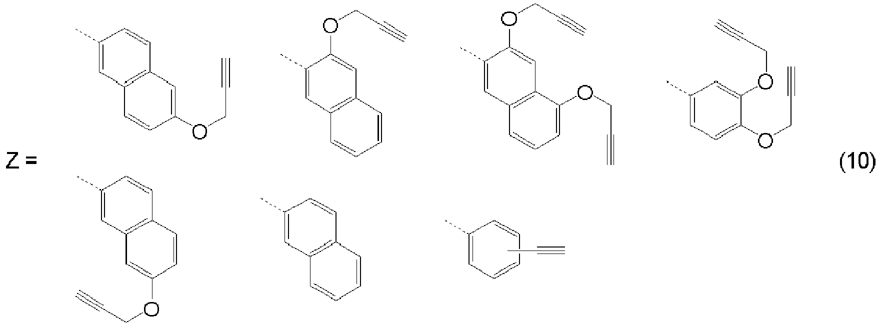 (in the formula, a broken line represents a bonding arm) .
[7]: The resist underlayer film material according to [6], wherein Z in the general formula (9) comprises one or more kinds of groups represented by the general formula (10) and one or more kinds of groups represented by the following general formulae (11) and (12):

   -----Rₚ (11)

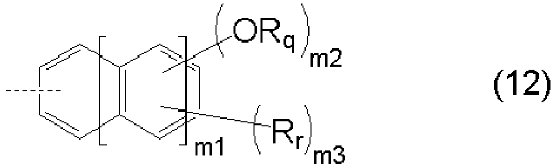

   (in the formula (11), Rₚ represents a linear or branched, saturated or unsaturated hydrocarbon group having 1 to 30 carbon atoms, which may be substituted with or separated by a hetero atom; in the formula (12), R_{q} represents a hydrogen atom, or a linear or branched, saturated or unsaturated hydrocarbon group having 1 to 10 carbon atoms; Rᵣ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; m1 represents 0 to 2, m2 and m3 each represent the number of substituents on an aromatic ring, m2 and m3 each represent an integer of 0 to 7, and m2+m3 satisfies a relation of 0 or more and 7 or less; when a proportion of a structure having the general formula (10) that constitutes Z is denoted as "a", and a proportion of a total of structures having the general formulae (11) and (12) is denoted as "b", the following relation is satisfied: a + b = 1.0, 0.50 ≤ a ≤ 0.99, 0.01 ≤ b ≤ 0.50).
[8]: The resist underlayer film material according to [6] or [7], wherein W in the general formula (8) is a structure represented by any one of the following formulae: 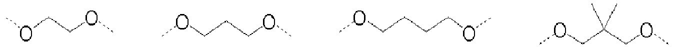 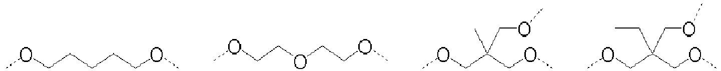 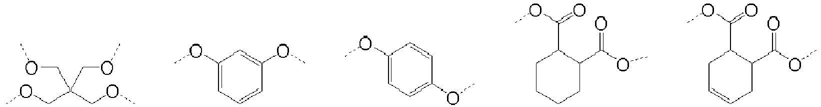 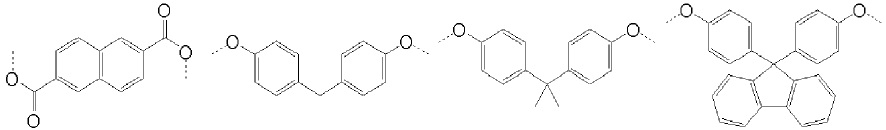 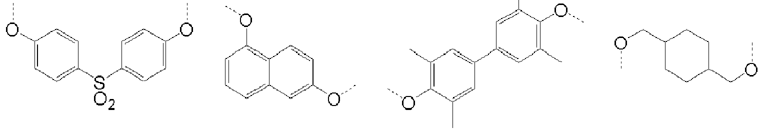 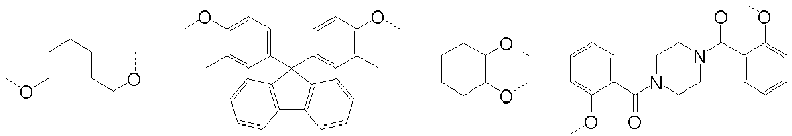 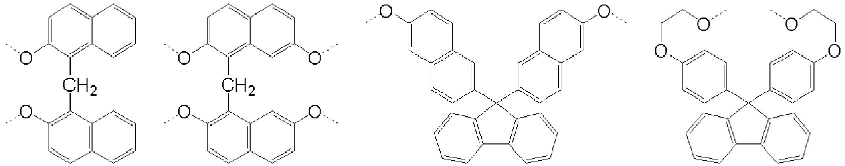 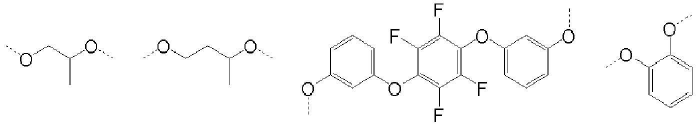 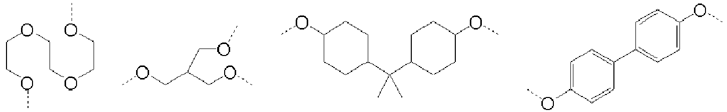 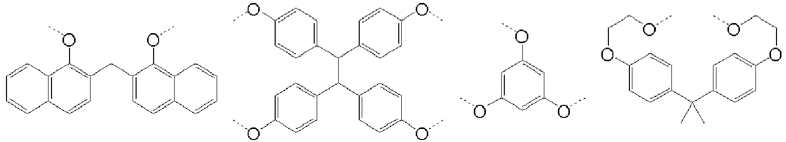 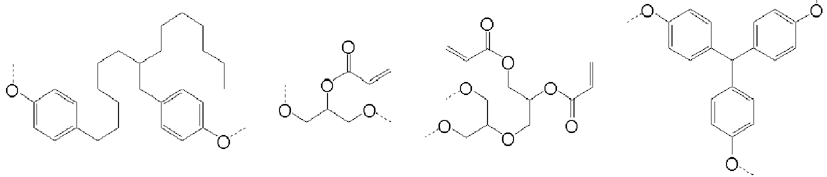 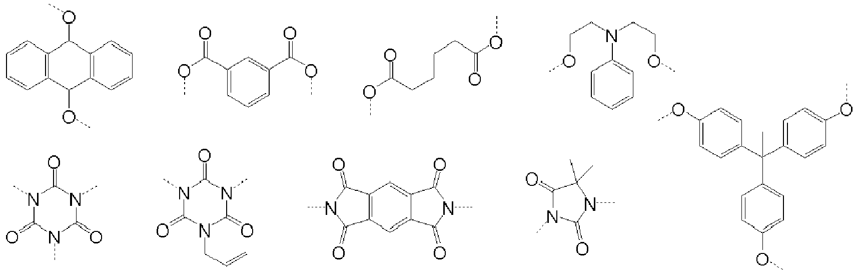 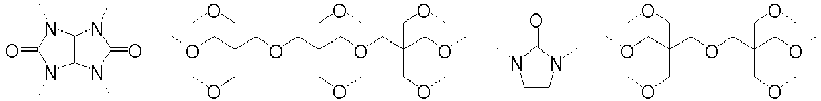 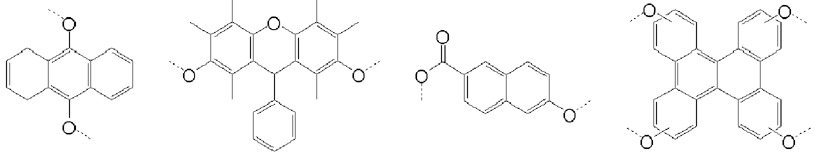 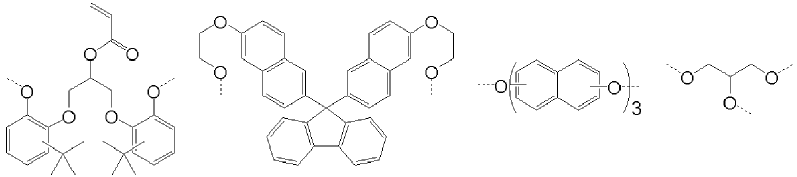 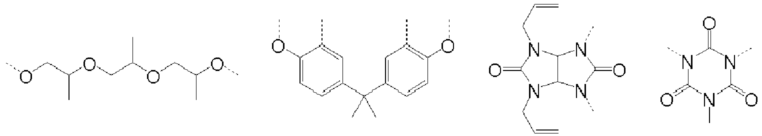 (in the formulae, a broken line represents a bonding arm).
[9]: The resist underlayer film material according to any one of [1] to [8], wherein the organic solvent (D) is a mixture of one or more kinds of organic solvent having a boiling point of lower than 180°C and one or more kinds of organic solvent having a boiling point of 180°C or higher.
[10]: The resist underlayer film material according to any one of [1] to [9], further comprising one or more of (E) a surfactant, (F) a plasticizer, and (G) a pigment.
[11]: A method of forming a pattern in a substrate to be processed, the method comprising steps of:
   (I-1) applying the resist underlayer film material according to any one of [1] to [10] on a substrate to be processed and thereafter performing heat treatment to form a resist underlayer film;
   (I-2) forming a resist upper layer film using a photoresist material on the resist underlayer film;
   (I-3) performing pattern exposure and subsequent development with a developer in the resist upper layer film to form a pattern in the resist upper layer film;
   (I-4) transferring a pattern to the resist underlayer film by dry-etching while using the resist upper layer film having the pattern as a mask; and
   (I-5) processing the substrate to be processed while using the resist underlayer film having the pattern as a mask to form a pattern in the substrate to be processed.
[12]: A method of forming a pattern in a substrate to be processed, the method comprising steps of:
   (II-1) applying the resist underlayer film material according to any one of [1] to [10] on a substrate to be processed and thereafter performing heat treatment to form a resist underlayer film;
   (II-2) forming a resist middle layer film on the resist underlayer film;
   (II-3) forming a resist upper layer film using a photoresist material on the resist middle layer film;
   (II-4) performing pattern exposure and subsequent development with a developer in the resist upper layer film to form a pattern in the resist upper layer film;
   (II-5) transferring a pattern to the resist middle layer film by dry-etching while using the resist upper layer film having the pattern as a mask;
   (II-6) transferring a pattern to the resist underlayer film by dry-etching while using the resist middle layer film having the transferred pattern as a mask; and
   (II-7) processing the substrate to be processed while using the resist underlayer film having the pattern as a mask to form a pattern in the substrate to be processed.
[13]: A method of forming a pattern in a substrate to be processed, the method comprising steps of:
   (III-1) applying the resist underlayer film material according to any one of [1] to [10] on a substrate to be processed and thereafter performing heat treatment to form a resist underlayer film;
   (III-2) forming an inorganic hard mask middle layer film selected from the group consisting of a silicon oxide film, a silicon nitride film, and a silicon oxynitride film on the resist underlayer film;
   (III-3) forming an organic thin film on the inorganic hard mask middle layer film;
   (III-4) forming a resist upper layer film using a photoresist material on the organic thin film;
   (III-5) performing pattern exposure and subsequent development with a developer in the resist upper layer film to form a pattern in the resist upper layer film;
   (III-6) transferring a pattern to the organic thin film and the inorganic hard mask middle layer film by dry-etching while using the resist upper layer film having the pattern as a mask;
   (III-7) transferring a pattern to the resist underlayer film by dry-etching while using the inorganic hard mask middle layer film having the transferred pattern as a mask; and
   (III-8) processing the substrate to be processed while using the resist underlayer film having the pattern as a mask to form a pattern in the substrate to be processed.
[14]: The pattern forming method according to [13], wherein the inorganic hard mask middle layer film is formed by a CVD method or an ALD method.
[15]: The pattern forming method according to any one of [11] to [14], wherein a substrate having a structure or a step with a height of 30 nm or more is used as the substrate to be processed.
[16]: The pattern forming method according to any one of [11] to [15], wherein a substrate having a static contact angle with water of 50° or more is used as the substrate to be processed.
[17]: A method of forming a resist underlayer film that functions as an organic planarizing film employed in a semiconductor device manufacturing process, wherein the resist underlayer film material according to any one of [1] to [10] is spin-coated on a substrate to be processed, and the substrate coated with the resist underlayer film material is hardened by heat treatment in a range of temperature of 100°C or higher and 600°C or lower for 10 to 600 seconds to form a resist underlayer film.
[18]: A method of forming a resist underlayer film that functions as an organic planarizing film employed in a semiconductor device manufacturing process, wherein the resist underlayer film material according to any one of [1] to [10] is spin-coated on a substrate to be processed, and the substrate coated with the resist underlayer film material is hardened by heat treatment in an atmosphere with an oxygen concentration of 1% by volume or more and 21% by volume or less to form a resist underlayer film.
[19]: A method of forming a resist underlayer film that functions as an organic planarizing film employed in a semiconductor device manufacturing process, wherein the resist underlayer film material according to any one of [1] to [10] is spin-coated on a substrate to be processed, and the substrate coated with the resist underlayer film material is hardened by heat treatment in an atmosphere with an oxygen concentration of less than 1% by volume to form a resist underlayer film.
[20]: The method of forming a resist underlayer film according to any one of [17] to [19], wherein a substrate having a structure or a step with a height of 30 nm or more is used as the substrate to be processed.
[21]: The method of forming a resist underlayer film according to any one of [17] to [20], wherein a substrate having a static contact angle with water of 50° or more is used as the substrate to be processed.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A resist underlayer film material comprising:
(A) a compound containing no phenolic hydroxyl group, or a compound having a phenolic hydroxyl group modified and in which a residual rate of the phenolic hydroxyl group is less than 2%, wherein the compound has a weight average molecular weight of 2,500 or less in terms of polystyrene by gel permeation chromatography;
(B) a crosslinking agent containing a phenolic hydroxyl group represented by the following general formula (1);
(C) a base generator; and
(D) an organic solvent: 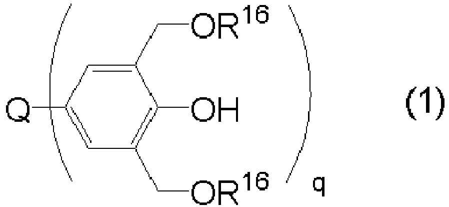 (in the formula, Q is a single bond or a hydrocarbon group with a valency of q having 1 to 20 carbon atoms, R¹⁶ is a hydrogen atom or an alkyl group having 1 to 20 carbon atoms, and q is an integer of 1 to 5) .

2. The resist underlayer film material according to claim 1, wherein the base generator (C) is a compound that expresses basicity by thermal decomposition.

3. The resist underlayer film material according to claim 2, wherein the base generator (C) is any one represented by the following general formulae (2), (3), and (4) : 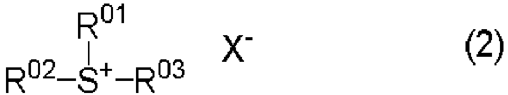
R⁰⁴-I⁺-R⁰⁵ X⁻ (3) 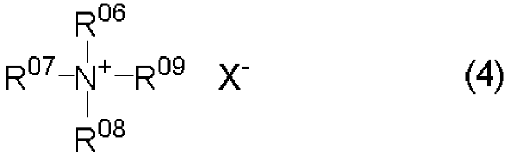
(in the formulae, R⁰¹ to R⁰³ each independently represent a linear, branched, or cyclic alkyl group or alkenyl group having 1 to 10 carbon atoms, which may be substituted with or separated by a hetero atom, or an aryl group or aralkyl group having 6 to 18 carbon atoms, which may be substituted with or separated by a hetero atom, and any two of R⁰¹, R⁰², and R⁰³ may bond together to form a ring with a sulfur atom in the formula; X-represents an organic or inorganic anion serving as a pairing ion, provided that X⁻ does not include OH⁻; R⁰⁴ and R⁰⁵ are each independently an aryl group having 6 to 20 carbon atoms, which may be substituted with or separated by a hetero atom, in which some or all of hydrogen atoms may be substituted with a linear, branched, or cyclic alkyl group or alkoxy group having 1 to 10 carbon atoms, and R⁰⁴ and R⁰⁵ may bond together to form a ring with an iodine atom in the formula; R⁰⁶, R⁰⁷, R⁰⁸, and R⁰⁹ each independently represent a hydrogen atom, or a linear, branched, or cyclic alkyl group, alkenyl group, or aralkyl group having 1 to 20 carbon atoms, which may be substituted with or separated by a hetero atom, or represent an aryl group or aralkyl group having 6 to 18 carbon atoms, which may be substituted with or separated by a hetero atom, and any two or more of R⁰⁶, R⁰⁷, R⁰⁸, and R⁰⁹ may bond together to form a ring with a nitrogen atom in the formula), preferably wherein
X⁻ in the general formulae (2), (3), and (4) is any one of: a structure represented by any one of the following general formulae (5), (6), and (7); and an anion selected from the group consisting of chloride ion, bromide ion, iodide ion, fluoride ion, cyanide ion, nitrate ion, and nitrite ion:
R¹⁰-COO⁻ (5)
R¹¹-SO₃⁻ (6) 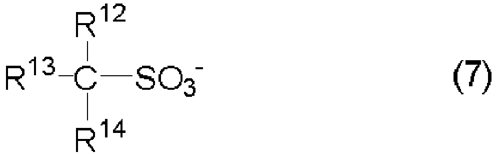
(in the formulae, R¹⁰ represents a linear, branched, or cyclic alkyl group, alkenyl group, aralkyl group, or aryl group having 1 to 20 carbon atoms, which may contain an ether group, an ester group, or a carbonyl group, and one or more of hydrogen atoms in these groups may be substituted with a halogen atom, a hydroxyl group, a carboxyl group, an amino group, or a cyano group; R¹¹ represents an aryl group having 1 to 20 carbon atoms, and one or more of hydrogen atoms in the aryl group may be substituted with a halogen atom, a hydroxyl group, a carboxyl group, an amino group, or a cyano group; R¹², R¹³, and R¹⁴ each independently represent a hydrogen atom, or a halogen atom except fluorine atom, or a linear, branched, or cyclic alkyl group, alkenyl group, aralkyl group, or aryl group having 1 to 20 carbon atoms, which may contain an ether group, an ester group, or a carbonyl group, one or more of hydrogen atoms in these groups may be substituted with a halogen atom, a hydroxyl group, a carboxyl group, an amino group, or a cyano group, and two or more of R¹², R¹³, and R¹⁴ may bond together to form a ring), preferably wherein
a conjugate acid X-H of X- in the general formulae (2), (3), and (4) has a boiling point of 200°C or lower.

4. The resist underlayer film material according to claim 1, wherein the compound (A) is represented by the following general formula (8): 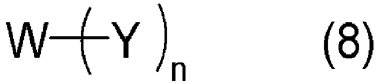 (in the formula, W is an organic group with a valency of n having 2 to 50 carbon atoms, n is an integer of 2 to 10, and Y is independently any one of structures represented by the following general formula (9)) 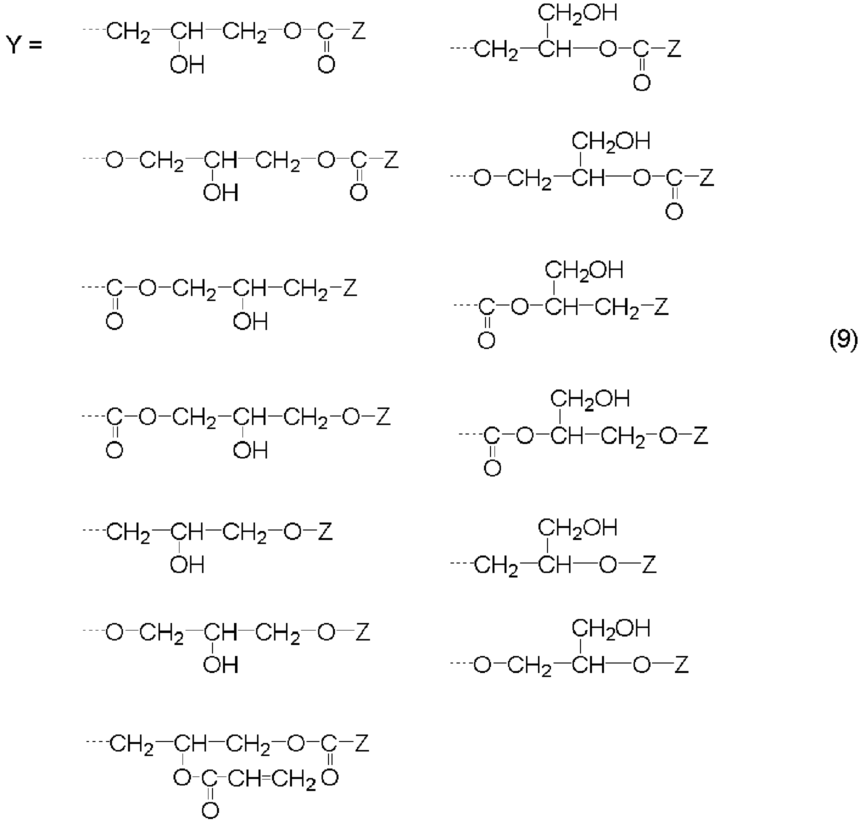 (in the formula, a broken line represents a bonding site with W, Z is one kind or two or more kinds of end groups, and at least one kind of the end groups is any one of groups represented by the following general formula (10)) 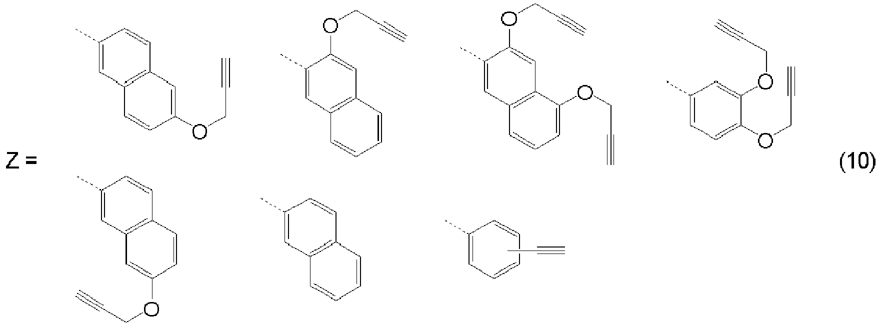 (in the formula, a broken line represents a bonding arm) .

5. The resist underlayer film material according to claim 4, wherein Z in the general formula (9) comprises one or more kinds of groups represented by the general formula (10) and one or more kinds of groups represented by the following general formulae (11) and (12):
----- Rₚ (11) 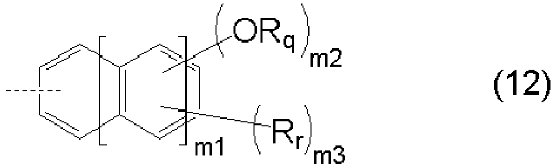
(in the formula (11), Rₚ represents a linear or branched, saturated or unsaturated hydrocarbon group having 1 to 30 carbon atoms, which may be substituted with or separated by a hetero atom; in the formula (12), R_{q} represents a hydrogen atom, or a linear or branched, saturated or unsaturated hydrocarbon group having 1 to 10 carbon atoms; Rᵣ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; m1 represents 0 to 2, m2 and m3 each represent the number of substituents on an aromatic ring, m2 and m3 each represent an integer of 0 to 7, and m2+m3 satisfies a relation of 0 or more and 7 or less; when a proportion of a structure having the general formula (10) that constitutes Z is denoted as "a", and a proportion of a total of structures having the general formulae (11) and (12) is denoted as "b", the following relation is satisfied: a + b = 1.0, 0.50 ≤ a ≤ 0.99, 0.01 ≤ b ≤ 0.50).

6. The resist underlayer film material according to claim 4, wherein W in the general formula (8) is a structure represented by any one of the following formulae: 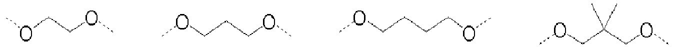 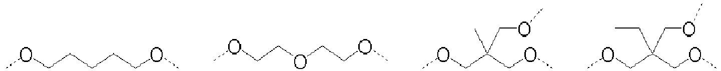 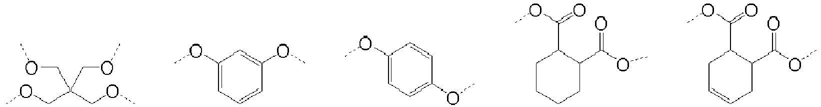 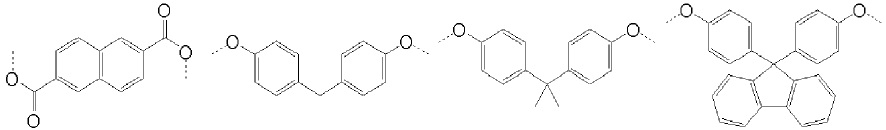 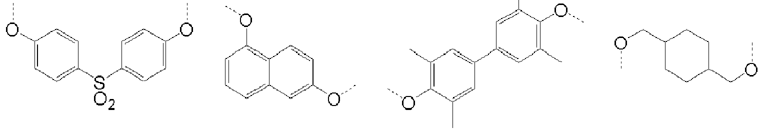 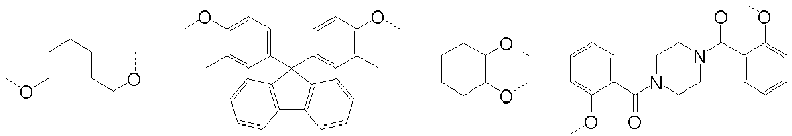 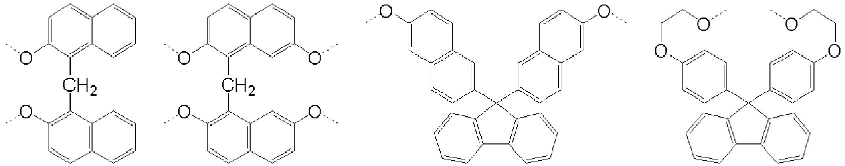 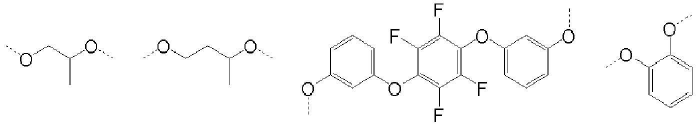 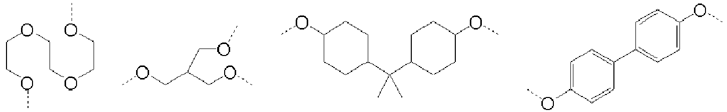 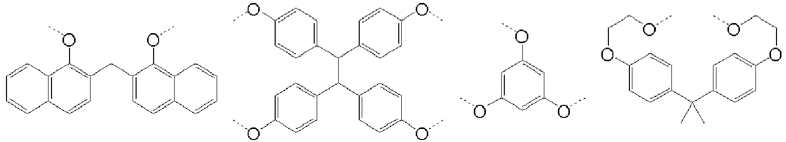 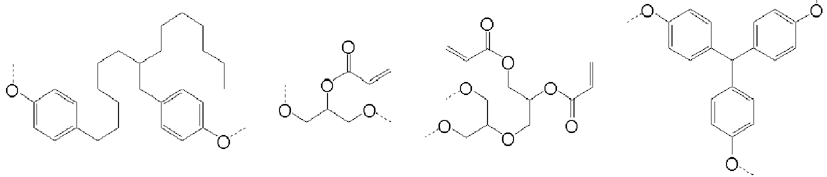 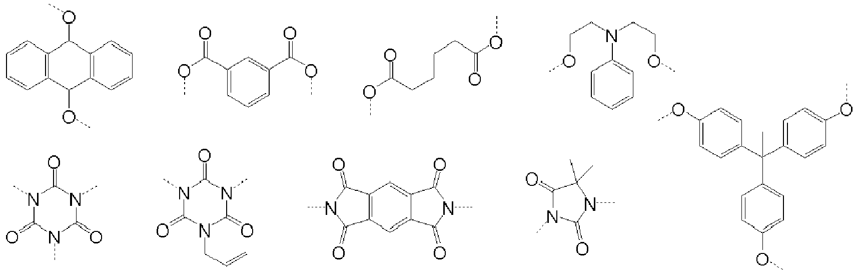 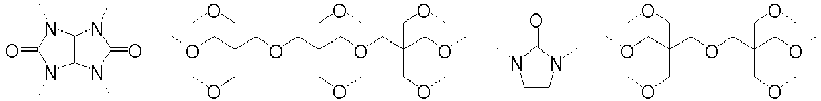 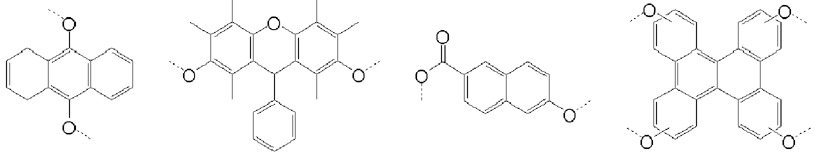 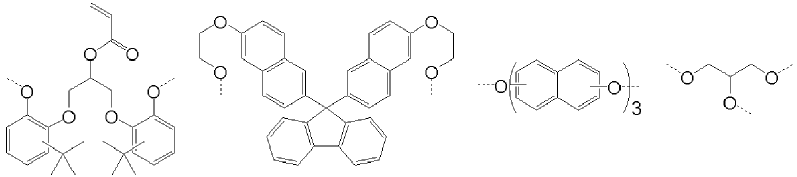 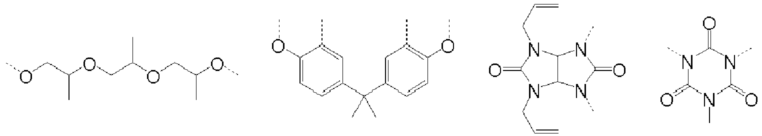 (in the formulae, a broken line represents a bonding arm).

7. The resist underlayer film material according to claim 1, wherein the organic solvent (D) is a mixture of one or more kinds of organic solvent having a boiling point of lower than 180°C and one or more kinds of organic solvent having a boiling point of 180°C or higher.

8. The resist underlayer film material according to claim 1, further comprising one or more of (E) a surfactant, (F) a plasticizer, and (G) a pigment.

9. A method of forming a pattern in a substrate to be processed, the method comprising steps of:
(I-1) applying the resist underlayer film material according to any one of claims 1 to 8 on a substrate to be processed and thereafter performing heat treatment to form a resist underlayer film;
(I-2) forming a resist upper layer film using a photoresist material on the resist underlayer film;
(I-3) performing pattern exposure and subsequent development with a developer in the resist upper layer film to form a pattern in the resist upper layer film;
(I-4) transferring a pattern to the resist underlayer film by dry-etching while using the resist upper layer film having the pattern as a mask; and
(I-5) processing the substrate to be processed while using the resist underlayer film having the pattern as a mask to form a pattern in the substrate to be processed, or
a method of forming a pattern in a substrate to be processed, the method comprising steps of:
(II-1) applying the resist underlayer film material according to any one of claims 1 to 8 on a substrate to be processed and thereafter performing heat treatment to form a resist underlayer film;
(II-2) forming a resist middle layer film on the resist underlayer film;
(II-3) forming a resist upper layer film using a photoresist material on the resist middle layer film;
(II-4) performing pattern exposure and subsequent development with a developer in the resist upper layer film to form a pattern in the resist upper layer film;
(II-5) transferring a pattern to the resist middle layer film by dry-etching while using the resist upper layer film having the pattern as a mask;
(II-6) transferring a pattern to the resist underlayer film by dry-etching while using the resist middle layer film having the transferred pattern as a mask; and
(II-7) processing the substrate to be processed while using the resist underlayer film having the pattern as a mask to form a pattern in the substrate to be processed, or
a method of forming a pattern in a substrate to be processed, the method comprising steps of:
(III-1) applying the resist underlayer film material according to any one of claims 1 to 8 on a substrate to be processed and thereafter performing heat treatment to form a resist underlayer film;
(III-2) forming an inorganic hard mask middle layer film selected from the group consisting of a silicon oxide film, a silicon nitride film, and a silicon oxynitride film on the resist underlayer film;
(III-3) forming an organic thin film on the inorganic hard mask middle layer film;
(III-4) forming a resist upper layer film using a photoresist material on the organic thin film;
(III-5) performing pattern exposure and subsequent development with a developer in the resist upper layer film to form a pattern in the resist upper layer film;
(III-6) transferring a pattern to the organic thin film and the inorganic hard mask middle layer film by dry-etching while using the resist upper layer film having the pattern as a mask;
(III-7) transferring a pattern to the resist underlayer film by dry-etching while using the inorganic hard mask middle layer film having the transferred pattern as a mask; and
(III-8) processing the substrate to be processed while using the resist underlayer film having the pattern as a mask to form a pattern in the substrate to be processed, preferably, wherein
the inorganic hard mask middle layer film is formed by a CVD method or an ALD method.

10. The pattern forming method according to claim 9, wherein a substrate having a structure or a step with a height of 30 nm or more is used as the substrate to be processed.

11. The pattern forming method according to claim 9, wherein a substrate having a static contact angle with water of 50° or more is used as the substrate to be processed.

12. A method of forming a resist underlayer film that functions as an organic planarizing film employed in a semiconductor device manufacturing process, wherein the resist underlayer film material according to any one of claims 1 to 8 is spin-coated on a substrate to be processed, and the substrate coated with the resist underlayer film material is hardened by heat treatment in a range of temperature of 100°C or higher and 600°C or lower for 10 to 600 seconds to form a resist underlayer film, or
a method of forming a resist underlayer film that functions as an organic planarizing film employed in a semiconductor device manufacturing process, wherein the resist underlayer film material according to any one of claims 1 to 8 is spin-coated on a substrate to be processed, and the substrate coated with the resist underlayer film material is hardened by heat treatment in an atmosphere with an oxygen concentration of 1% by volume or more and 21% by volume or less to form a resist underlayer film, or
a method of forming a resist underlayer film that functions as an organic planarizing film employed in a semiconductor device manufacturing process, wherein the resist underlayer film material according to any one of claims 1 to 8 is spin-coated on a substrate to be processed, and the substrate coated with the resist underlayer film material is hardened by heat treatment in an atmosphere with an oxygen concentration of less than 1% by volume to form a resist underlayer film.

13. The method of forming a resist underlayer film according to claim 12, wherein a substrate having a structure or a step with a height of 30 nm or more is used as the substrate to be processed.

14. The method of forming a resist underlayer film according to claim 12, wherein a substrate having a static contact angle with water of 50° or more is used as the substrate to be processed.
